# EUROPEAN PATENT APPLICATION

(11) **EP 4 606 808 A1**
(43) Date of publication of application: **27.08.2025**
(21) Application number: 25159604.5
(22) Date of filing: 24.02.2025
(51) Int. Cl.: C07F 15/00, C09K 11/06, C07B 59/00

(54) **ORGANOMETALLIC COMPOUND, ORGANIC LIGHT-EMITTING DEVICE INCLUDING THE SAME, AND ELECTRONIC APPARATUS INCLUDING THE ORGANIC LIGHT-EMITTING DEVICE**

(30) Priority: 26.02.2024 KR 20240027500
(71) Applicant: Samsung Electronics Co., Ltd., Suwon-si, Gyeonggi-do 16677 (KR)
(72) Inventor: LEE, Minhan, 16678 Suwon-si (KR); KWON, Ohyun, 16678 Suwon-si (KR); RAI, Virendra Kumar, 16678 Suwon-si (KR); MOON, Juhee, 16678 Suwon-si (KR); SIM, Myungsun, 16678 Suwon-si (KR); ISHIHARA, Shingo, 16678 Suwon-si (KR); CHO, Oul, 16678 Suwon-si (KR); CHOI, Byoungki, 16678 Suwon-si (KR); HONG, Youngki, 16678 Suwon-si (KR)
(74) Representative: Elkington and Fife LLP

(57) **Abstract**

An organometallic compound represented by Formula 1:

Formula 1 M₁(Ln₁)ₙ₁(Ln₂)ₙ₂

wherein M₁ is a transition metal, Ln₁ is a ligand represented by Formula 1A, Ln₂ is a ligand represented by Formula 1B, n1 is 1 or 2, and n2 is 1 or 2: 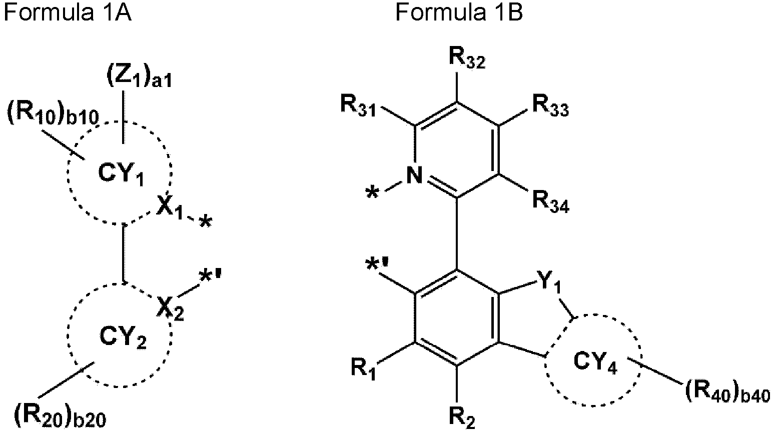 wherein ring CY₄ is a polycyclic C₅-C₃₀ carbocyclic group or a polycyclic C₁-C₃₀ heterocyclic group; Y₁ is O, S, or Se; Z₁ is -Si(Q₁)(Q₂)(Q₃) or -Ge(Q₁)(Q₂)(Q₃); a1 is 1, 2, 3, or 4; at least one of R₁ and R₂ is a substituted or unsubstituted C₁-C₆₀ alkyl group, a substituted or unsubstituted C₃-C₁₀ cycloalkyl group, or a substituted or unsubstituted C₆-C₆₀ aryl group; and the remaining substituent groups are as defined herein.

## Description

### FIELD OF THE INVENTION

The disclosure relates to an organometallic compound, an organic light-emitting device including the same, and an electronic apparatus including the organic light-emitting device.

### BACKGROUND OF THE INVENTION

Organic light-emitting devices (OLEDs) are self-emissive devices, which have improved characteristics in terms of viewing angles, response time, brightness, driving voltage, and response speed. In addition, OLEDs can produce full-color images.

In an example, an organic light-emitting device includes an anode, a cathode, and an organic layer that is arranged between the anode and the cathode and includes an emission layer. A hole transport region may be arranged between the anode and the emission layer, and an electron transport region may be arranged between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. The excitons may transition from an excited state to a ground state, thus generating light.

### SUMMARY OF THE INVENTION

Provided are an organometallic compound, an organic light-emitting device including the same, and an electronic apparatus including the organic light-emitting device.

Additional aspects will be set forth in part in the detailed description that follows and, in part, will be apparent from the detailed description, or may be learned by practice of the presented exemplary embodiments herein.

According to an aspect, provided is an organometallic compound represented by Formula 1:

Formula 1 M₁(Ln₁)ₙ₁(Ln₂)ₙ₂

wherein, in Formula 1,
M₁ is a transition metal,
Ln₁ is a ligand represented by Formula 1A,
Ln₂ is a ligand represented by Formula 1B,
n1 is 1 or 2, and
n2 is 1 or 2, 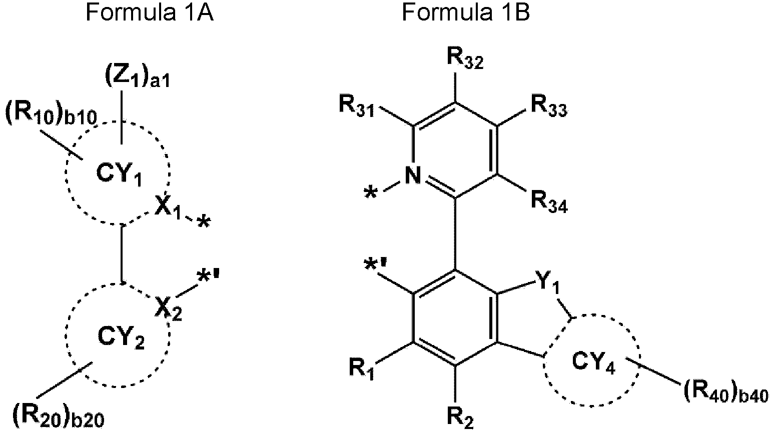 wherein, in Formulae 1A and 1B,
   ring CY₁ and ring CY₂ are each independently a C₅-C₃₀ carbocyclic group or a C₁-C₃₀ heterocyclic group,
   ring CY₄ is a polycyclic C₅-C₃₀ carbocyclic group or a polycyclic C₁-C₃₀ heterocyclic group,
   X₁ is C or N, and X₂ is C or N,
   Y₁ is O, S, or Se,
   Z₁ is -Si(Q₁)(Q₂)(Q₃) or -Ge(Q₁)(Q₂)(Q₃),
   a1 is 1, 2, 3, or 4,
   R₁, R₂, R₁₀, R₂₀, R₃₁ to R₃₄, and R₄₀ are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -Si(Q₁)(Q₂)(Q₃), -Ge(Q₁)(Q₂)(Q₃), -N(Q₄)(Q₅), -B(Q₆)(Q₇), -P(Q₈)(Q₉), or -P(=O)(Q₈)(Q₉),
   at least one of R₁ and R₂ is a substituted or unsubstituted C₁-C₆₀ alkyl group, a substituted or unsubstituted C₃-C₁₀ cycloalkyl group, or a substituted or unsubstituted C₆-C₆₀ aryl group,
   two or more of a plurality of R₁₀ are optionally bonded to each other to form a substituted or unsubstituted C₅-C₃₀ carbocyclic group or a substituted or unsubstituted C₁-C₃₀ heterocyclic group,
   two or more of a plurality of R₂₀ are optionally bonded to each other to form a substituted or unsubstituted C₅-C₃₀ carbocyclic group or a substituted or unsubstituted C₁-C₃₀ heterocyclic group,
   neighboring two or more of R₁, R₂, R₁₀, R₂₀, R₃₁ to R₃₄, or R₄₀ are optionally bonded to each other to form a substituted or unsubstituted C₅-C₃₀ carbocyclic group or a substituted or unsubstituted C₁-C₃₀ heterocyclic group,
   b10, b20, and b40 are each independently 1, 2, 3, 4, 5, 6, 7, 8, 9, or 10,
      * and *" each indicates a binding site to M₁,
      at least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group is:
         deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group,
         a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₁₁)(Q₁₂)(Q₁₃), - Ge(Q₁₁)(Q₁₂)(Q₁₃), -N(Q₁₄)(Q₁₅), -B(Q₁₆)(Q₁₇), -P(Q₁₈)(Q₁₉), -P(=O)(Q₁₈)(Q₁₉), or a combination thereof,
         a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group,
         a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each substituted with at least one of deuterium, -F, -Cl, -Br, -I, -SF₅, -CD₃, -CD₂H, - CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₂₁)(Q₂₂)(Q₂₃), - Ge(Q₂₁)(Q₂₂)(Q₂₃), -N(Q₂₄)(Q₂₅), -B(Q₂₆)(Q₂₇), -P(Q₂₈)(Q₂₉), -P(=O)(Q₂₈)(Q₂₉), or a combination thereof, or
         -Si(Q₃₁)(Q₃₂)(Q₃₃), -Ge(Q₃₁)(Q₃₂)(Q₃₃), -N(Q₃₄)(Q₃₅), -B(Q₃₆)(Q₃₇), - P(Q₃₈)(Q₃₉), or -P(=O)(Q₃₈)(Q₃₉), and
         Q₁ to Q₉, Q₁₁ to Q₁₉, Q₂₁ to Q₂₉, and Q₃₁ to Q₃₉ are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group.

According to another aspect, an organic light-emitting device includes a first electrode, a second electrode, and an organic layer arranged between the first electrode and the second electrode, wherein the organic layer includes an emission layer, and wherein the organic layer further includes at least one of the organometallic compounds represented by Formula 1.

At least one of the organometallic compounds represented by Formula 1 may be included in the emission layer of the organic layer, and the at least one organometallic compound represented by Formula 1 included in the emission layer may act as a dopant.

According to another aspect, an electronic apparatus includes the organic light-emitting device.

### BRIEF DESCRIPTION OF THE DRAWINGS

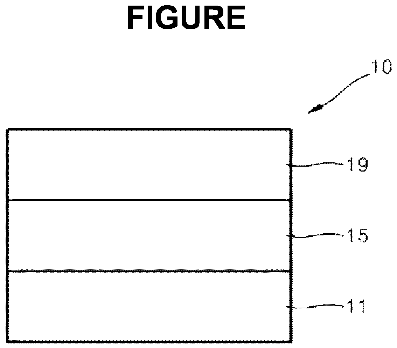

The above and other aspects, features, and advantages of certain exemplary embodiments will be more apparent from the following detailed description taken in conjunction with the accompanying drawing, in which:
The FIGURE is a schematic cross-sectional view of an organic light-emitting device according to one or more embodiments.

### DETAILED DESCRIPTION OF THE EMBODIMENTS

Reference will now be made in further detail to exemplary embodiments, examples of which are illustrated in the accompanying drawing, wherein like reference numerals refer to like elements throughout. In this regard, the present exemplary embodiments may have different forms and should not be construed as being limited to the detailed descriptions set forth herein. Accordingly, the exemplary embodiments are merely described in further detail below, and by referring to the figure, to explain certain aspects and features. As used herein, the term "and/or" includes any and all combinations of one or more of the associated listed items. Expressions such as "at least one of," when preceding a list of elements, modify the entire list of elements and do not modify the individual elements of the list.

The terminology used herein is for the purpose of describing one or more exemplary embodiments only and is not intended to be limiting. As used herein, the singular forms "a," "an," and "the" are intended to include the plural forms as well, unless the context clearly indicates otherwise. The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that when an element is referred to as being "on" another element, it can be directly in contact with the other element or intervening elements may be present therebetween. In contrast, when an element is referred to as being "directly on" another element, there are no intervening elements present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

As used herein, an "energy level" (e.g., a highest occupied molecular orbital (HOMO) energy level or a triplet (T₁) energy level) is expressed as an absolute value from a vacuum level. In addition, when the energy level is referred to as being "deep," "high," or "large," the energy level has a large absolute value based on "0 electron Volts (eV)" of the vacuum level, and when the energy level is referred to as being "shallow," "low," or "small," the energy level has a small absolute value based on "0 eV" of the vacuum level.

The organometallic compound is represented by Formula 1:

Formula 1 M₁(Ln₁)ₙ₁(Ln₂)ₙ₂

wherein M₁ in Formula 1 is a transition metal.

For example, M₁ may be a first-row transition metal of the Periodic Table of Elements, a second-row transition metal of the Periodic Table of Elements, or a third-row transition metal of the Periodic Table of Elements.

In an embodiment, M₁ may be iridium (Ir), platinum (Pt), osmium (Os), titanium (Ti), zirconium (Zr), hafnium (Hf), europium (Eu), terbium (Tb), thulium (Tm), or rhodium (Rh).

In one or more embodiments, M₁ may be iridium (Ir), platinum (Pt), osmium (Os), or rhodium (Rh).

In one or more embodiments, M₁ may be iridium (Ir).

In Formula 1, n1 is 1 or 2, and n2 is 1 or 2.

In one or more embodiments, a sum of n1 and n2 may be 2 or 3.

In one or more embodiments, M₁ may be iridium (Ir), and the sum of n1 and n2 may be 3.

In one or more embodiments, M₁ may be platinum (Pt), and the sum of n1 and n2 may be 2.

In one or more embodiments, M₁ may be iridium (Ir), n1 may be 2, and n2 may be 1.

In Formula 1, Ln₁ is a ligand represented by Formula 1A: 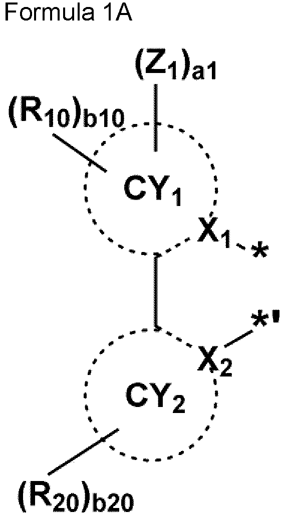 wherein, in Formula 1A, X₁ is C or N, and X₂ is C or N.

The bond between M₁ and X₁ in Formula 1A may be a covalent bond or a coordinate bond.

The bond between M₁ and X₂ in Formula 1A may be a covalent bond or a coordinate bond.

In one or more embodiments, X₁ may be N, X₂ may be C, the bond between X₁ and M₁ may be a coordinate bond, and the bond between X₂ and M₁ may be a covalent bond.

In Formula 1A, ring CY₁ and ring CY₂ are each independently a C₅-C₃₀ carbocyclic group or a C₁-C₃₀ heterocyclic group.

In one or more embodiments, ring CY₁ and ring CY₂ may each independently be i) a first ring, ii) a second ring, iii) a condensed ring group in which at least two first rings are condensed, iv) a condensed ring group in which at least two second rings are condensed, or v) a condensed ring group in which at least one first ring is condensed with at least one second ring,
the first ring may be a cyclopentane group, a cyclopentadiene group, a furan group, a thiophene group, a pyrrole group, a silole group, an indene group, a benzofuran group, a benzothiophene group, an indole group, a benzosilole group, an oxazole group, an isoxazole group, an oxadiazole group, an isoxadiazole group, an oxatriazole group, an isoxatriazole group, a thiazole group, an isothiazole group, a thiadiazole group, an isothiadiazole group, a thiatriazole group, an isothiatriazole group, a pyrazole group, an imidazole group, a triazole group, a tetrazole group, an azasilole group, a diazasilole group, or a triazasilole group, and
the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

**In** one or more embodiments, ring CY₁ and ring CY₂ may each independently be a cyclopentane group, a cyclohexane group, a cycloheptane group, a cyclopentene group, a cyclohexene group, a cycloheptene group, a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group.

**In** one or more embodiments, ring CY₁ and ring CY₂ may each independently be a benzene group, a naphthalene group, a 1,2,3,4-tetrahydronaphthalene group, a phenanthrene group, a pyridine group, a pyrimidine group, a pyrazine group, a triazine group, a quinoline group, an isoquinoline group, a quinoxaline group, a quinazoline group, a phenanthroline group, a benzofuran group, a benzothiophene group, a fluorene group, a carbazole group, a dibenzofuran group, a dibenzothiophene group, a dibenzosilole group, an azafluorene group, an azacarbazole group, an azadibenzofuran group, an azadibenzothiophene group, or an azadibenzosilole group.

In one or more embodiments, ring CY₁ and ring CY₂ may each independently be a benzene group, a naphthalene group, a pyridine group, a pyrimidine group, a pyrazine group, a triazine group, a quinoline group, an isoquinoline group, a quinoxaline group, a quinazoline group, a fluorene group, a carbazole group, a dibenzofuran group, a dibenzothiophene group, or a dibenzosilole group.

In one or more embodiments, a moiety represented by may be a group represented by one of Formulae 1-1 to 1-32: 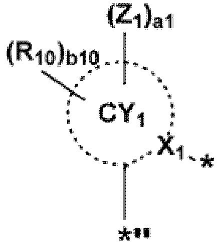 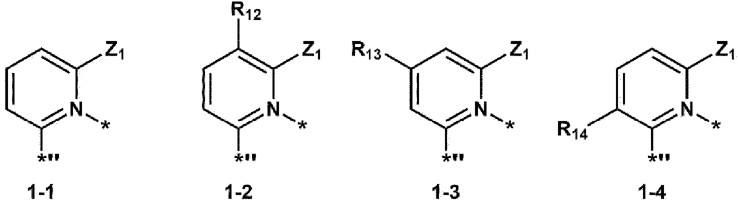 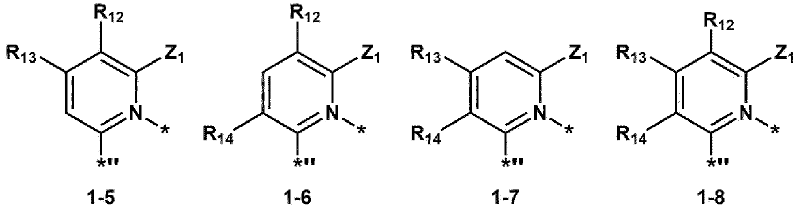 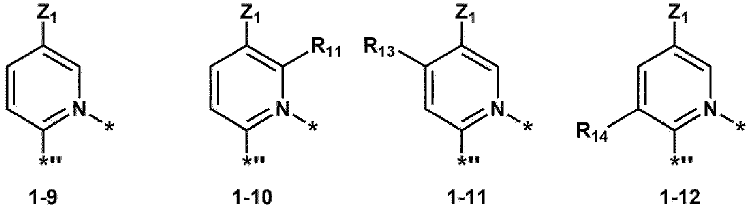 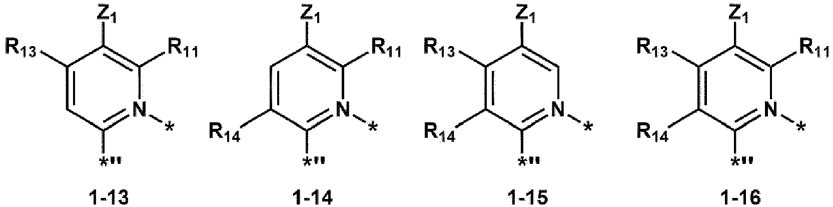 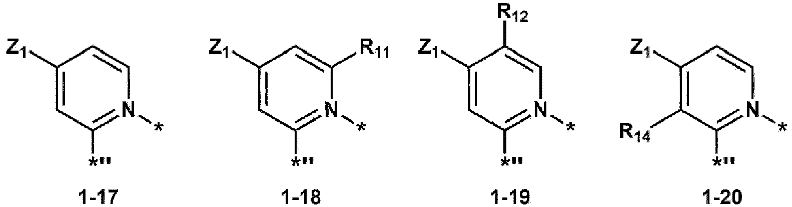 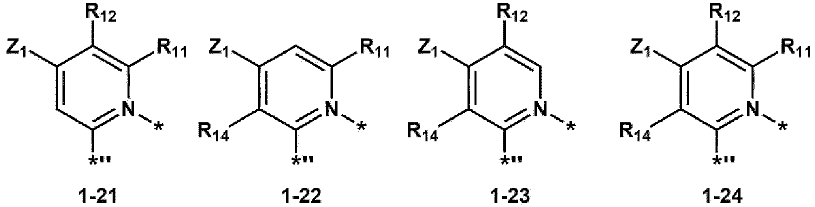 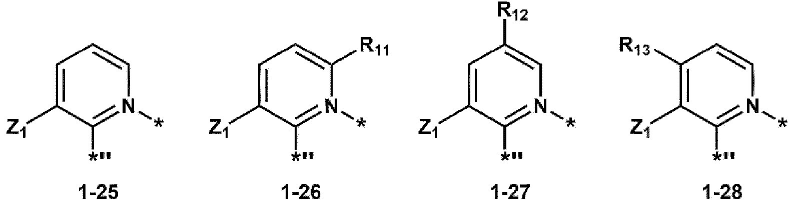 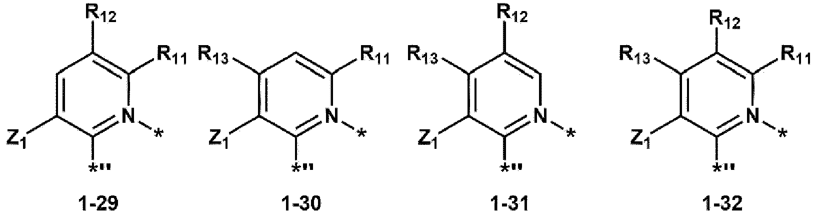 wherein, in Formulae 1-1 to 1-32,
R₁₁ to R₁₄ are each independently as described herein in connection with R₁₀, provided that R₁₁ to R₁₄ may not be hydrogen,
Z₁ is as described herein,
* indicates a binding site to M₁, and
*" indicates a binding site to a neighboring atom.

In one or more embodiments, a moiety represented by may be a group represented by one of Formulae 2-1 to 2-16: 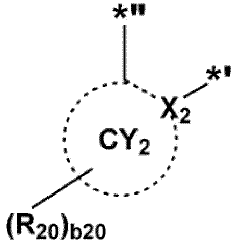 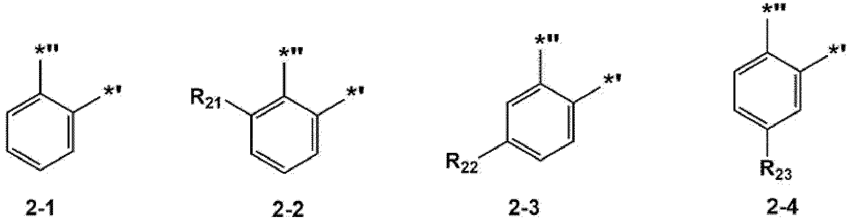 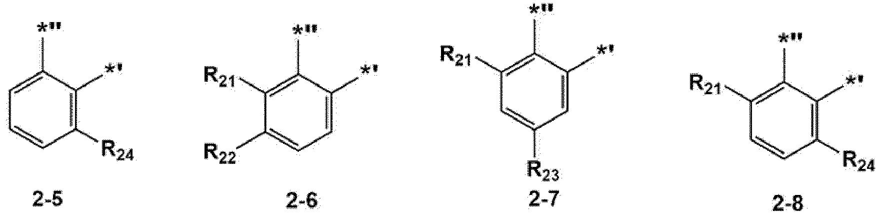 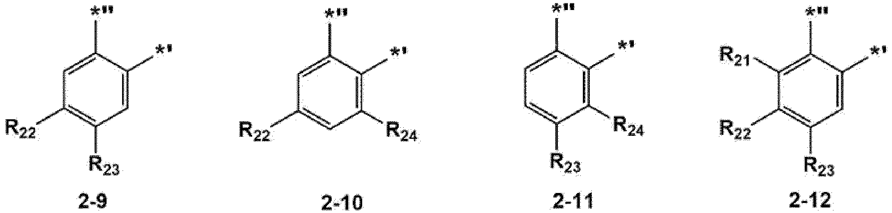 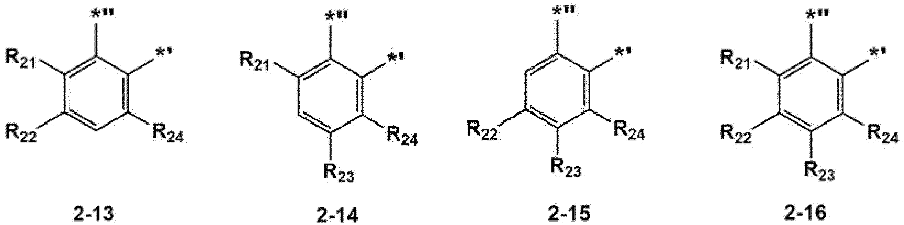 wherein, in Formulae 2-1 to 2-16,
R₂₁ to R₂₄ are each independently as described herein in connection with R₂₀, provided that R₂₁ to R₂₄ may not be hydrogen,
*' indicates a binding site to M₁, and
*" indicates a binding site to a neighboring atom.

In Formula 1A, Z₁ is -Si(Q₁)(Q₂)(Q₃) or -Ge(Q₁)(Q₂)(Q₃), wherein Q₁ to Q₃ are as defined herein.

In one or more embodiments, Z₁ may not be -SiH₃.

In one or more embodiments, Q₁ to Q₃ in Z₁ may each independently be:
deuterium, -CH₃, -CD₃, -CD₂H, -CDH₂, -CH₂CH₃, -CH₂CD₃, -CH₂CD₂H, - CH₂CDH₂, -CHDCH₃, -CHDCD₂H, -CHDCDH₂, -CHDCD₃, -CD₂CD₃, -CD₂CD₂H, or -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group; or
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group, each substituted with at least one of deuterium, a C₁-C₁₀ alkyl group, a phenyl group, or a combination thereof.

For example, Q₁ to Q₃ in Z₁ may each independently be -CH₃, -CD₃, -CD₂H, or - CDH₂.

In Formula 1A, a1 is 1, 2, 3, or 4.

In one or more embodiments, a1 may be 1.

In Formula 1, Ln₂ is a ligand represented by Formula 1B: 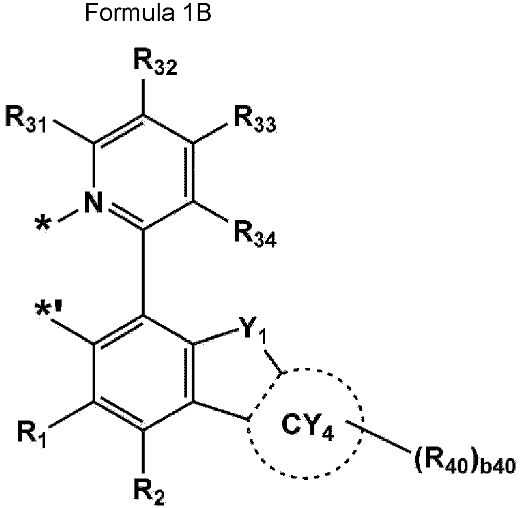 wherein, in Formula 1B, ring CY₄ is a polycyclic C₅-C₃₀ carbocyclic group or a polycyclic C₁-C₃₀ heterocyclic group. In one or more embodiments, ring CY₄ may be a tricyclic C₅-C₃₀ carbocyclic group or a tricyclic C₁-C₃₀ heterocyclic group. For example, ring CY₄ may be a tricyclic C₅-C₃₀ carbocyclic group.

In one or more embodiments, ring CY₄ may be a group represented by Formula 4: 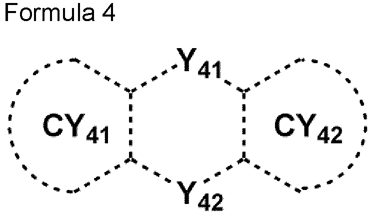 wherein, in Formula 4,
Y₄₁ and Y₄₂ may each independently be a single bond, *-O-*', *-S-*', *-Se-*', *-N(R₅₁)-*', *-C(R₅₁)(R₅₂)-*', *-Si(R₅₁)(R₅₂)-*', *-B(R₅₁)-*', *-P(R₅₁)-*', *-C(=O)-*', *-S(=O)₂-*', *-P(=O)(R₅₁)-*', *-C(R₅₁)=*', *-N=*', *-C(R₅₁)=C(R₅₂)-*', *-C(R₅₁)=N-*', or *-N=N-*',
ring CY₄₁ and ring CY₄₂ may each independently be a C₆-C₁₆ carbocyclic group or a C₁-C₁₅ heterocyclic group, and
R₅₁ and R₅₂ are each independently as described herein in connection with R₄₀. The group represented by Formula 4 may be condensed with the ring containing Y₁ via ring CY₄₁.

In one or more embodiments, ring CY₄₁ and ring CY₄₂ may each independently be i) a first ring, ii) a second ring, iii) a condensed ring group in which at least two first rings are condensed, iv) a condensed ring group in which at least two second rings are condensed, or v) a condensed ring group in which at least one first ring is condensed with at least one second ring,
the first ring may be a cyclopentane group, a cyclopentadiene group, a furan group, a thiophene group, a pyrrole group, a silole group, an indene group, a benzofuran group, a benzothiophene group, an indole group, a benzosilole group, an oxazole group, an isoxazole group, an oxadiazole group, an isoxadiazole group, an oxatriazole group, an isoxatriazole group, a thiazole group, an isothiazole group, a thiadiazole group, an isothiadiazole group, a thiatriazole group, an isothiatriazole group, a pyrazole group, an imidazole group, a triazole group, a tetrazole group, an azasilole group, a diazasilole group, or a triazasilole group, and
the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

In one or more embodiments, ring CY₄₁ and ring CY₄₂ may each independently be a cyclopentane group, a cyclohexane group, a cycloheptene group, a cyclopentene group, a cyclohexene group, a cycloheptene group, a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group.

In one or more embodiments, ring CY₄₁ and ring C₄₂ may each independently be a benzene group, a naphthalene group, a 1,2,3,4-tetrahydronaphthalene group, a phenanthrene group, a pyridine group, a pyrimidine group, a pyrazine group, a triazine group, a quinoline group, an isoquinoline group, a quinoxaline group, a quinazoline group, a phenanthroline group, a benzofuran group, a benzothiophene group, a fluorene group, a carbazole group, a dibenzofuran group, a dibenzothiophene group, a dibenzosilole group, an azafluorene group, an azacarbazole group, an azadibenzofuran group, an azadibenzothiophene group, or an azadibenzosilole group.

In one or more embodiments, ring CY₄₁ and ring CY₄₂ may each independently be a benzene group, a naphthalene group, a pyridine group, a pyrimidine group, a pyrazine group, a triazine group, a quinoline group, an isoquinoline group, a quinoxaline group, a quinazoline group, a fluorene group, a carbazole group, a dibenzofuran group, a dibenzothiophene group, or a dibenzosilole group.

In one or more embodiments, a moiety represented by may be a group represented by one of Formulae 4-1 to 4-15: 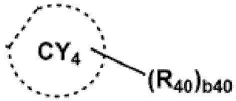 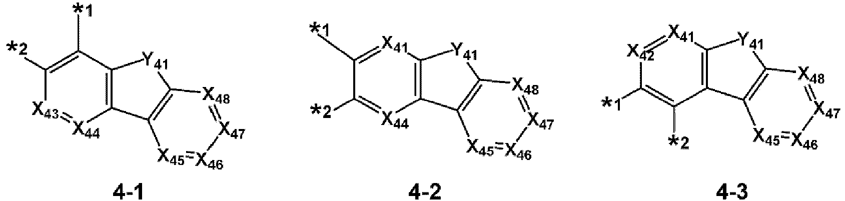 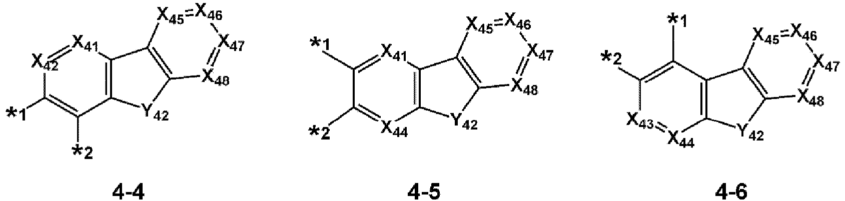 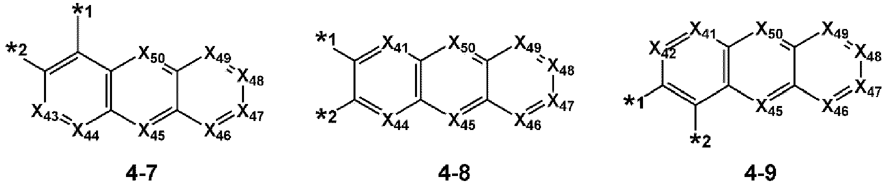 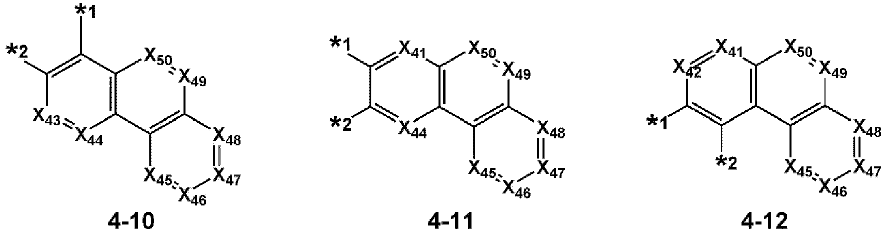 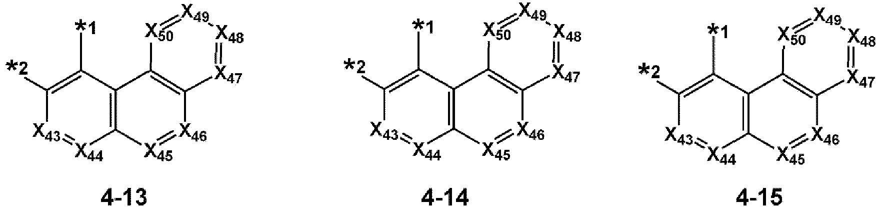 wherein, in Formulae 4-1 to 4-15,
Y₄₁ and Y₄₂ may each independently be O, S, Se, N(R₅₁), C(R₅₁)(R₅₂), Si(R₅₁)(R₅₂), B(R₅₁), P(R₅₁), C(=O), S(=O)₂, or P(=O)(R₅₁),
X₄₁ may be C(R₄₁) or N, X₄₂ may be C(R₄₂) or N, X₄₃ may be C(R₄₃) or N, X₄₄ may be C(R₄₄) or N, X₄₅ may be C(R₄₅) or N, X₄₆ may be C(R₄₆) or N, X₄₇ may be C(R₄₇) or N, X₄₈ may be C(R₄₈) or N, X₄₉ may be C(R₄₉) or N, and X₅₀ may be C(R₅₀) or N,
R₄₁ to R₅₂ are each independently as described herein in connection with R₄₀, and
*¹ and *² each indicate a binding site to a neighboring atom.
*¹ may indicate a binding site to Y₁, and *² may indicate a binding site to carbon atom.

In Formula 1B, Y₁ is O, S, or Se.

In one or more embodiments, Y₁ may be O or S.

In Formulae 1A and 1B, R₁, R₂, R₁₀, R₂₀, R₃₁ to R₃₄, and R₄₀ are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -Si(Q₁)(Q₂)(Q₃), - Ge(Q₁)(Q₂)(Q₃), -N(Q₄)(Q₅), -B(Q₆)(Q₇), -P(Q₈)(Q₉), or -P(=O)(Q₈)(Q₉).

In Formula 1A, b10, b20, and b40 are each independently 1, 2, 3, 4, 5, 6, 7, 8, 9, or 10.

In one or more embodiments, b10, b20, and b40 may each independently be 1, 2, 3, 4, 5, 6, 7, or 8.

In one or more embodiments, b10, b20, and b40 may each independently be 1, 2, 3, 4, 5, or 6.

In one or more embodiments, b10, b20, and b40 may each independently be 1, 2, 3, or 4.

In one or more embodiments, R₁, R₂, R₁₀, R₂₀, R₃₁ to R₃₄, and R₄₀ may each independently be:
hydrogen, deuterium, -F, -Cl, -Br, -I, -SF₅, -CD₃, -CD₂H, -CDH₂, -CF₃, - CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, or a C₁-C₂₀ alkylthio group;
a C₁-C₂₀ alkyl group, a C₁-C₂₀ alkoxy group, or a C₁-C₂₀ alkylthio group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, or a pyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, or a combination thereof; or
-Si(Q₁)(Q₂)(Q₃), -Ge(Q₁)(Q₂)(Q₃), -N(Q₄)(Q₅), -B(Q₆)(Q₇), -P(Q₈)(Q₉), or - P(=O)(Q₈)(Q₉).

In one or more embodiments, R₁, R₂, R₁₀, R₂₀, R₃₁ to R₃₄, and R₄₀ may each independently be:
hydrogen, deuterium, -F, -Cl, -Br, -I, -SF₅, -CD₃, -CD₂H, -CDH₂, -CF₃, - CF₂H,
   -CFH₂, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group; or
a group represented by one of Formulae 9-1 to 9-67, 9-201 to 9-244, 10-1 to 10-154, or 10-201 to 10-350: 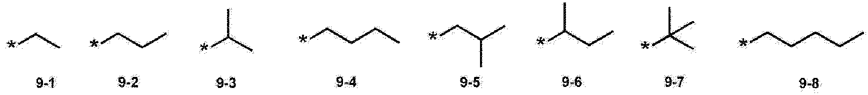 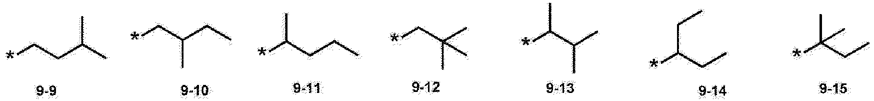 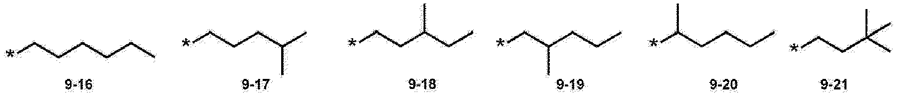 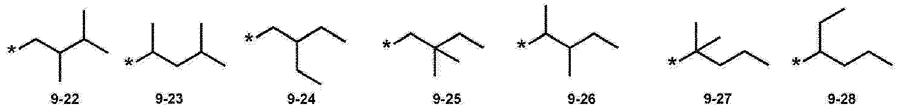 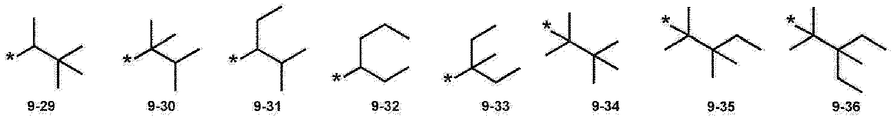 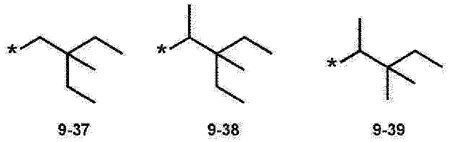 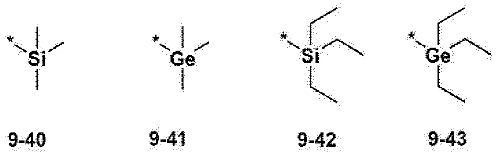 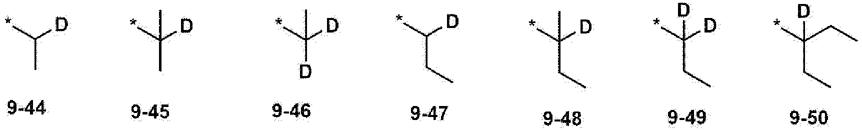 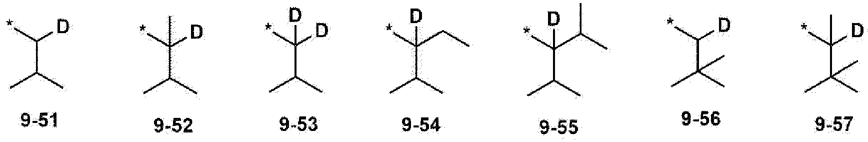 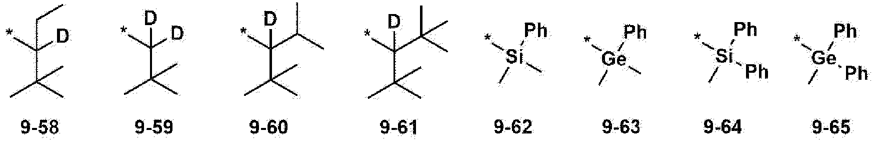 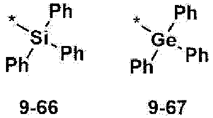 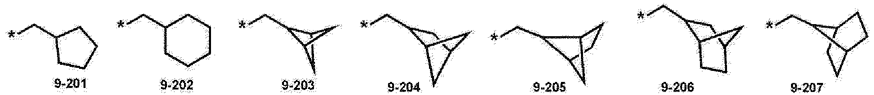 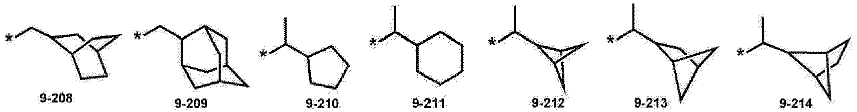 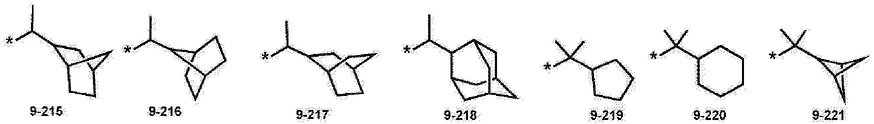 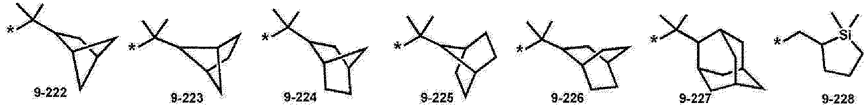 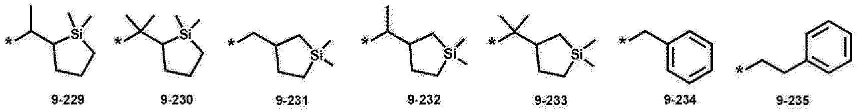 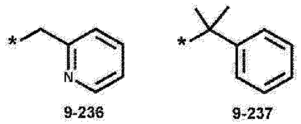 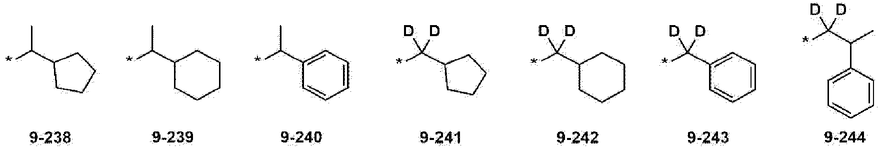 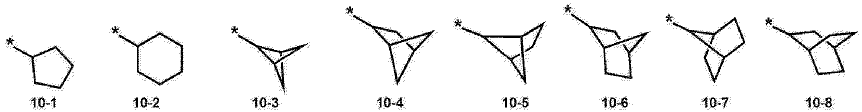 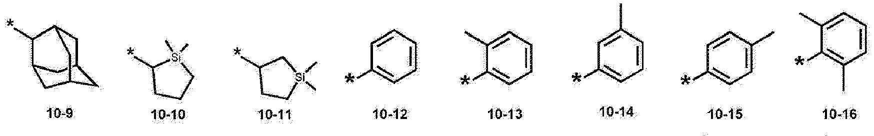 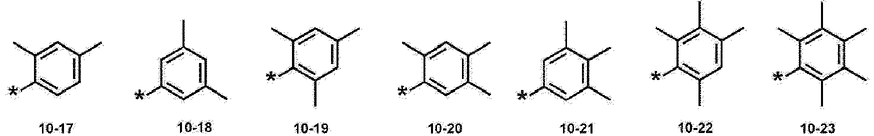 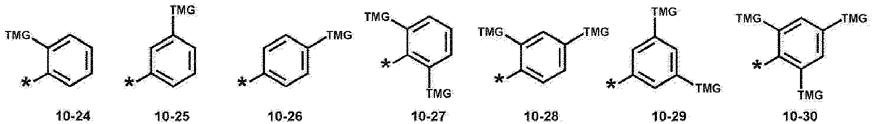 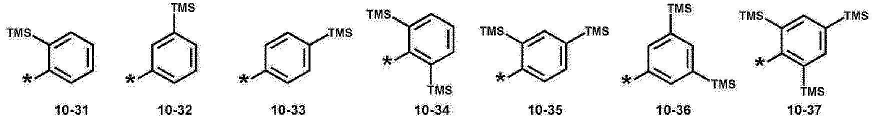 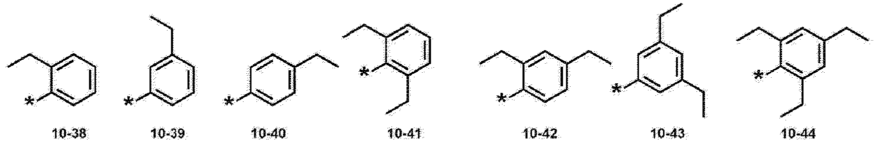 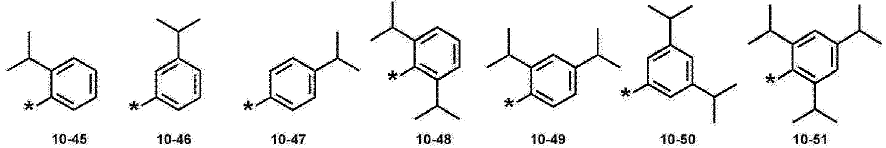 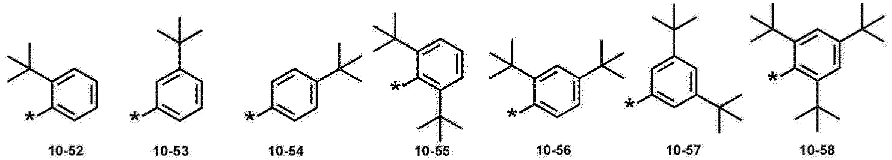 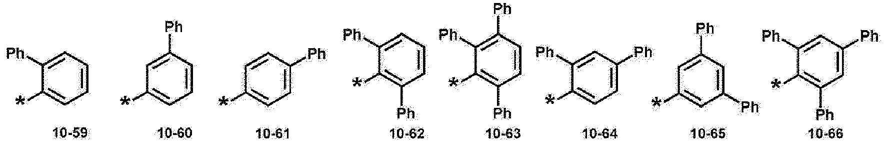 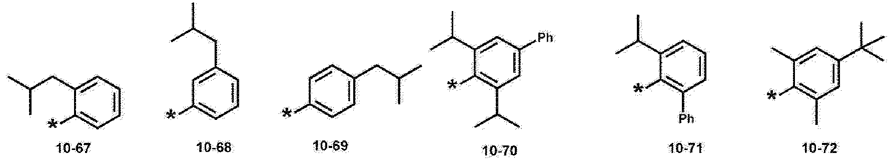 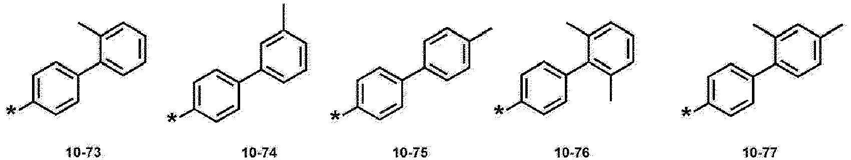 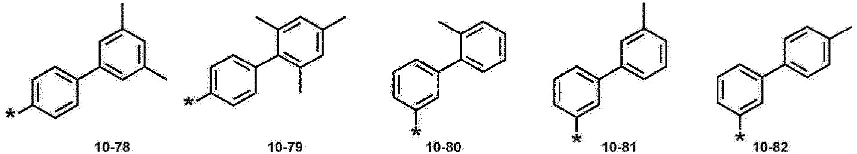 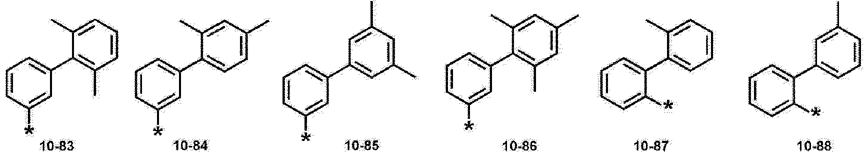 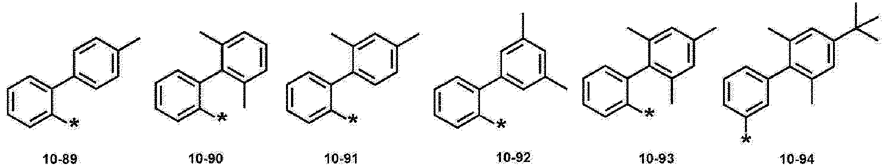 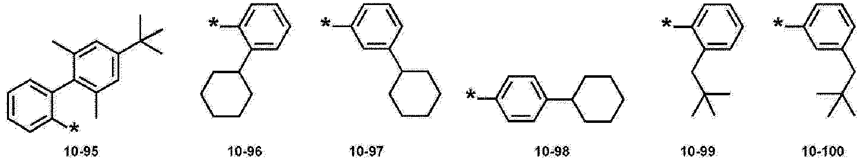 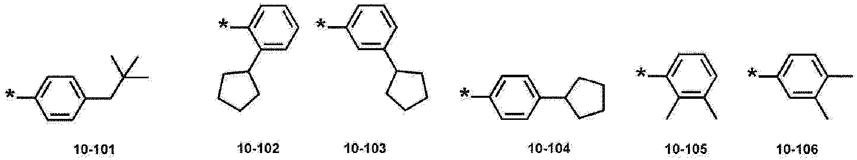 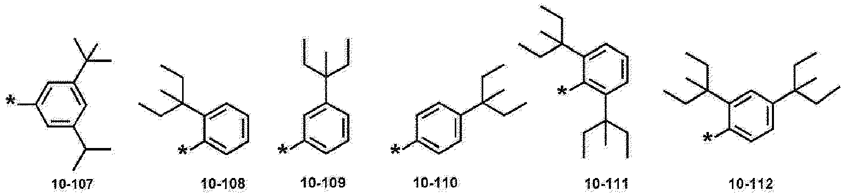 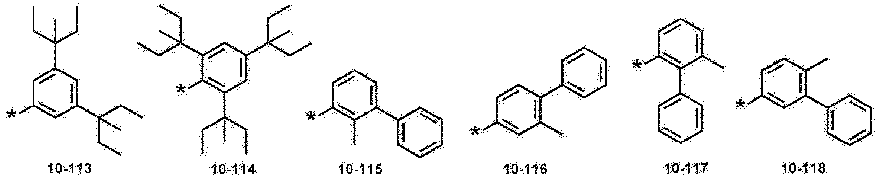 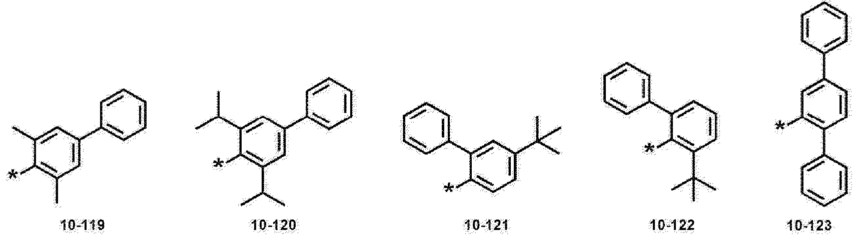 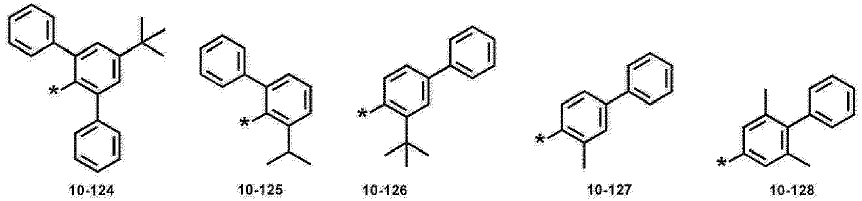 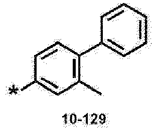 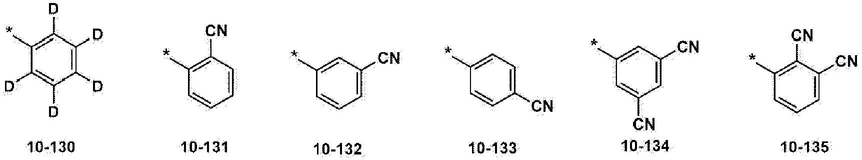 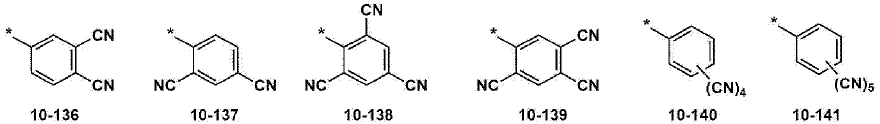 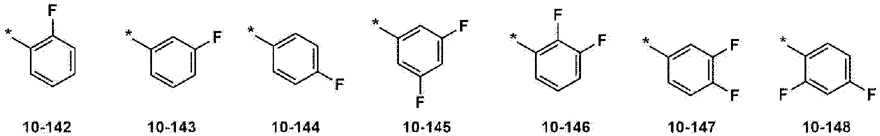 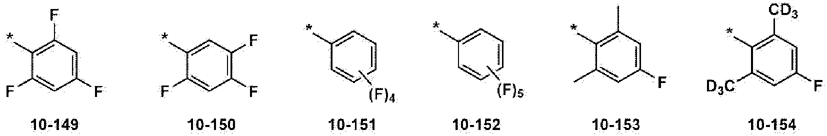 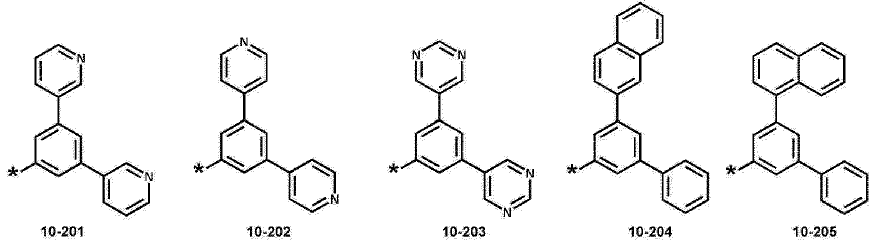 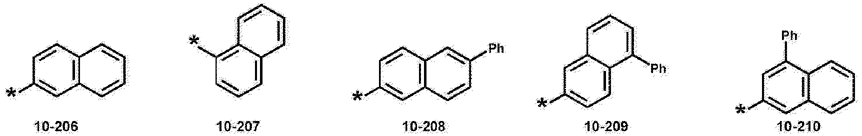 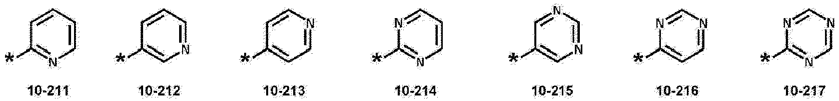 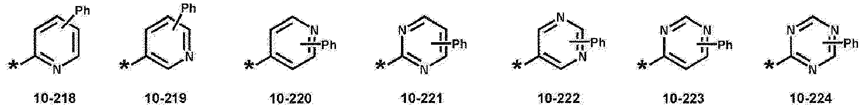 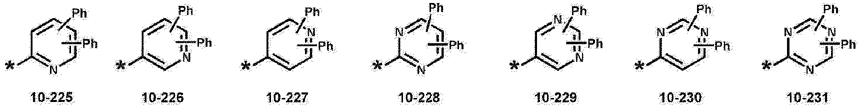 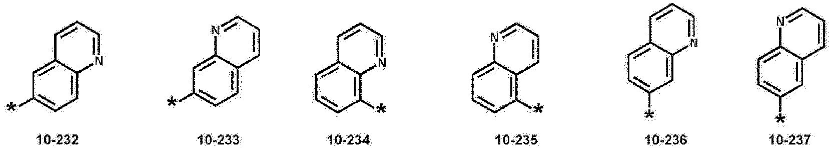 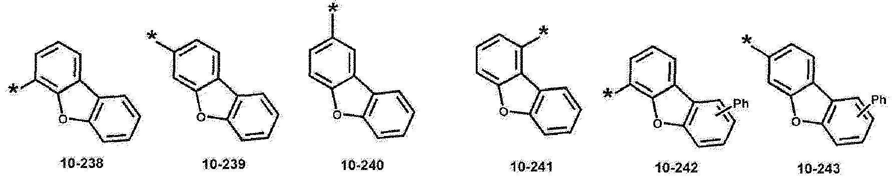 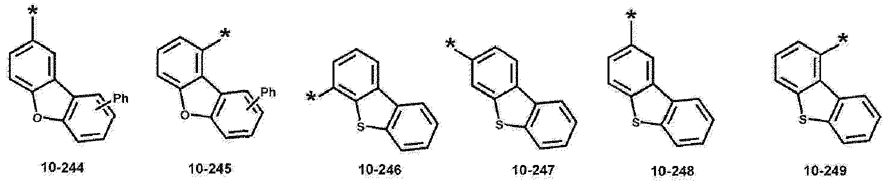 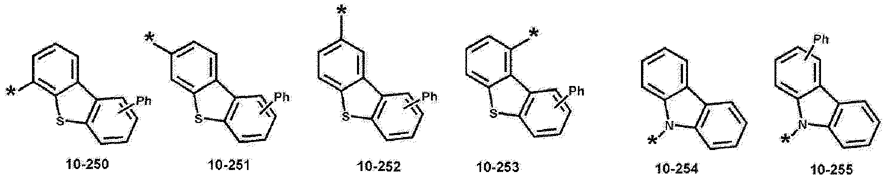 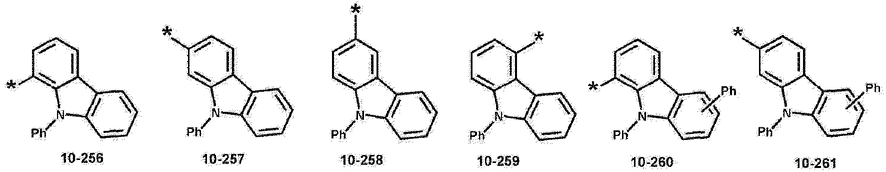 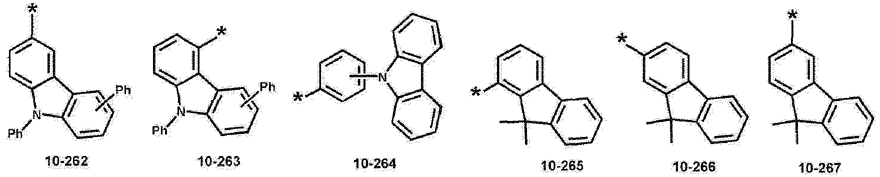 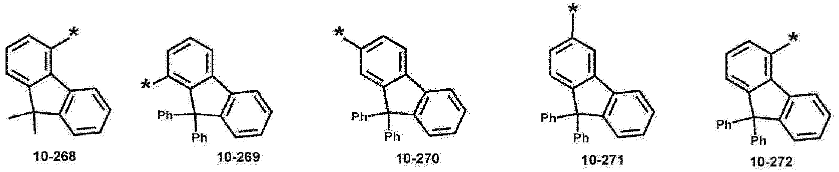 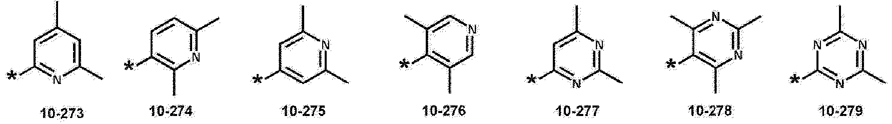 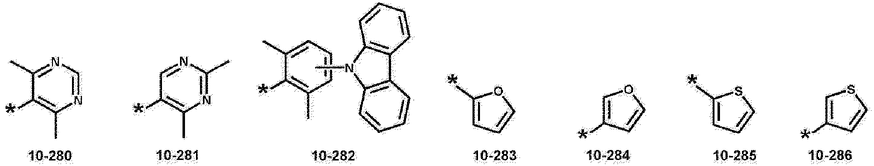 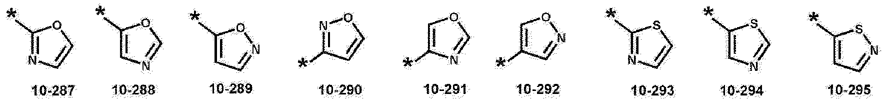 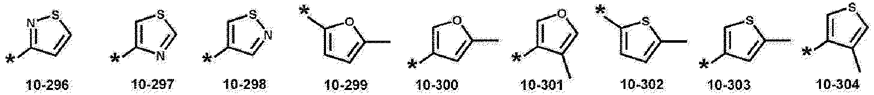 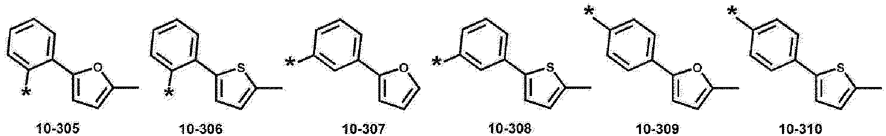 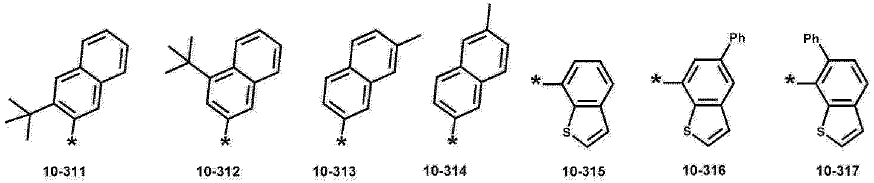 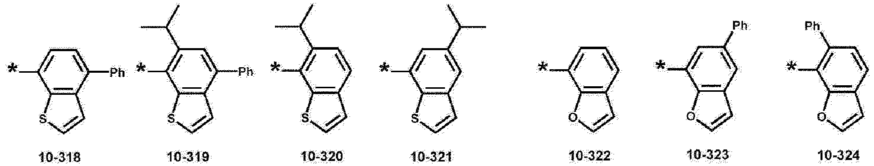 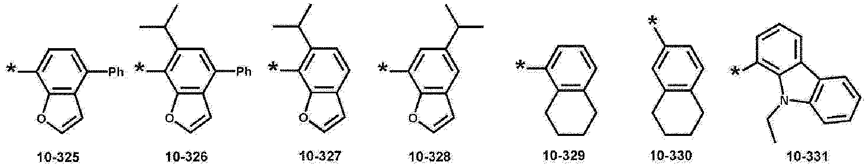 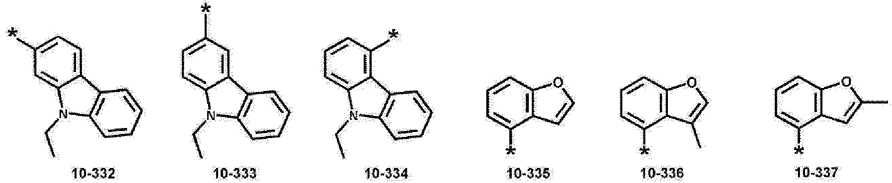 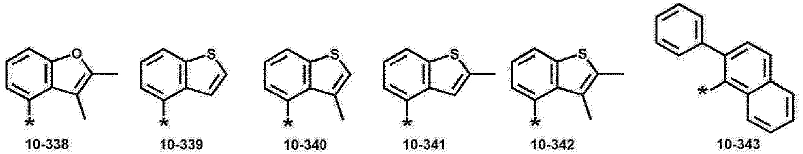 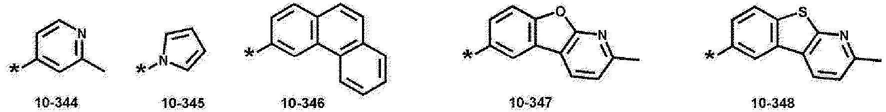 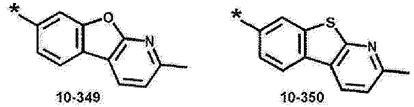
wherein, in Formulae 9-1 to 9-67, 9-201 to 9-244, 10-1 to 10-154, and 10-201 to 10-350, * indicates a binding site to a neighboring atom, "Ph" is a phenyl group, "TMS" is a trimethylsilyl group, and "TMG" is a trimethylgermyl group.

In Formula 1B, at least one of R₁ and R₂ is a substituted or unsubstituted C₁-C₆₀ alkyl group, a substituted or unsubstituted C₃-C₁₀ cycloalkyl group, or a substituted or unsubstituted C₆-C₆₀ aryl group.

In one or more embodiments, at least one of R₁ and R₂ may be an unsubstituted C₁-C₆₀ alkyl group, a C₁-C₆₀ alkyl group substituted with at least one deuterium, an unsubstituted C₃-C₁₀ cycloalkyl group, a C₃-C₁₀ cycloalkyl group substituted with at least one deuterium, an unsubstituted C₆-C₆₀ aryl group, or a C₆-C₆₀ aryl group substituted with at least one deuterium.

In one or more embodiments, when R₁ and R₂ are each a C₁-C₆₀ alkyl group substituted with at least one deuterium, a C₃-C₁₀ cycloalkyl group substituted with at least one deuterium, or a C₆-C₆₀ aryl group substituted with at least one deuterium, then R₁ and R₂ may each independently be a group represented by one of Formulae 8-1 to 8-32: 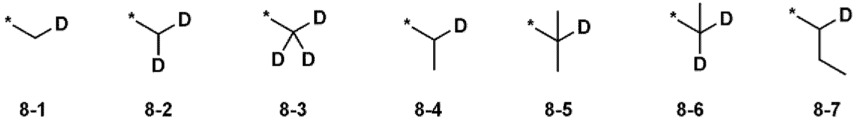 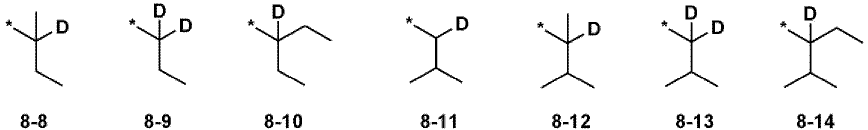 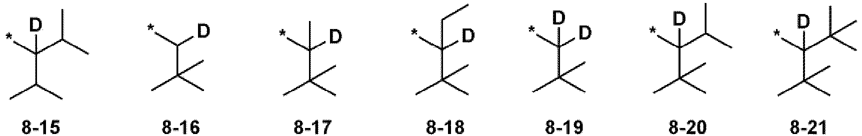 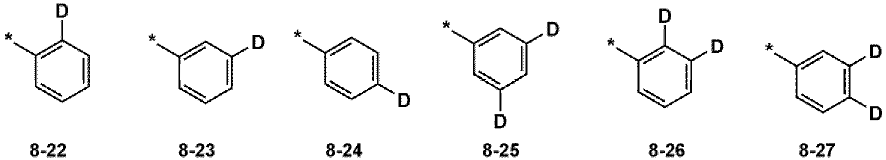 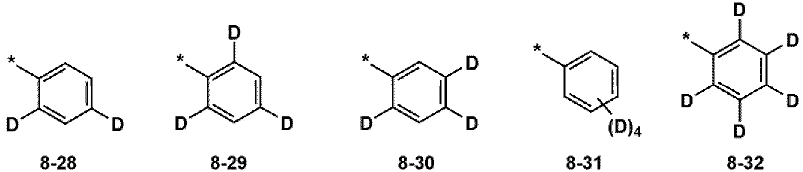 wherein, in Formulae 8-1 to 8-32,
* indicates a binding site to a neighboring atom.

In one or more embodiments, at least one of R₁ and R₂ may be a C₁-C₆₀ alkyl group substituted with at least one deuterium.

In one or more embodiments, R₁ and R₂ may each independently be hydrogen, deuterium, a substituted or unsubstituted C₁-C₆₀ alkyl group, a substituted or unsubstituted C₃-C₁₀ cycloalkyl group, or a substituted or unsubstituted C₆-C₆₀ aryl group.

In one or more embodiments, at least one of R₃₁ to R₃₄ may not be hydrogen.

In one or more embodiments, at least one of R₃₁ to R₃₄ may be deuterium, -F, - Cl, -Br, -I, -SF₅, -CD₃, -CD₂H, -CDH₂, -CF₃, -CF₂H, -CFH₂, a C₁-C₆₀ alkyl group, a C₁-C₆₀ alkyl group substituted with at least one deuterium, -Si(Q₃)(Q₄)(Q₅), or -Ge(Q₃)(Q₄)(Q₅).

In one or more embodiments, at least one of R₃₁ to R₃₄ may be deuterium, -F, - Cl, -Br, -I, -SF₅, -CD₃, -CD₂H, -CDH₂, -CF₃, -CF₂H, -CFH₂, a C₁-C₆₀ alkyl group, or a C₁-C₆₀ alkyl group substituted with at least one deuterium.

In Formula 1A, two or more of a plurality of R₁₀ are optionally bonded to each other to form a substituted or unsubstituted C₅-C₃₀ carbocyclic group or a substituted or unsubstituted C₁-C₃₀ heterocyclic group.

In one or more embodiments, two or more of a plurality of R₁₀ are optionally bonded to each other, via a single bond, a double bond, or a first linking group, to form a C₅-C₃₀ carbocyclic group unsubstituted or substituted with at least one R₁₀ₐ or a C₁-C₃₀ heterocyclic group unsubstituted or substituted with at least one R₁₀ₐ (for example, a fluorene group, an xanthene group, or an acridine group, each unsubstituted or substituted with at least one R₁₀ₐ). R₁₀ₐ is as described herein in connection with R₁₀.

In Formulae 1A and 1B, two or more of R₁, R₂, R₁₀, R₂₀, R₃₁ to R₃₄, and R₄₀ may optionally be bonded to each other to form a substituted or unsubstituted C₅-C₃₀ carbocyclic group or a substituted or unsubstituted C₁-C₃₀ heterocyclic group.

In one or more embodiments, two or more of R₁, R₂, R₁₀, R₂₀, R₃₁ to R₃₄, or R₄₀ are optionally bonded to each other (e.g., via a single bond, a double bond, or first linking group) to form a C₅-C₃₀ carbocyclic group unsubstituted or substituted with at least one R₁₀ₐ or a C₁-C₃₀ heterocyclic group unsubstituted or substituted with at least one R₁₀ₐ (for example, a fluorene group, a xanthene group, an acridine group, or the like, each unsubstituted or substituted with at least one R₁₀ₐ). R₁₀ₐ is as described herein in connection with R₁₀.

In one or more embodiments, examples of the "C₅-C₃₀ carbocyclic group unsubstituted or substituted with at least one R₁₀ₐ or a C₁-C₃₀ heterocyclic group unsubstituted or substituted with at least one R₁₀ₐ" include a benzene group, a naphthalene group, a cyclopentane group, a cyclopentadiene group, a cyclohexane group, a cycloheptane group, a bicyclo[2.2.1]heptane group, a furan group, a thiophene group, a pyrrole group, a silole group, an indene group, a benzofuran group, a benzothiophene group, an indole group, or a benzosilole group, each unsubstituted or substituted with at least one R₁₀ₐ. R₁₀ₐ is the same as described herein in connection with R₁₀. The C₅-C₃₀ carbocyclic group and the C₁-C₃₀ heterocyclic group are each as described herein.

The first linking group may be *-N(R₈)-*', *-B(R₈)-*', *-P(R₈)-*', *-C(R₈)(R₉)-*', *-Si(R₈)(R₉)-*', *-Ge(R₈)(R₉)-*', *-S-*', *-Se-*', *-O-*', *-C(=O)-*', *-S(=O)-*', *-S(=O)₂-*', *-C(R₈)=*', *=C(R₈)-*', *-C(R₈)=C(R₉)-*', *-C(=S)-*', or *-C=C-*', R₈ and R₉ are each as described herein in connection with R₁₀, and * and *' each indicate a binding site to a neighboring atom.

In one or more embodiments, Q₁ to Q₉, Q₁₁ to Q₁₉, Q₂₁ to Q₂₉ and Q₃₁ to Q₃₉ described herein may each independently be:
deuterium, -CH₃, -CD₃, -CD₂H, -CDH₂, -CH₂CH₃, -CH₂CD₃, -CH₂CD₂H, - CH₂CDH₂, -CHDCH₃, -CHDCD₂H, -CHDCDH₂, -CHDCD₃, -CD₂CD₃, -CD₂CD₂H, or -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group; or
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group, each substituted with at least one of deuterium, a C₁-C₁₀ alkyl group, a phenyl group, or a combination thereof.

In one or more embodiments, the organometallic compound may be a compound represented by Formula 11: 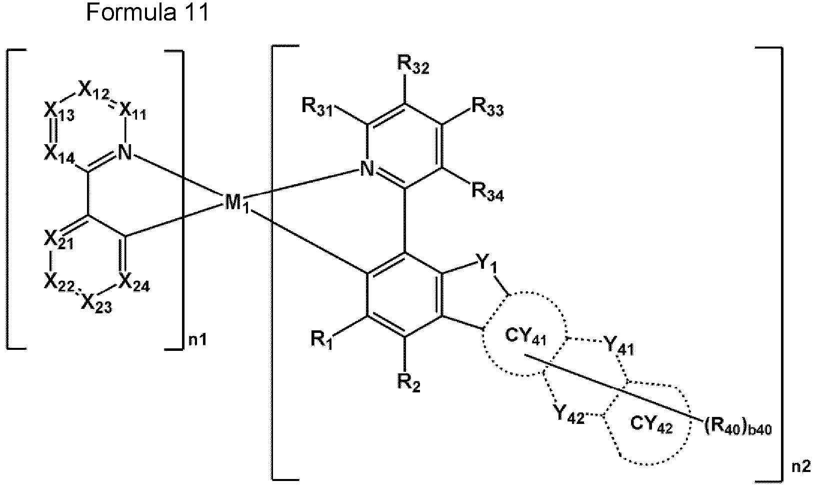 wherein, in Formula 11,
M₁, n1, n2, R₁, R₂, R₃₁ to R₃₄, R₄₀, and Y₁ are each as described herein,
Y₄₁ and Y₄₂ may each independently be a single bond, *-O-*', *-S-*', *-Se-*', *-N(R₅₁)-*', *-C(R₅₁)(R₅₂)-*', *-Si(R₅₁)(R₅₂)-*', *-B(R₅₁)-*', *-P(R₅₁)-*', *-C(=O)-*', *-S(=O)₂-*', *-P(=O)(R₅₁)-*', *-C(R₅₁)=*', *-N=*', *-C(R₅₁)=C(R₅₂)-*', *-C(R₅₁)=N-*', or *-N=N-*',
ring CY₄₁ and ring CY₄₂ may each independently be a C₆-C₁₅ carbocyclic group or a C₁-C₁₅ heterocyclic group,
X₁₁ may be C(Z₁), C(R₁₁), or N, X₁₂ may be C(Z₁), C(R₁₂), or N, X₁₃ may be C(Z₁), C(R₁₃), or N, and X₁₄ may be C(Z₁), C(R₁₄), or N,
X₂₁ is C(R₂₁) or N, X₂₂ is C(R₂₂) or N, X₂₃ is C(R₂₃) or N, and X₂₄ is C(R₂₄) or N,
at least one of X₁₁ to X₁₄ may be C(Z₁),
two or more of R₁₁ to R₁₄ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of R₂₁ to R₂₄ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more R₄₀ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
R₁₀ₐ is as described in connection with R₁₀,
R₁₁ to R₁₄ are independently as described in connection with R₁₀,
R₂₁ to R₂₄ are independently as described in connection with R₂₀, and
R₅₁ and R₅₂ are each independently as described herein in connection with R₄₀.

In one or more embodiments, the organometallic compound may be a compound represented by one of Formulae 21-1 to 21-15: 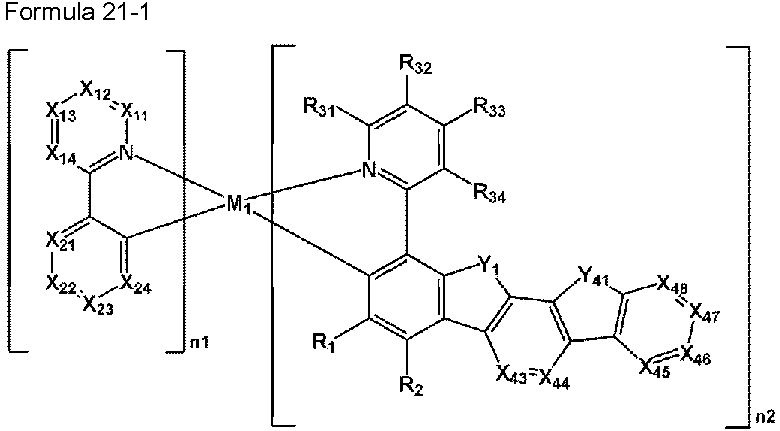 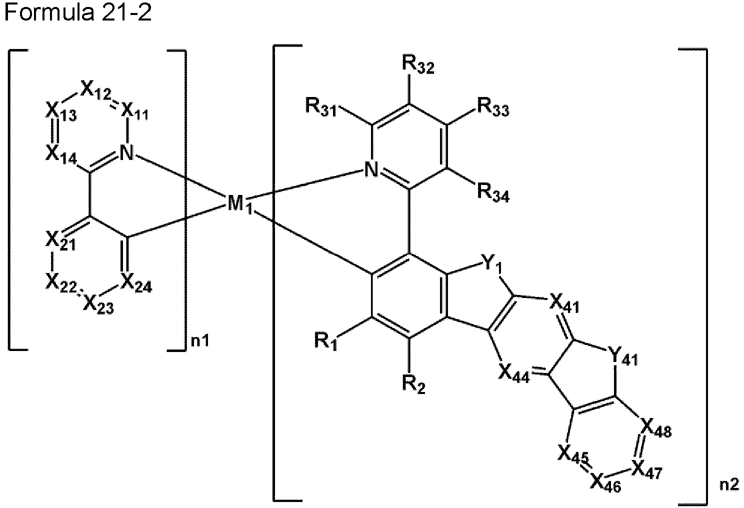 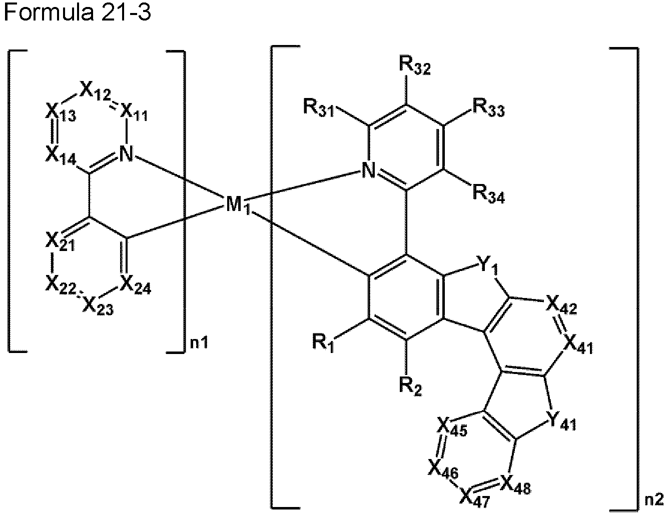 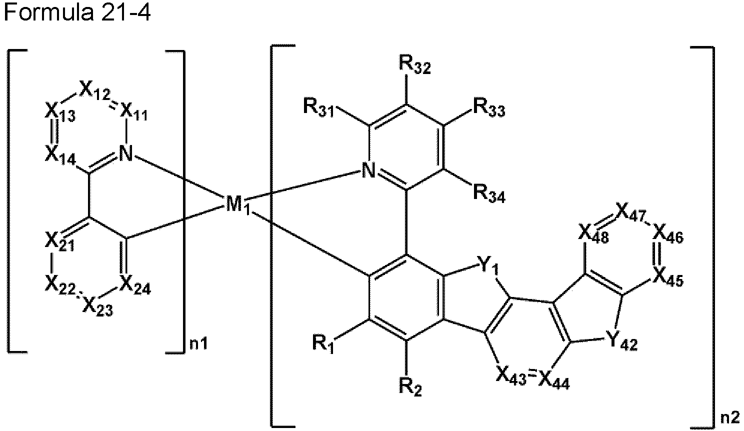 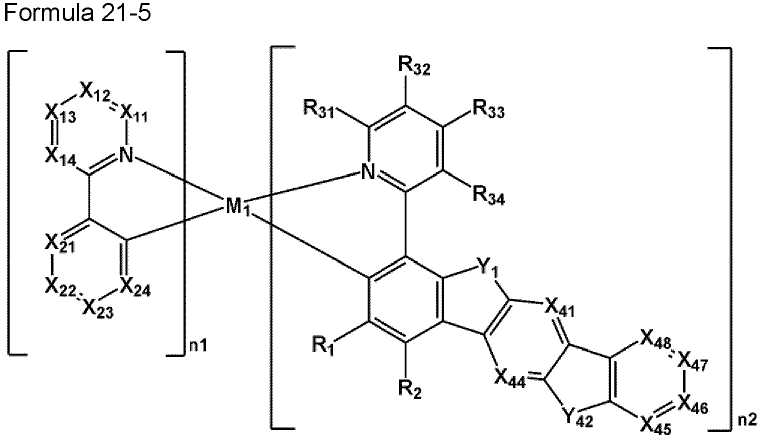 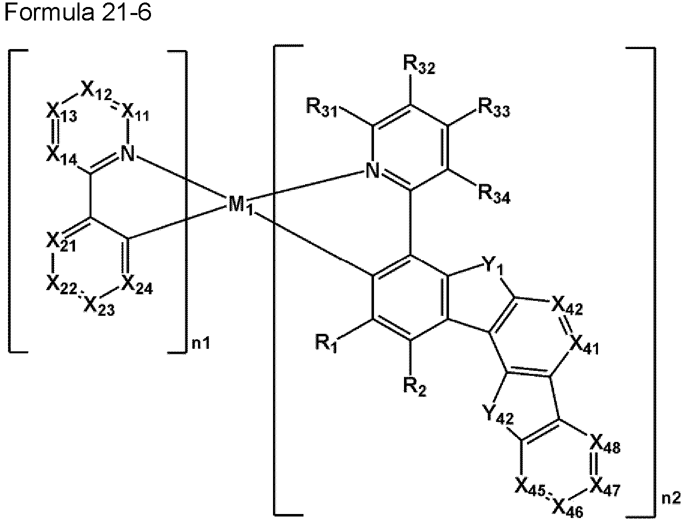 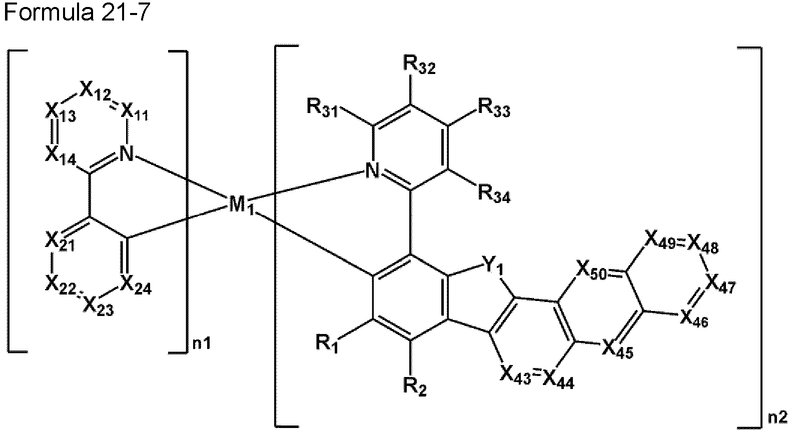 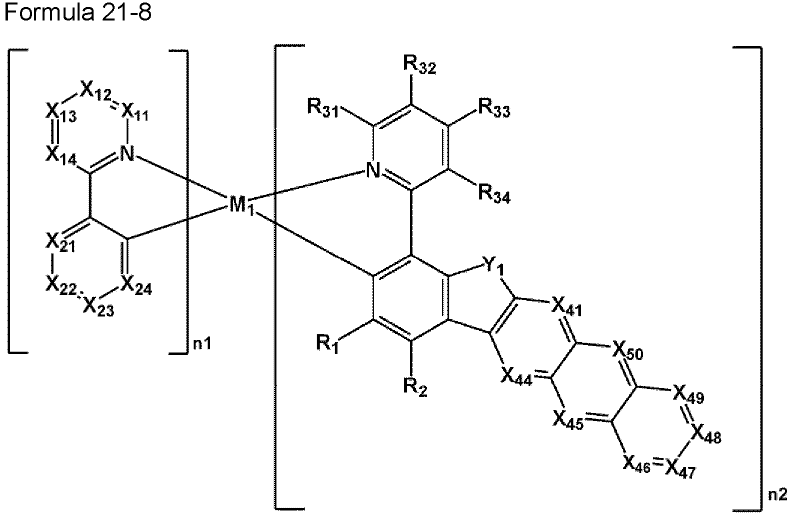 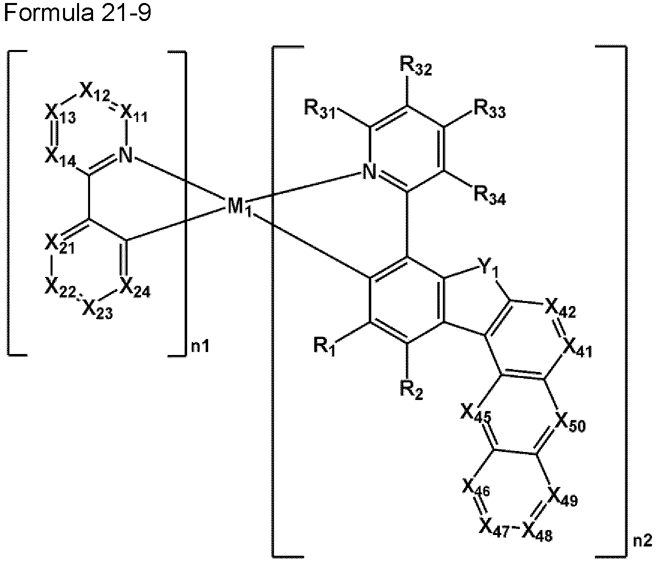 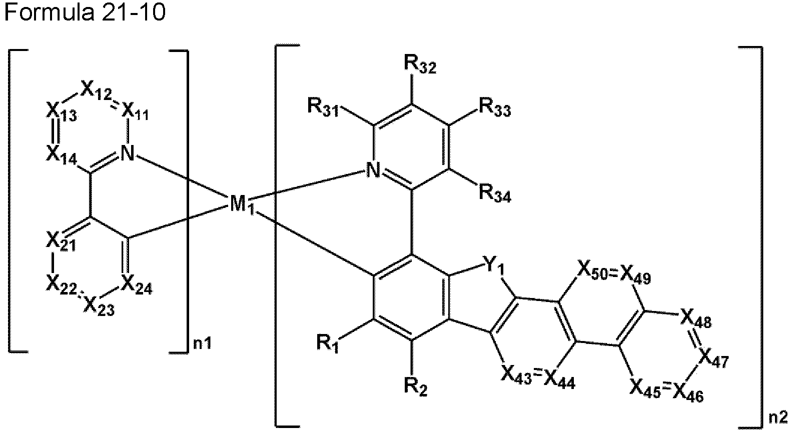 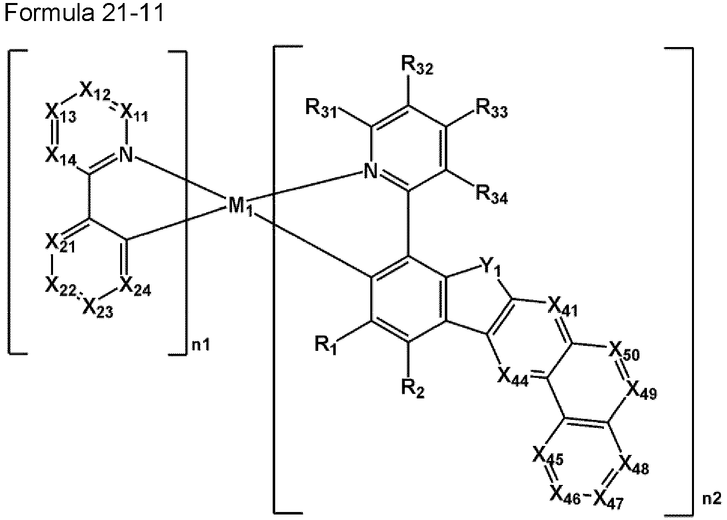 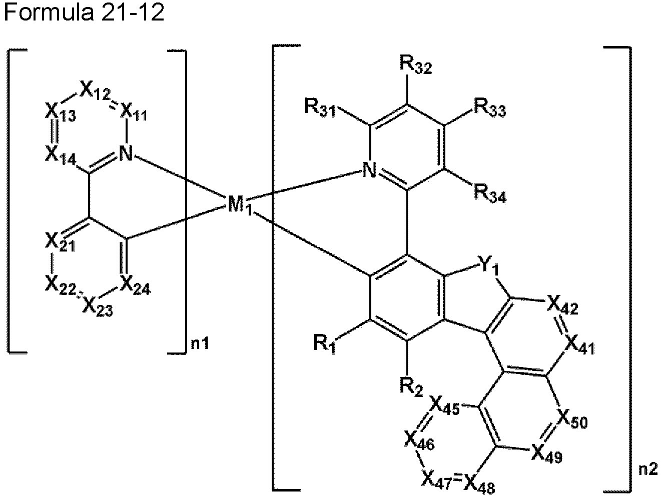 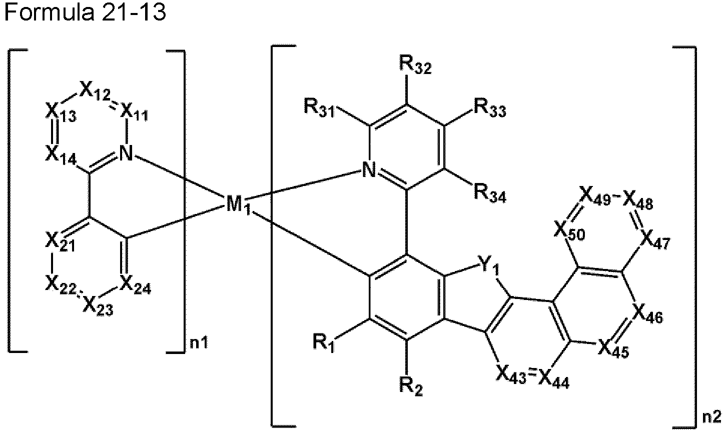 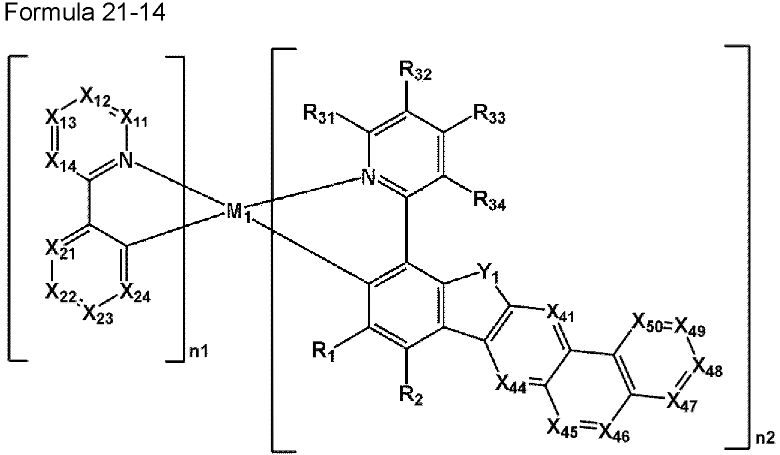 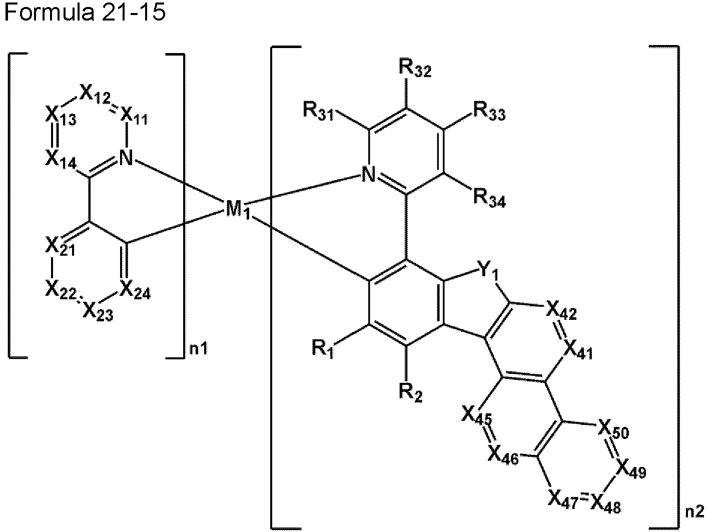 wherein, in Formulae 21-1 to 21-15,
M₁, n1, n2, R₁, R₂, R₃₁ to R₃₄, and Y₁ are each the same as described herein,
Y₄₁ and Y₄₂ may each independently be a single bond, *-O-*', *-S-*', *-Se-*', *-N(R₅₁)-*', *-C(R₅₁)(R₅₂)-*', *-Si(R₅₁)(R₅₂)-*', *-B(R₅₁)-*', *-P(R₅₁)-*', *-C(=O)-*', *-S(=O)₂-*', *-P(=O)(R₅₁)-*', *-C(R₅₁)=*', or *-N=*',
X₁₁ may be C(Z₁), C(R₁₁), or N, X₁₂ may be C(Z₁), C(R₁₂), or N, X₁₃ may be C(Z₁), C(R₁₃), or N, and X₁₄ may be C(Z₁), C(R₁₄), or N,
at least one of X₁₁ to X₁₄ may be C(Z₁), Z₁ are the same as described herein,
X₂₁ may be C(R₂₁) or N, X₂₂ may be C(R₂₂) or N, X₂₃ may be C(R₂₃) or N, and X₂₄ may be C(R₂₄) or N,
X₄₁ may be C(R₄₁) or N, X₄₂ may be C(R₄₂) or N, X₄₃ may be C(R₄₃) or N, X₄₄ may be C(R₄₄) or N, X₄₅ may be C(R₄₅) or N, X₄₆ may be C(R₄₆) or N, X₄₇ may be C(R₄₇) or N, and X₄₈ may be C(R₄₈) or N, X₄₉ may be C(R₄₉) or N, and X₅₀ may be C(R₅₀) or N,
R₁₁ to R₁₄ are each independently as described herein in connection with R₁₀,
R₂₁ to R₂₄ are each independently as described herein in connection with R₂₀,
R₄₁ to R₅₀ are each independently as described herein in connection with R₄₀,
two or more of R₁₁ to R₁₄ may optionally be linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of R₂₁ to R₂₄ may optionally be linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ, and R₁₀ₐ is as described herein in connection with R₁₀.
In Formulae 21-1 to 21-15, X₁₁ may be C(R₁₁), X₁₂ may be C(Z₁), X₁₃ may be C(R₁₃), and X₁₄ may be C(R₁₄). R₁₃ may be an unsubstituted C₁-C₆₀ (e.g., C₁-C₂₀, C₁-C₁₀, or C₁-C₆) alkyl group, or a C₁-C₆₀ (e.g., C₁-C₂₀, C₁-C₁₀, or C₁-C₆) alkyl group substituted with at least one deuterium. At least one of R₃₁ to R₃₄ (e.g. R₃₂, R₃₃, or both R₃₂ and R₃₃) may be deuterium, -CD₃, -CD₂H, -CDH₂, a C₁-C₆₀ (e.g., C₁-C₂₀, C₁-C₁₀, or C₁-C₆) alkyl group, or a C₁-C₆₀ (e.g., C₁-C₂₀, C₁-C₁₀, or C₁-C₆) alkyl group substituted with at least one deuterium.

In one or more embodiments, the organometallic compound represented by Formula 1 may be electrically neutral.

In one or more embodiments, the organometallic compound represented by Formula 1 may be at least one of Compounds 1 to 78:

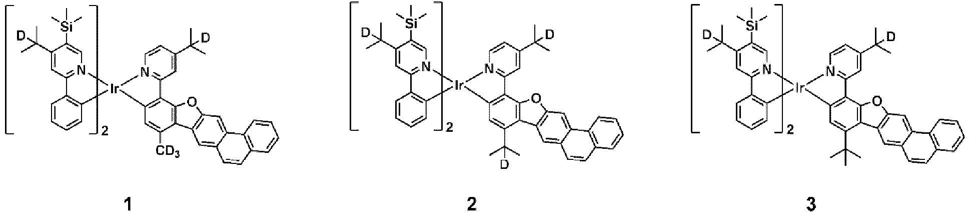

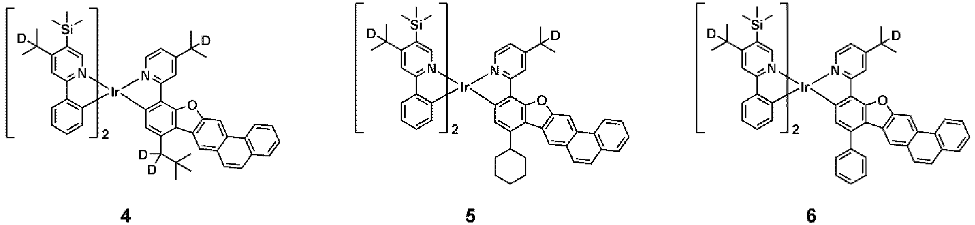

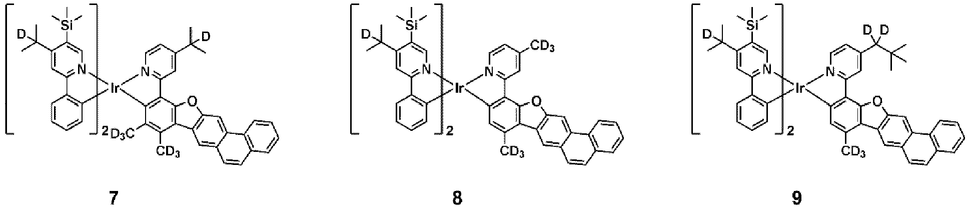

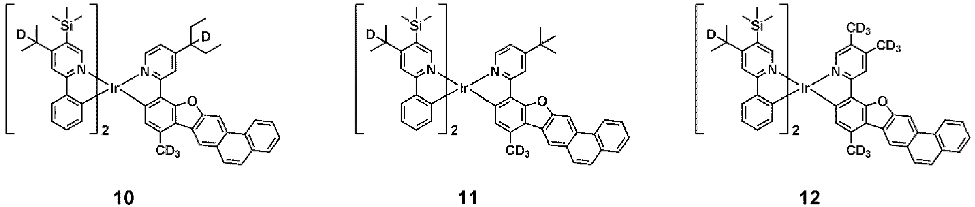

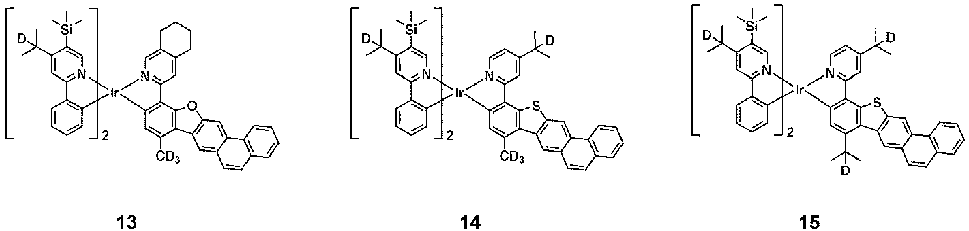

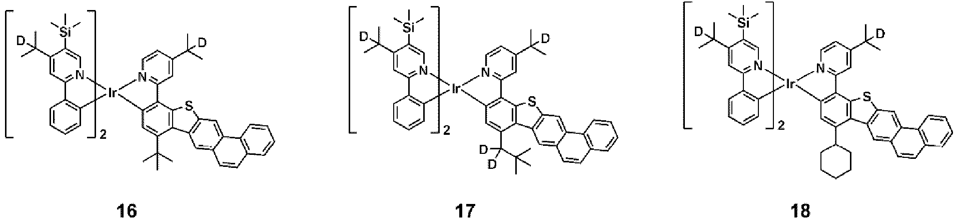

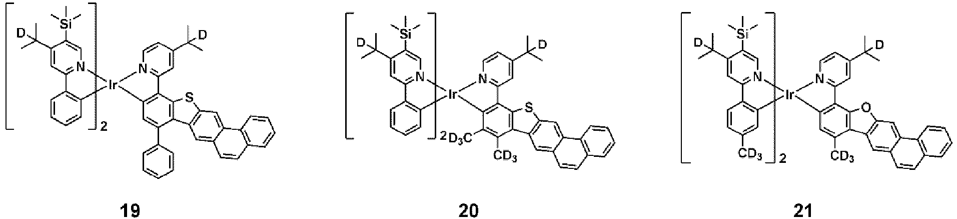

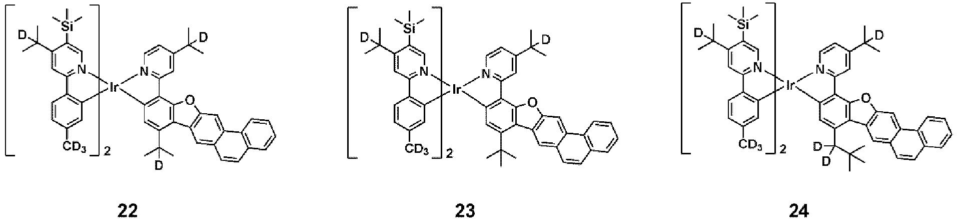

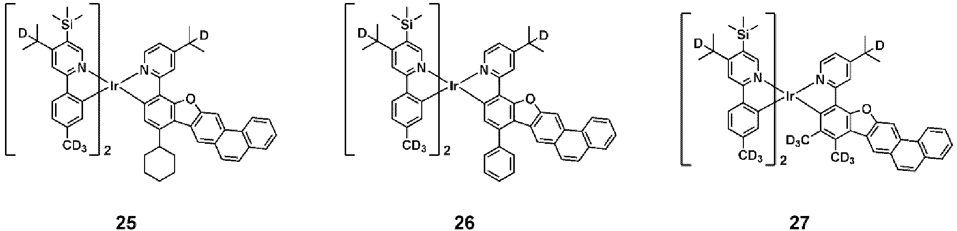

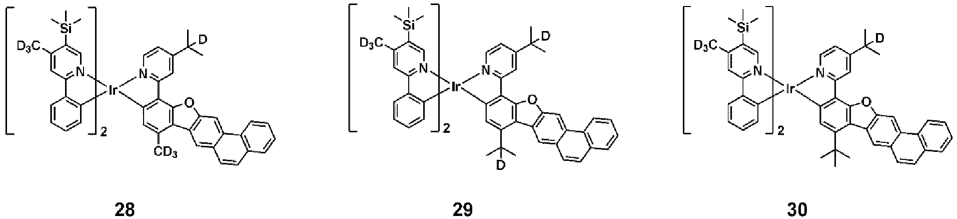

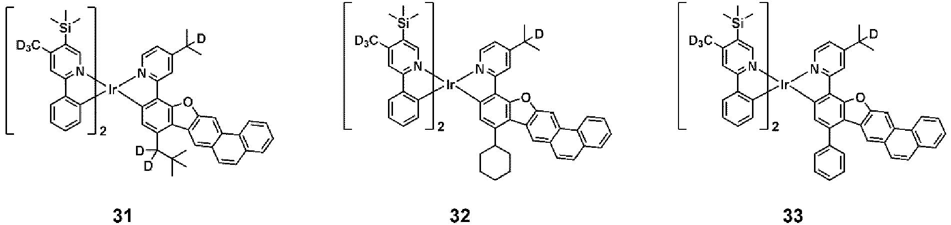

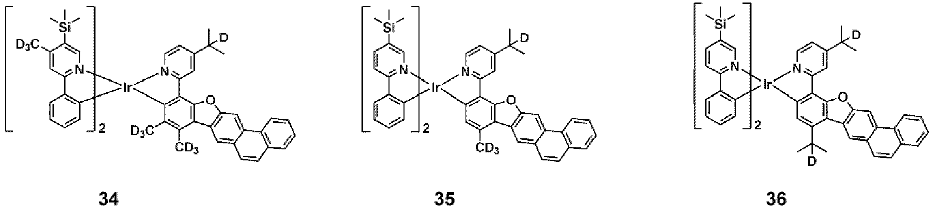

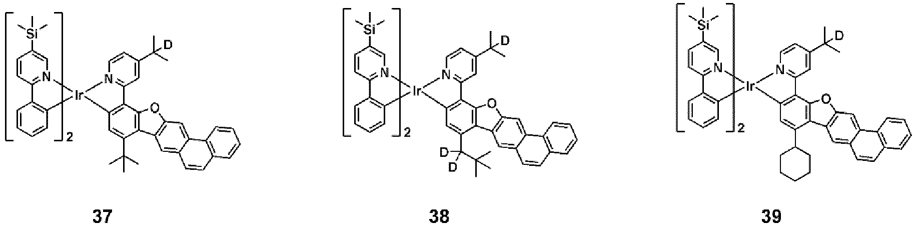

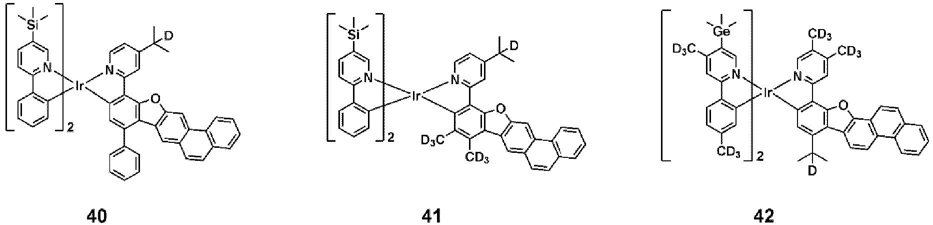

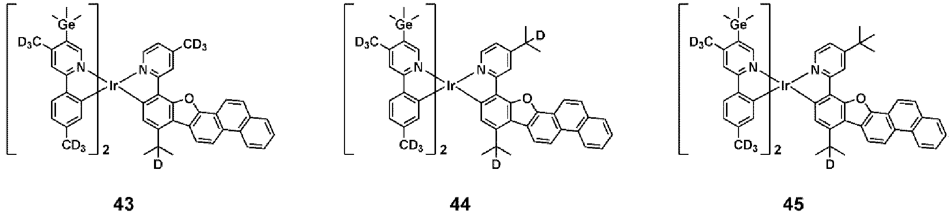

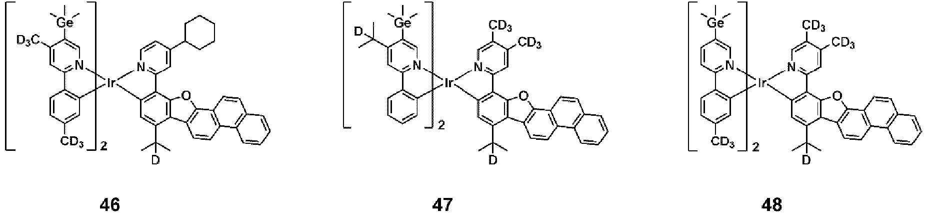

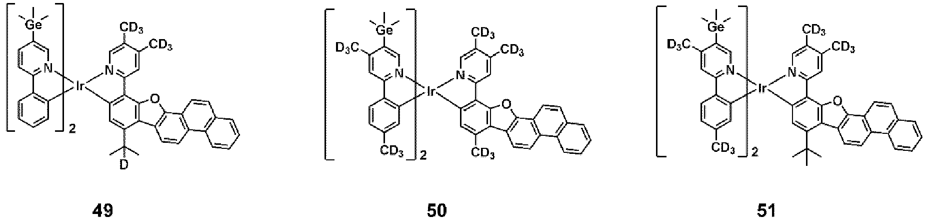

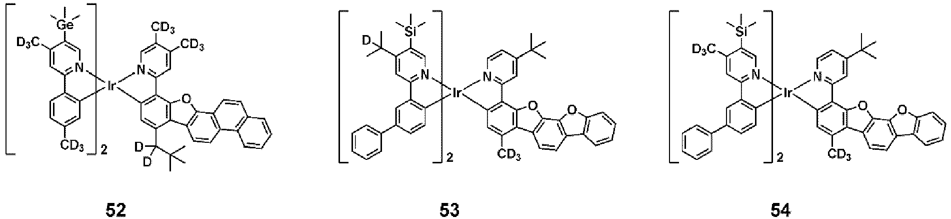

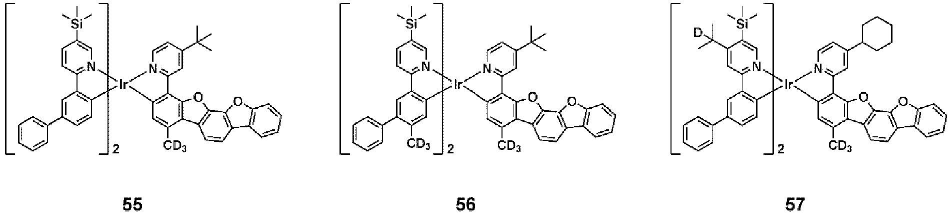

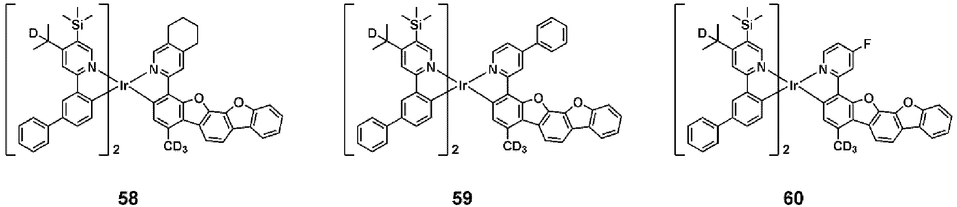

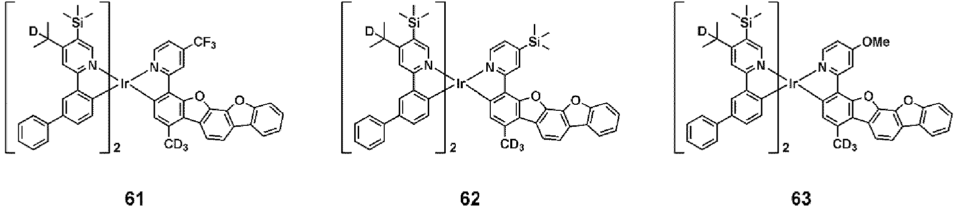

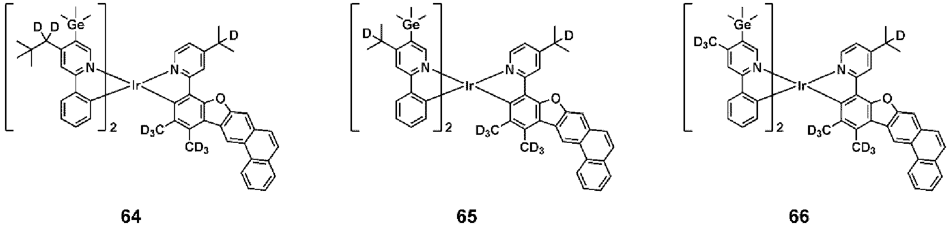

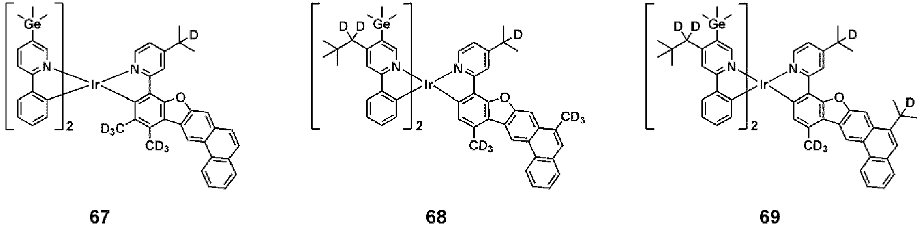

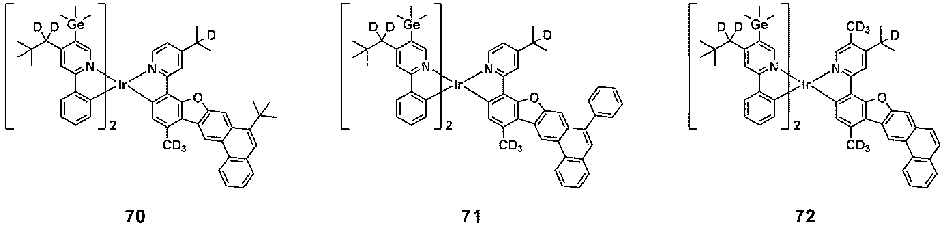

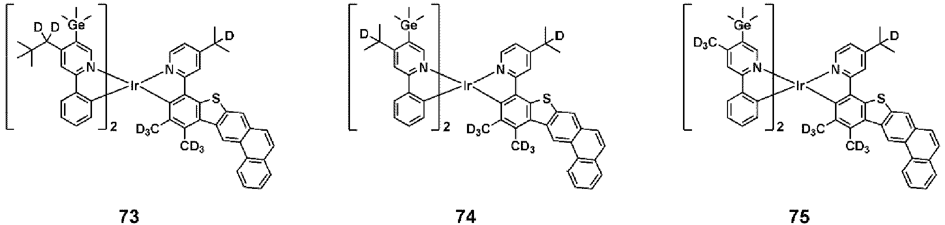

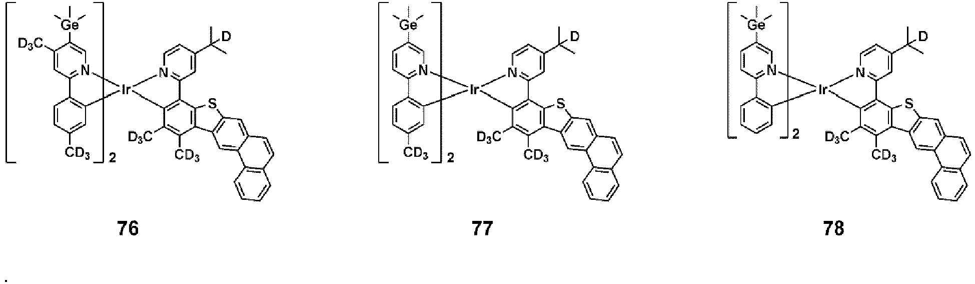

The organometallic compound represented by Formula 1 satisfies the structure of Formula 1 described herein. For example, ring CY₁ of the ligand represented by Formula 1A is substituted with at least one Z₁ which is a silyl group or a germyl group, the ligand represented by Formula 1B may include ring CY₄ which is condensed thereto, and at least one of R₁ and R₂ is a substituted or unsubstituted C₁-C₆₀ alkyl group, a substituted or unsubstituted C₃-C₁₀ cycloalkyl group, or a substituted or unsubstituted C₆-C₆₀ aryl group. By such structure, the organometallic compound represented by Formula 1 may have improved structural stability and excellent lifespan and luminescence characteristics. Moreover, by controlling an emission wavelength range, the organometallic compound represented by Formula 1 may have properties suitable for use in high-color purity luminescent materials. Although not wishing to be limited to a particular theory, for example, when at least one of R₁ and R₂ is a substituted or unsubstituted C₁-C₆₀ alkyl group, a substituted or unsubstituted C₃-C₁₀ cycloalkyl group, or a substituted or unsubstituted C₆-C₆₀ aryl group, the maximum emission wavelength of the organometallic compound represented by Formula 1 may be shortened, and an external quantum efficiency and lifespan thereof may be improved.

In addition, the organometallic compound represented by Formula 1 has excellent electrical mobility, and thus, electronic devices including at least one of the organometallic compounds represented by Formula 1, for example, organic light-emitting devices including at least one of the organometallic compounds represented by Formula 1 may show a low driving voltage, high efficiency, a long lifespan, and a reduced roll-off phenomenon.

Moreover, the photochemical stability of the organometallic compound represented by Formula 1 is improved, and thus, electronic devices including at least one of the organometallic compounds represented by Formula 1, for example, organic light-emitting devices including at least one of the organometallic compounds represented by Formula 1 may show high luminescence efficiency, long lifespan, and high color purity.

In one or more embodiments, a full width at half maximum (FWHM) of an emission peak of an emission spectrum or electroluminescence spectrum of the organometallic compound represented by Formula 1 may be about 70 nanometers (nm) or less. For example, the FWHM of the emission peak of the emission spectrum or the electroluminescence (EL) spectrum of the organometallic compound represented by Formula 1 may be about 30 nm to about 65 nm, about 40 nm to about 63 nm, or about 45 nm to about 62 nm.

In one or more embodiments, a maximum emission wavelength (emission peak maximum wavelength, λₘₐₓ) of an emission peak of an emission spectrum or electroluminescence spectrum of the organometallic compound may be about 490 nm to about 600 nm.

Synthesis methods of the organometallic compound represented by Formula 1 may be recognizable by one of ordinary skill in the art and by referring to Synthesis Examples described herein.

Accordingly, the organometallic compound represented by Formula 1 may be suitable for use as a dopant in an organic layer, for example, an emission layer, of an organic light-emitting device. Thus, another aspect provides an organic light-emitting device including a first electrode; a second electrode; and an organic layer arranged between the first electrode and the second electrode, wherein the organic layer includes an emission layer, and wherein the organic layer further includes at least one of the organometallic compounds represented by Formula 1.

As described herein, due to the inclusion of the organic layer including at least one of the organometallic compounds represented by Formula 1, the organic light-emitting device may have excellent characteristics in terms of driving voltage, current efficiency, power efficiency, external quantum efficiency, lifespan, and/or color purity. Also, such an organic light-emitting device may have a reduced roll-off phenomenon and a relatively narrow FWHM of an emission peak in an electroluminescence (EL) spectrum.

The organometallic compound represented by Formula 1 may be used between a pair of electrodes of an organic light-emitting device. For example, at least one of the organometallic compounds represented by Formula 1 may be included in the emission layer. In this regard, the organometallic compound represented by Formula 1 may act as a dopant, and the emission layer may further include a host (that is, an amount of the organometallic compound represented by Formula 1 in the emission layer is smaller than an amount of the host included in the emission layer, based on weight).

In one or more embodiments, the emission layer may emit a green light. For example, the emission layer may emit a green light having a maximum emission wavelength of about 490 nm to about 600 nm, for example, about 500 nm to about 580 nm.

The expression "(an organic layer) includes at least one of (the) organometallic compounds represented by Formula 1" as used herein may include a case in which "(an organic layer) includes identical organometallic compounds represented by Formula 1" and a case in which "(an organic layer) includes two or more different organometallic compounds represented by Formula 1."

For example, the organic layer may include, as the at least one organometallic compound represented by Formula 1, only Compound 1. In this embodiment, Compound 1 may be included in the emission layer of the organic light-emitting device. In one or more embodiments, the organic layer may include, as the at least one organometallic compound represented by Formula 1, Compound 1 and Compound 2. In this regard, Compound 1 and Compound 2 may exist in an identical layer (for example, Compound 1 and Compound 2 both may exist in an emission layer).

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

In one or more embodiments, in the organic light-emitting device, the first electrode is an anode, and the second electrode is a cathode, and the organic layer may further include a hole transport region located between the first electrode and the emission layer, and an electron transport region located between the emission layer and the second electrode, and the hole transport region may include a hole injection layer, a hole transport layer, an electron blocking layer, a buffer layer, or a combination thereof, and the electron transport region may include a hole blocking layer, an electron transport layer, an electron injection layer, or a combination thereof.

The term "organic layer" as used herein refers to a single layer and/or a plurality of layers located between the first electrode and the second electrode of the organic light-emitting device. The "organic layer" may include, in addition to an organic compound, an organometallic complex including metal.

The FIGURE is a schematic cross-sectional view of an organic light-emitting device 10 according to one or more embodiments. Hereinafter, the structure and manufacturing method of the organic light-emitting device 10 according to one or more embodiments will be described in connection with the FIGURE. The organic light-emitting device 10 includes a first electrode 11, an organic layer 15, and a second electrode 19, which are sequentially stacked in the stated order.

A substrate may be additionally disposed under the first electrode 11 or on the second electrode 19. The substrate may be a conventional substrate used in organic light-emitting devices, e.g., a glass substrate or a transparent plastic substrate, each having excellent mechanical strength, thermal stability, transparency, surface smoothness, ease of handling, and/or water repellency.

The first electrode 11 may be produced by depositing or sputtering, onto the substrate, a material for forming the first electrode 11. The first electrode 11 may be an anode. The material for forming the first electrode 11 may be selected from materials with a high work function for easy hole injection. The first electrode 11 may be a reflective electrode, a semi-transmissive electrode, or a transmissive electrode. The material for forming the first electrode 11 may be indium tin oxide (ITO), indium zinc oxide (IZO), tin oxide (SnO₂), or zinc oxide (ZnO). In one or more embodiments, the material for forming the first electrode 11 may be metal, such as magnesium (Mg), aluminum (Al), silver (Ag), aluminum-lithium (Al-Li), calcium (Ca), magnesium-indium (Mg-In), or magnesium-silver (Mg-Ag).

The first electrode 11 may have a single-layered structure or a multi-layered structure including a plurality of layers. For example, the first electrode 11 may have a three-layered structure of ITO/Ag/ITO, but the structure of the first electrode 11 is not limited thereto.

The organic layer 15 is located on the first electrode 11.

The organic layer 15 may include an emission layer, and may further includes a hole transport region and an electron transport region.

The hole transport region may be arranged between the first electrode 11 and the emission layer.

The hole transport region may include a hole injection layer, a hole transport layer, an electron blocking layer, a buffer layer, or a combination thereof.

The hole transport region may include only either a hole injection layer or a hole transport layer. In one or more embodiments, the hole transport region may have a hole injection layer/hole transport layer structure or a hole injection layer/hole transport layer/electron blocking layer structure, wherein, for each structure, respective layers are sequentially stacked in this stated order from the first electrode 11.

When the hole transport region includes a hole injection layer, the hole injection layer may be formed on the first electrode 11 by using one or more suitable methods, for example, vacuum deposition, spin coating, casting, and/or Langmuir-Blodgett (LB) deposition, but embodiments are not limited thereto.

When a hole injection layer is formed by vacuum deposition, the deposition conditions may vary according to a material that is used to form the hole injection layer, and the structure and thermal characteristics of the hole injection layer. For example, the deposition conditions may include a deposition temperature of about 100°C to about 500°C, a vacuum pressure of about 10⁻⁸ torr to about 10⁻³ torr, and a deposition rate of about 0.01 angstroms per second (Å/sec) to about 100 Å/sec. However, the deposition conditions are not limited thereto.

When the hole injection layer is formed by spin coating, the coating conditions may vary according to a material that is used to form the hole injection layer, and the structure and thermal characteristics of the hole injection layer. For example, the coating conditions may include a coating speed of about 2,000 revolutions per minute (rpm) to about 5,000 rpm and a heat treatment temperature for removing a solvent after coating of about 80°C to about 200°C. However, the coating conditions are not limited thereto.

The conditions for forming the hole transport layer and the electron blocking layer may be similar to or the same as the conditions for forming the hole injection layer.

The hole transport region may include at least one of 4,4',4"-tris(3-methylphenylphenylamino)triphenylamine (m-MTDATA), 4,4',4''-tris(N,N-diphenylamino)triphenylamine (TDATA), 4,4',4"-tris{N-(2-naphthyl)-N-phenylamino}-triphenylamine (2-TNATA), N,N'-di(1-naphthyl)-N,N'-diphenylbenzidine (NPB), β-NPB, N,N'-bis(3-methylphenyl)-N,N'-diphenyl-[1,1-biphenyl]-4,4'-diamine (TPD), Spiro-TPD, Spiro-NPB, methylated NPB, 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201, or a compound represented by Formula 202, but embodiments are not limited thereto: 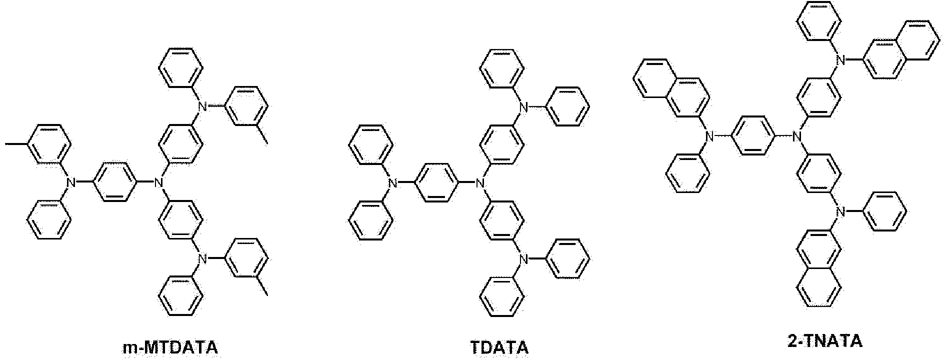 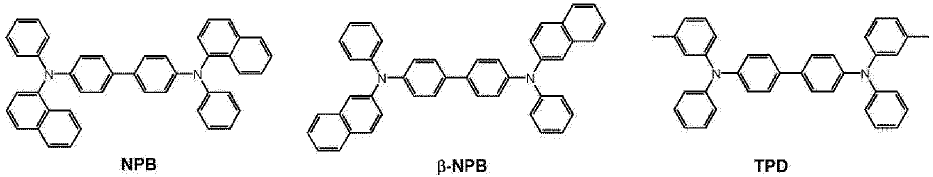 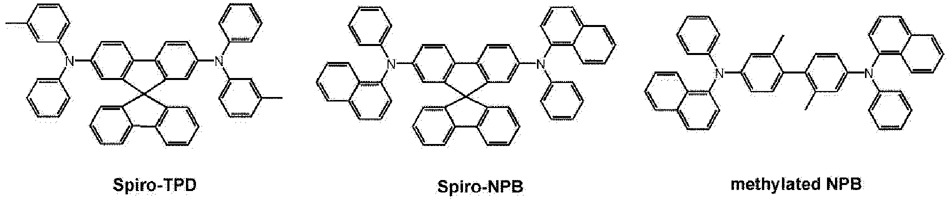 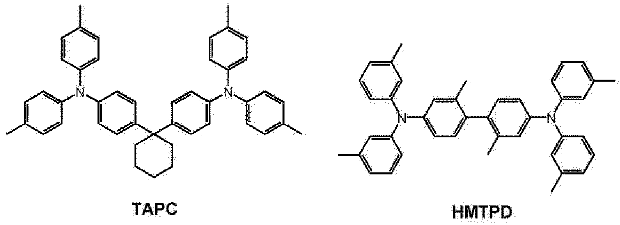 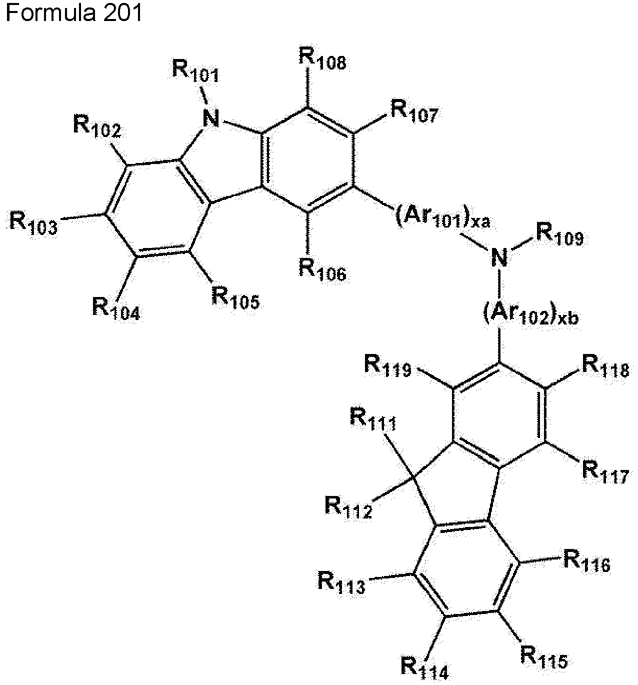 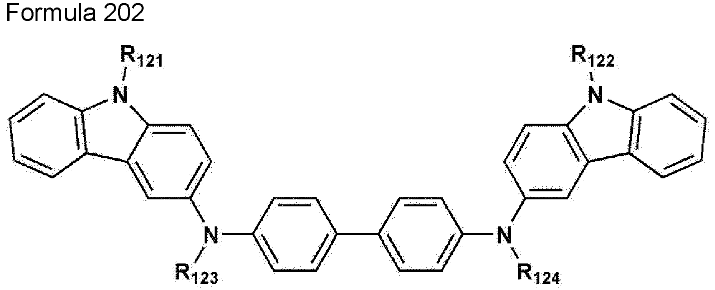 wherein, in Formula 201, Ar₁₀₁ and Ar₁₀₂ may each independently be:
a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group; or
a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each substituted with at least one of deuterium, -F, -Cl, - Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, or a combination thereof.
xa and xb in Formula 201 may each independently be an integer from 0 to 5, or 0, 1, or 2. For example, xa may be 1 and xb may be 0, but xa and xb are not limited thereto.
R₁₀₁ to R₁₀₈, R₁₁₁ to R₁₁₉ and R₁₂₁ to R₁₂₄ in Formulae 201 and 202 may each independently be:
   hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (e.g., a methyl group, an ethyl group, a propyl group, a butyl group, pentyl group, a hexyl group, or the like), a C₁-C₁₀ alkoxy group (e.g., a methoxy group, an ethoxy group, a propoxy group, a butoxy group, a pentoxy group, or the like), or a C₁-C₁₀ alkylthio group;
   a C₁-C₁₀ alkyl group, a C₁-C₁₀ alkoxy group, or a C₁-C₁₀ alkylthio group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, or a combination thereof;
   a phenyl group, a naphthyl group, an anthracenyl group, a fluorenyl group, or a pyrenyl group; or
   a phenyl group, a naphthyl group, an anthracenyl group, a fluorenyl group, or a pyrenyl group, each substituted with at least one of deuterium, -F, -Cl, -Br, - I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a C₁-C₁₀ alkoxy group, a C₁-C₁₀ alkylthio group, or a combination thereof, but embodiments are not limited thereto.

In Formula 201, R₁₀₉ may be:
a phenyl group, a naphthyl group, an anthracenyl group, or a pyridinyl group; or
a phenyl group, a naphthyl group, an anthracenyl group, or a pyridinyl group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a naphthyl group, an anthracenyl group, a pyridinyl group, or a combination thereof.

In one or more embodiments, the compound represented by Formula 201 may be represented by Formula 201A, but embodiments are not limited thereto: 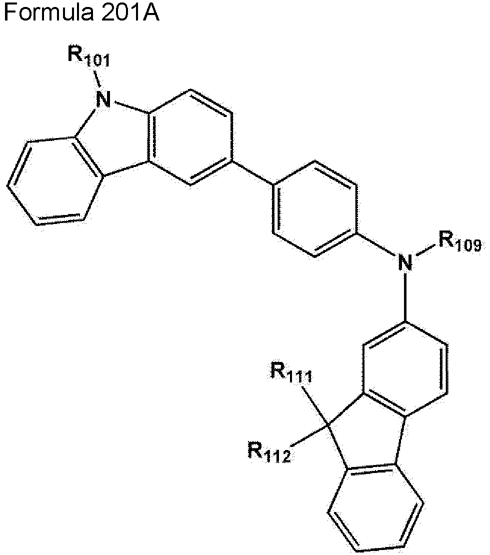 wherein, in Formula 201A, R₁₀₁, R₁₁₁, R₁₁₂, and R₁₀₉ are each as described herein.

For example, the compound represented by Formula 201 and the compound represented by Formula 202 may include one or more of Compounds HT1 to HT20, but embodiments are not limited thereto:

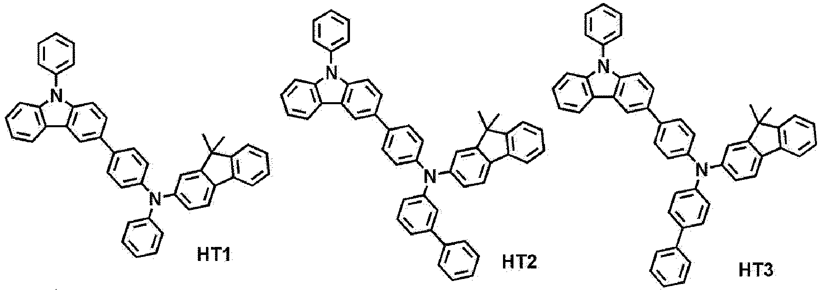

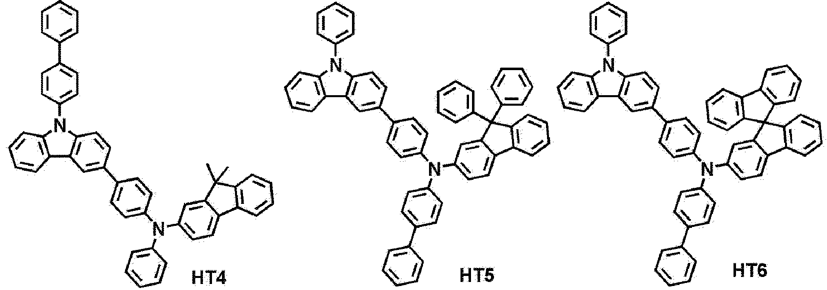

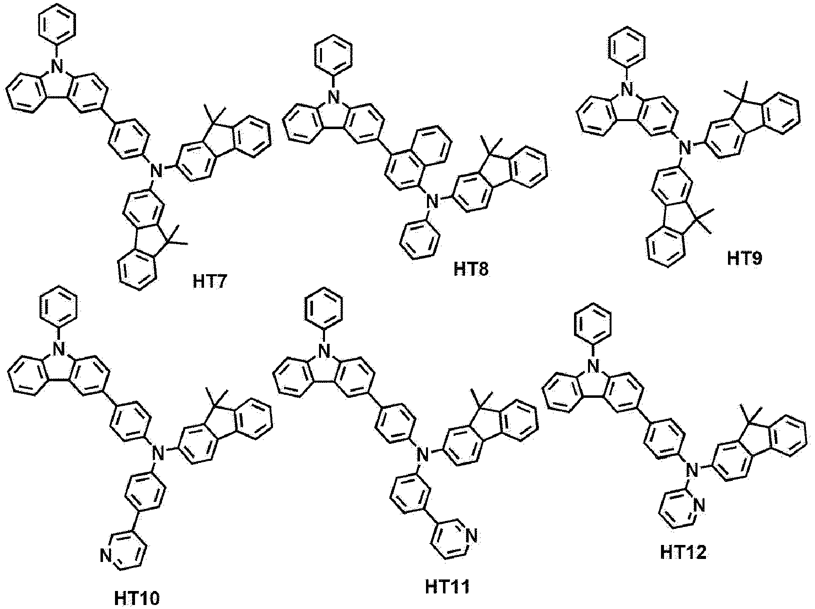

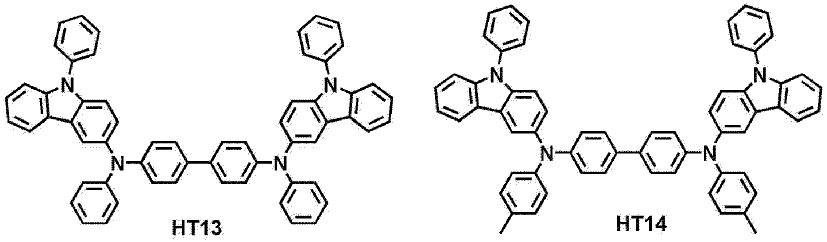

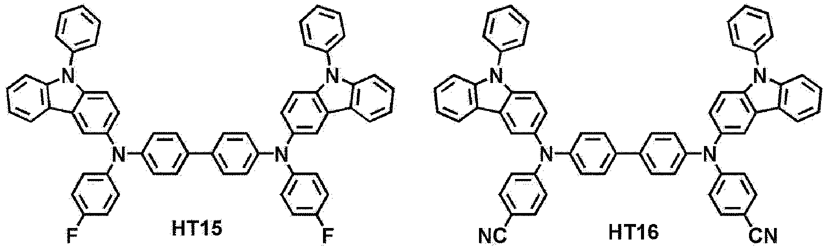

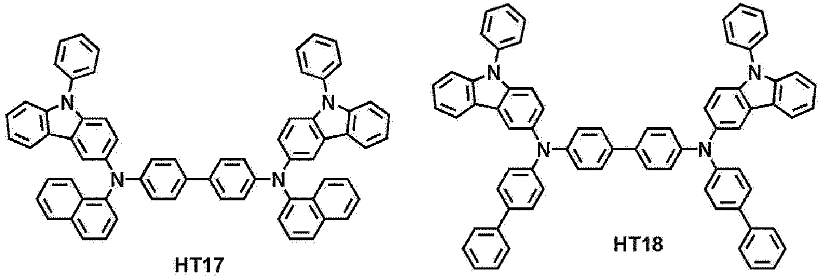

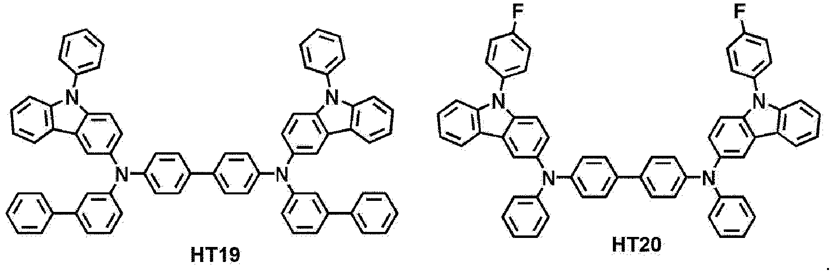

A thickness of the hole transport region may be about 100 Å to about 10,000 Å, for example, about 100 Å to about 1,000 Å. When the hole transport region includes at least one of a hole injection layer and a hole transport layer, a thickness of the hole injection layer may be about 50 Å to about 10,000 Å, for example, about 100 Å to about 1,000 Å, and a thickness of the hole transport layer may be about 50 Å to about 2,000 Å, for example, about 100 Å to about 1,500 Å. When the thicknesses of the hole transport region, the hole injection layer and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may be a quinone derivative, a metal oxide, or a cyano group-containing compound, but embodiments are not limited thereto. Non-limiting examples of the p-dopant include a quinone derivative, such as tetracyanoquinodimethane (TCNQ), 2,3,5,6-tetrafluoro-tetracyano-1,4-benzoquinonedimethane (F4-TCNQ), 1,3,4,5,7,8-hexafluorotetracyanonaphthoquinodimethane (F6-TCNNQ), or the like; a metal oxide, such as a tungsten oxide, a molybdenum oxide, or the like; or a cyano group-containing compound, such as Compound HT-D1 or F12, but embodiments are not limited thereto:

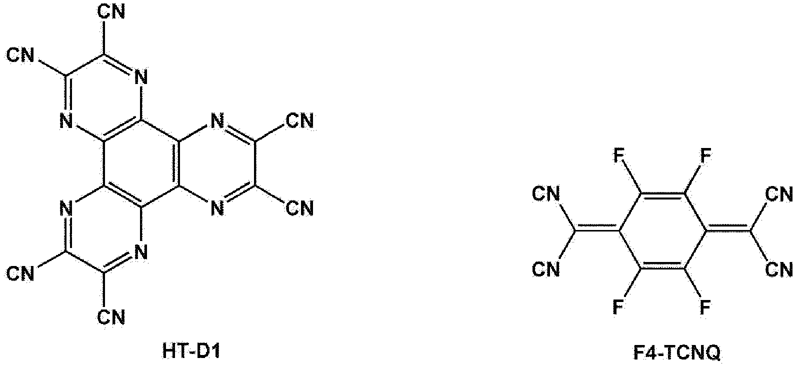

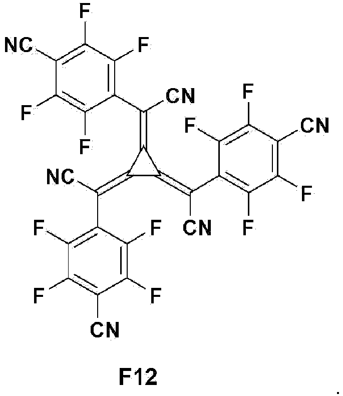

The hole transport region may further include a buffer layer.

Also, the buffer layer may compensate for an optical resonance distance according to a wavelength of light emitted from the emission layer, and thus, efficiency of a formed organic light-emitting device may be improved.

Then, an emission layer may be formed on the hole transport region by vacuum deposition, spin coating, casting, LB deposition, or the like. When the emission layer is formed by vacuum deposition or spin coating, the deposition or coating conditions may be similar to those applied in forming the hole injection layer although the deposition or coating conditions may vary according to a material that is used to form the emission layer.

Meanwhile, when the hole transport region includes an electron blocking layer, a material for the electron blocking layer may be selected from materials for the hole transport region described above and materials for a host to be explained later. However, the material for the electron blocking layer is not limited thereto. For example, when the hole transport region includes an electron blocking layer, a material for the electron blocking layer may be mCP, which will be explained later.

The emission layer may include a host and a dopant, and the dopant may include at least one of the organometallic compounds represented by Formula 1.

The host may include at least one of 1,3,5-tri(1-phenyl-1H-benzo[d]imidazol-2-yl)benzene (TPBi), 3-tert-butyl-9,10-di(naphth-2-yl)anthracene (TBADN), 9,10-di(naphthalene-2-yl)anthracene (ADN) (also referred to as "DNA"), 4,4'-bis(N-carbazolyl)-1,1'-biphenyl (CBP), 4,4'-bis(9-carbazolyl)-2,2'-dimethyl-biphenyl (CDBP), 1,3,5-tris(carbazole-9-yl)benzene (TCP), 1,3-bis(N-carbazolyl)benzene (mCP), Compound H50, or Compound H51, or Compound GH3, but embodiments are not limited thereto:

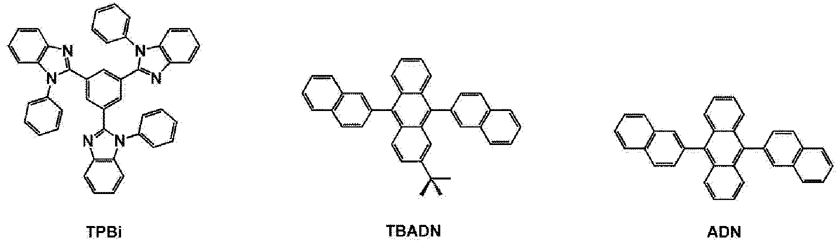

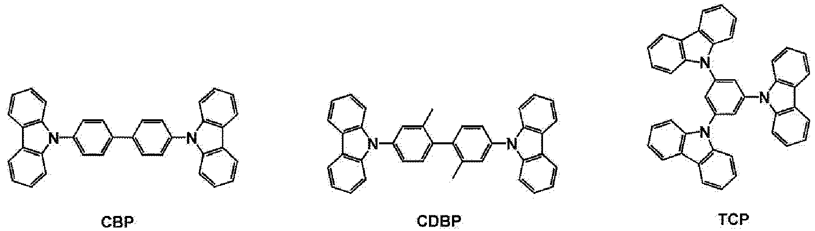

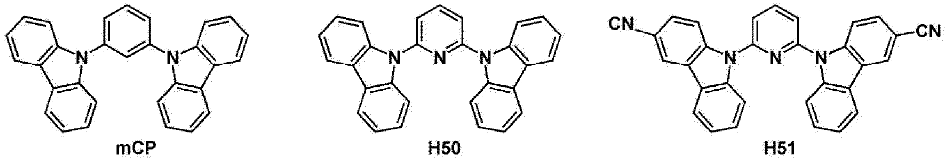

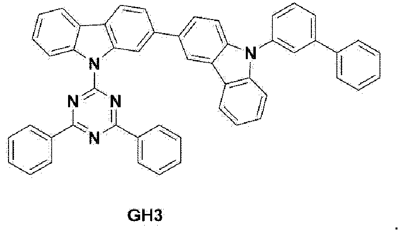

In some embodiments, the host may further include a compound represented by Formula 301: 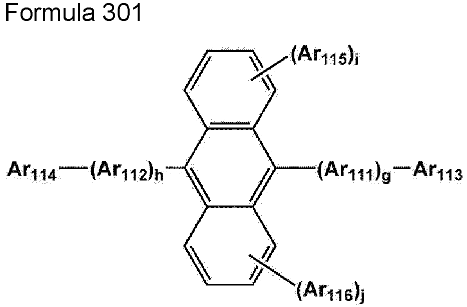
Ar₁₁₁ and Ar₁₁₂ in Formula 301 may each independently be:
   a phenylene group, a naphthylene group, a phenanthrenylene group, or a pyrenylene group; or
   a phenylene group, a naphthylene group, a phenanthrenylene group, or a pyrenylene group, each substituted with at least one of a phenyl group, a naphthyl group, an anthracenyl group, or a combination thereof.
Ar₁₁₃ to Ar₁₁₆ in Formula 301 may each independently be:
   a C₁-C₁₀ alkyl group, a phenyl group, a naphthyl group, a phenanthrenyl group, or a pyrenyl group; or
   a phenyl group, a naphthyl group, a phenanthrenyl group ,or a pyrenyl group, each substituted with at least one of a phenyl group, a naphthyl group, an anthracenyl group, or a combination thereof.
g, h, i, and j in Formula 301 may each independently be an integer from 0 to 4, and may be, for example, 0, 1, or 2.
Ar₁₁₃ to Ar₁₁₆ in Formula 301 may each independently be:
   a C₁-C₁₀ alkyl group which is substituted with at least one of a phenyl group, a naphthyl group, an anthracenyl group, or a combination thereof;
   a phenyl group, a naphthyl group, an anthracenyl group, a pyrenyl group, a phenanthrenyl group, or a fluorenyl group;
   a phenyl group, a naphthyl group, an anthracenyl group, a pyrenyl group, a phenanthrenyl group, or a fluorenyl group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a phenyl group, a naphthyl group, an anthracenyl group, a pyrenyl group, a phenanthrenyl group, a fluorenyl group, or a combination thereof; or
   a group represented by the structure:

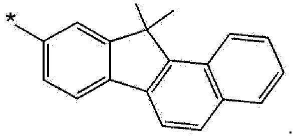

In some embodiments, the host may include a compound represented by Formula 302: 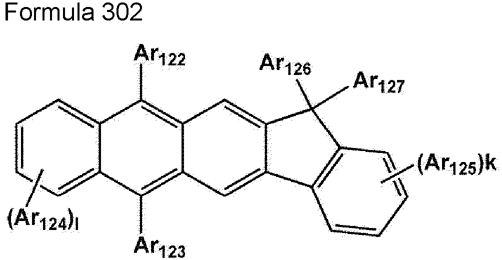 wherein, in Formula 302, Ar₁₂₂ to Ar₁₂₅ are each as described herein in connection with Ar₁₁₃ in Formula 301.

Ar₁₂₆ and Ar₁₂₇ in Formula 302 may each independently be a C₁-C₁₀ alkyl group (for example, a methyl group, an ethyl group, a propyl group, or the like).

k and l in Formula 302 may each independently be an integer from 0 to 4. For example, k and I may each independently be 0, 1, or 2.

When the organic light-emitting device 10 is a full-color organic light-emitting device, the emission layer may be patterned into a red emission layer, a green emission layer, and/or a blue emission layer. In one or more embodiments, due to a stacked structure including a red emission layer, a green emission layer, and/or a blue emission layer, the emission layer may emit white light.

When the emission layer includes a host and a dopant, an amount of the dopant may be about 0.01 part by weight to about 15 parts by weight, based on 100 parts by weight of the host, but embodiments are not limited thereto.

A thickness of the emission layer may be about 100 Å to about 1,000 Å, for example, about 200 Å to about 600 Å. When the thickness of the emission layer is within these ranges, excellent light-emission characteristics may be obtained without a substantial increase in driving voltage.

An electron transport region may be located on the emission layer.

The electron transport region may include a hole blocking layer, an electron transport layer, an electron injection layer, or a combination thereof.

For example, the electron transport region may have a hole blocking layer/electron transport layer/electron injection layer structure, or an electron transport layer/electron injection layer structure, and the structure of the electron transport region is not limited thereto. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer.

When the electron transport region includes a hole blocking layer, the hole blocking layer may include, for example, at least one of 2,9-dimethyl-4,7-diphenyl-1,10-phenanthroline (BCP), 4,7-diphenyl-1,10-phenanthroline (Bphen), or bis(2-methyl-8-quinolinolato-N1,O8)-(1,1'-biphenyl-4-olato)aluminum (BAlq), but embodiments are not limited thereto:

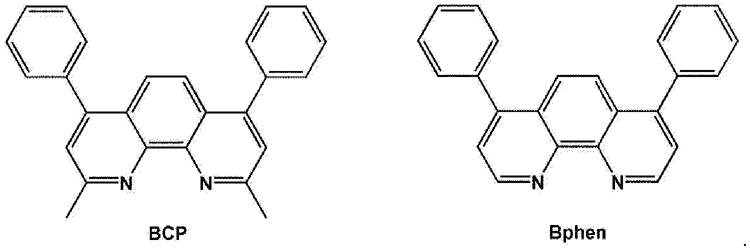

A thickness of the hole blocking layer may be about 20 Å to about 1,000 Å, for example, about 30 Å to about 300 Å. When the thickness of the hole blocking layer is within these ranges, excellent hole blocking characteristics may be obtained without a substantial increase in driving voltage.

The electron transport layer may include at least one of 2,9-dimethyl-4,7-diphenyl-1,10-phenanthroline (BCP), 4,7-diphenyl-1,10-phenanthroline (Bphen), tris(8-hydroxy-quinolinato)aluminum (Alq₃), bis(2-methyl-8-quinolinolato-N1,O8)-(1,1'-biphenyl-4-olato)aluminum (BAlq), 3-(4-biphenylyl)-4-phenyl-5-tert-butylphenyl-1,2,4-triazole (TAZ), or 4-(naphthalen-1-yl)-3,5-diphenyl-4H-1,2,4-triazole (NTAZ), but embodiments are not limited thereto:

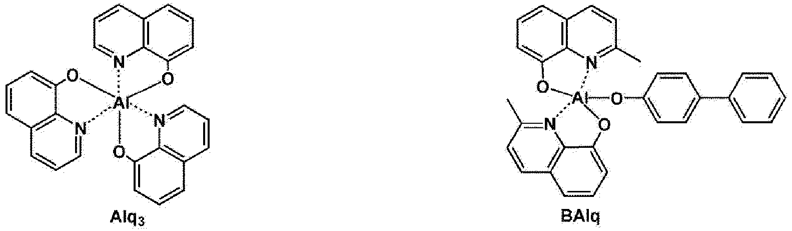

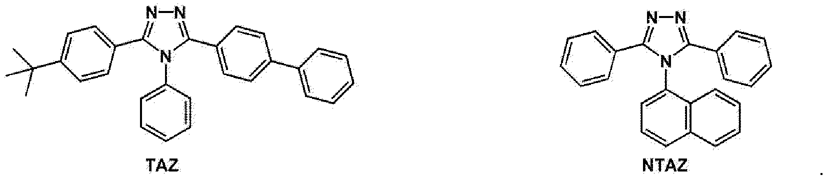

In one or more embodiments, the electron transport layer may include at least one of ET1 to ET25, but embodiments are not limited thereto:

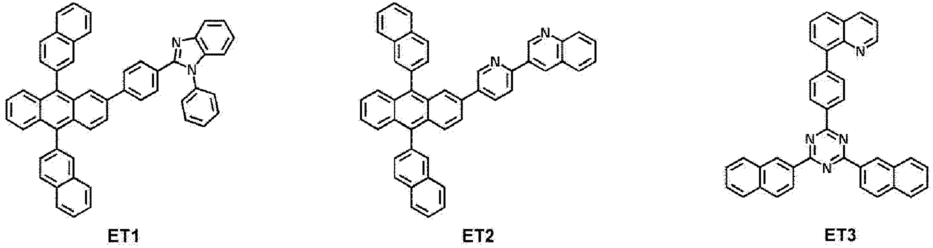

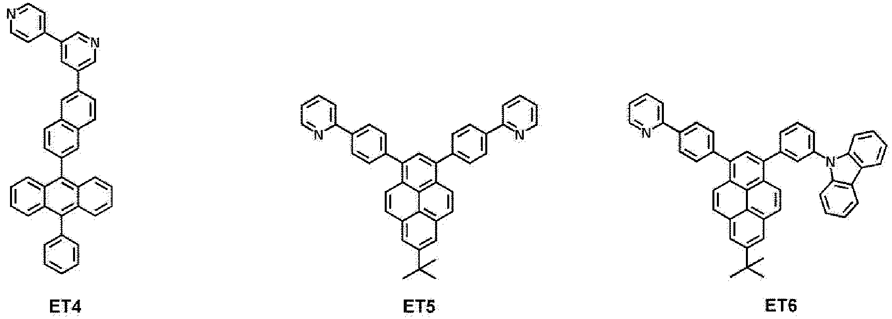

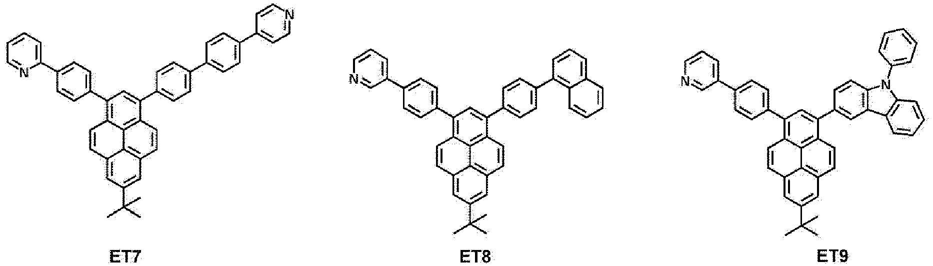

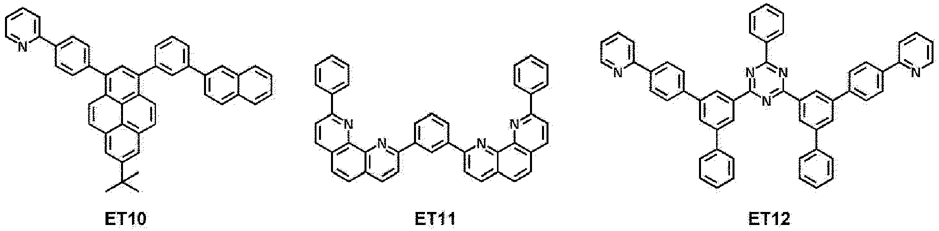

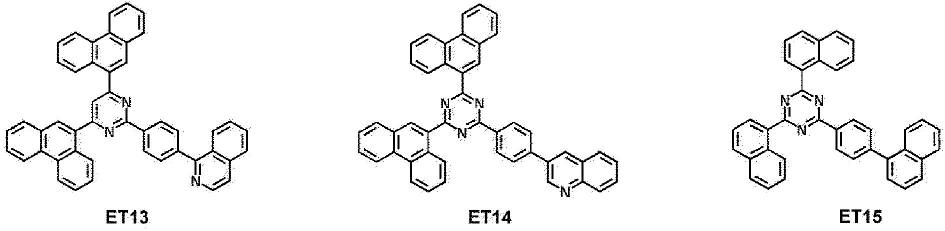

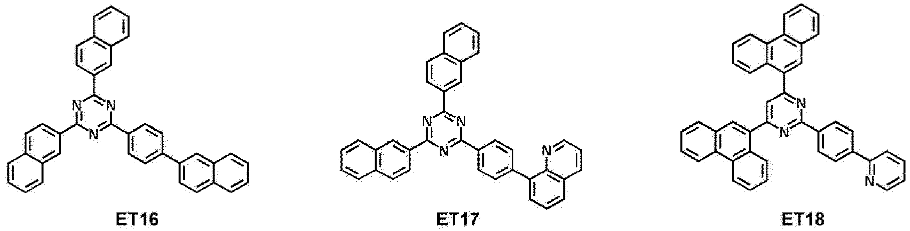

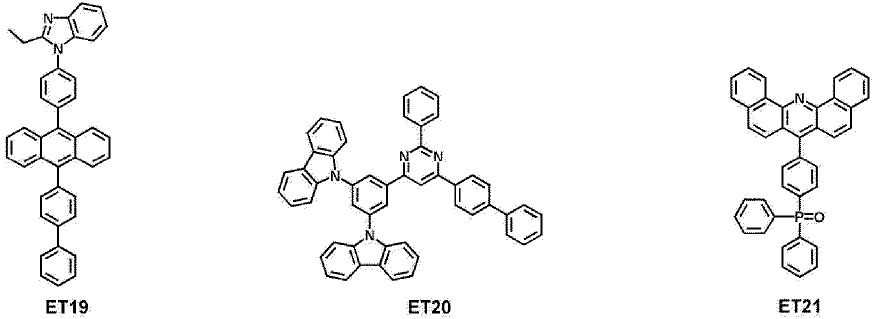

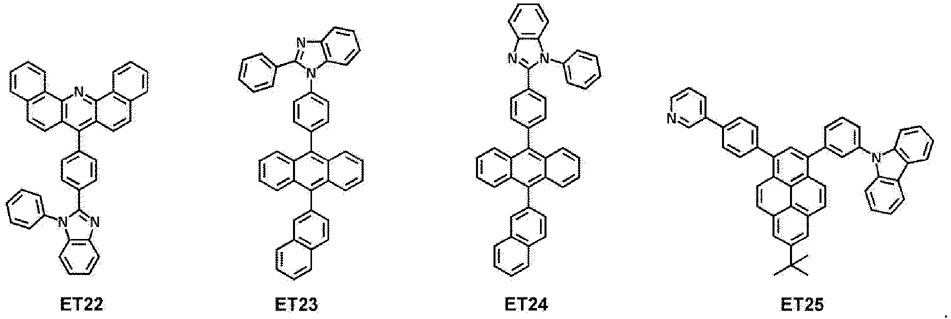

A thickness of the electron transport layer may be about 100 Å to about 1,000 Å, for example, about 150 Å to about 500 Å. When the thickness of the electron transport layer is within the range described above, the electron transport layer may have satisfactory electron transporting characteristics without a substantial increase in driving voltage.

The electron transport layer may include a metal-containing material in addition to the material as described herein.

The metal-containing material may include a Li complex. The Li complex may include, for example, Compound ET-D1 (lithium quinolate, LiQ) or ET-D2:

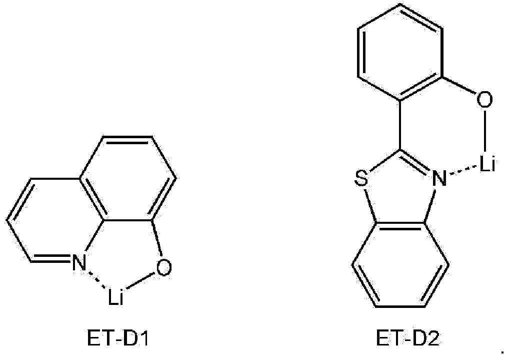

The electron transport region may include an electron injection layer that promotes the flow of electrons from the second electrode 19 thereinto.

The electron injection layer may include LiQ, LiF, NaCl, CsF, Li₂O, BaO, or a combination thereof.

A thickness of the electron injection layer may be about 1 Å to about 100 Å, or, for example, about 3 Å to about 90 Å. When the thickness of the electron injection layer is within the ranges described herein, satisfactory electron injection characteristics may be obtained without a substantial increase in driving voltage.

The second electrode 19 is located on the organic layer 15. The second electrode 19 may be a cathode. A material for forming the second electrode 19 may be metal, an alloy, an electrically conductive compound, or a combination thereof, which have a relatively low work function. For example, lithium (Li), magnesium (Mg), aluminum (Al), silver (Ag), aluminum-lithium (Al-Li), calcium (Ca), magnesium-indium (Mg-In), or magnesium-silver (Mg-Ag) may be used as the material for forming the second electrode 19. In one or more embodiments, to manufacture a top-emission type light-emitting device, a transmissive electrode formed using ITO or IZO may be used as the second electrode 19.

Hereinbefore, the organic light-emitting device has been described with reference to the FIGURE, but embodiments are not limited thereto.

Another aspect provides a diagnostic composition including at least one organometallic compound represented by Formula 1.

The organometallic compound represented by Formula 1 provides high luminescence efficiency, and accordingly, the diagnostic composition including at least one organometallic compound represented by Formula 1 may have a high diagnostic efficiency.

The diagnostic composition may be used in various applications, including a diagnosis kit, a diagnosis reagent, a biosensor, a biomarker, or the like, but embodiments are not limited thereto.

The term "C₁-C₆₀ alkyl group" as used herein refers to a linear or branched saturated aliphatic hydrocarbon monovalent group having 1 to 60 carbon atoms, and non-limiting examples thereof include a methyl group, an ethyl group, a propyl group, an isobutyl group, a sec-butyl group, a tert-butyl group, a pentyl group, an isoamyl group, a hexyl group, or the like. C₁-C₆₀ alkyl group may be C₁-C₂₀ alkyl group, C₁-C₁₀ alkyl group, C₁-C₆ alkyl group, C₁-C₅ alkyl group, or C₁-C₃ alkyl group. Each of the alkyl groups may be linear or branched. In the case of a branched alkyl group, the lower limit of the carbon number range of each of the above alkyl groups is 3. The term "C₁-C₆₀ alkylene group" as used herein refers to a divalent group having the same structure as the C₁-C₆₀ alkyl group.

The term "C₁-C₆₀ alkoxy group" as used herein refers to a monovalent group represented by -OA₁₀₁ (wherein A₁₀₁ is the C₁-C₆₀ alkyl group), and non-limiting examples thereof include a methoxy group, an ethoxy group, an isopropyloxy group, or the like. The term "C₁-C₆₀ alkylthio group" as used herein refers to a monovalent group represented by -SA_{101'} (wherein A_{101'} is the C₁-C₆₀ alkyl group).

The term "C₂-C₆₀ alkenyl group" as used herein refers to a hydrocarbon group formed by substituting at least one carbon-carbon double bond in the middle or at the terminus of the C₂-C₆₀ alkyl group, and non-limiting examples thereof include an ethenyl group, a propenyl group, a butenyl group, or the like. The term "C₂-C₆₀ alkenylene group" as used herein refers to a divalent group having the same structure as the C₂-C₆₀ alkenyl group.

The term "C₂-C₆₀ alkynyl group" as used herein refers to a hydrocarbon group formed by substituting at least one carbon-carbon triple bond in the middle or at the terminus of the C₂-C₆₀ alkyl group, and non-limiting examples thereof include an ethynyl group, a propynyl group, or the like. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon cyclic group having 3 to 10 carbon atoms, and non-limiting examples thereof include a cyclopropyl group, a cyclobutyl group, a cyclopentyl group, a cyclohexyl group, a cycloheptyl group, or the like. The term "C₃-C₁₀ cycloalkylene group" as used herein refers to a divalent group having the same structure as the C₃-C₁₀ cycloalkyl group.

The term "C₁-C₁₀ heterocycloalkyl group" as used herein refers to a monovalent saturated cyclic group having at least one heteroatom selected from B, N, O, P, Si, S, Se, or Ge as a ring-forming atom and 1 to 10 carbon atoms as ring-forming atom(s), and non-limiting examples thereof include a tetrahydrofuranyl group, a tetrahydrothiophenyl group, or the like. The term "C₁-C₁₀ heterocycloalkylene group" as used herein refers to a divalent group having the same structure as the C₁-C₁₀ heterocycloalkyl group.

The term "C₃-C₁₀ cycloalkenyl group" as used herein refers to a monovalent cyclic group that has 3 to 10 carbon atoms and at least one carbon-carbon double bond in the ring thereof and no aromaticity, and non-limiting examples thereof include a cyclopentenyl group, a cyclohexenyl group, a cycloheptenyl group, or the like. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent cyclic group that has at least one heteroatom selected from B, N, O, P, Si, S, Se, or Ge as a ring-forming atom, 2 to 10 carbon atoms as ring-forming atom(s), and at least one double bond in its ring. Non-limiting examples of the C₁-C₁₀ heterocycloalkenyl group include a 2,3-dihydrofuranyl group, a 2,3-dihydrothiophenyl group, or the like. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic ring system having 6 to 60 carbon atoms, and the term "C₆-C₆₀ arylene group" as used herein refers to a divalent group having a carbocyclic aromatic ring system having 6 to 60 carbon atoms. Non-limiting examples of the C₆-C₆₀ aryl group include a phenyl group, a naphthyl group, an anthracenyl group, a phenanthrenyl group, a pyrenyl group, a chrysenyl group, or the like. When the C₆-C₆₀ aryl group and the C₆-C₆₀ arylene group each include two or more rings, the rings may be fused to each other.

The term "C₇-C₆₀ alkyl aryl group" as used herein refers to a C₆-C₆₀ aryl group substituted with at least one C₁-C₆₀ alkyl group. The term "C₇-C₆₀ aryl alkyl group" as used herein refers to a C₁-C₆₀ alkyl group substituted with at least one C₆-C₆₀ aryl group.

The term "C₁-C₆₀ heteroaryl group" as used herein refers to a monovalent group having a heteroaromatic ring system that has at least one heteroatom selected from B, **N,** O, P, Si, S, Se, or Ge as a ring-forming atom, and 1 to 60 carbon atoms as ring-forming atom(s). The term "C₁-C₆₀ heteroarylene group" as used herein refers to a divalent group having a heteroaromatic ring system that has at least one heteroatom selected from B, **N,** O, P, Si, S, Se, or Ge as a ring-forming atom, and 1 to 60 carbon atoms as ring-forming atom(s). Non-limiting examples of the C₁-C₆₀ heteroaryl group include a pyridinyl group, a pyrimidinyl group, a pyrazinyl group, a pyridazinyl group, a triazinyl group, a quinolinyl group, an isoquinolinyl group, or the like. When the C₁-C₆₀ heteroaryl group and the C₁-C₆₀ heteroarylene group each include two or more rings, the rings may be fused to each other.

The term "C₂-C₆₀ alkyl heteroaryl group" as used herein refers to a C₁-C₆₀ heteroaryl group substituted with at least one C₁-C₆₀ alkyl group. The term "C₂-C₆₀ heteroaryl alkyl group" as used herein refers to a C₁-C₆₀ alkyl group substituted with at least one C₁-C₆₀ heteroaryl group.

The term "C₆-C₆₀ aryloxy group" as used herein indicates -OA₁₀₂ (wherein A₁₀₂ is a C₆-C₆₀ aryl group), and the term "C₆-C₆₀ arylthio group" as used herein indicates -SA₁₀₃ (wherein A₁₀₃ is a C₆-C₆₀ aryl group).

The term "C₁-C₆₀ heteroaryloxy group" as used herein refers to -OA₁₀₄ (wherein A₁₀₄ is the C₁-C₆₀ heteroaryl group), and the term "C₁-C₆₀ heteroarylthio group" as used herein refers to -SA₁₀₅ (wherein A₁₀₅ is the C₁-C₆₀ heteroaryl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Non-limiting examples of the monovalent non-aromatic condensed polycyclic group include a fluorenyl group or the like. The term "divalent non-aromatic condensed polycyclic group" as used herein refers to a divalent group having the same structure as the monovalent non-aromatic condensed polycyclic group described above.

The term "monovalent non-aromatic condensed heteropolycyclic group" as used herein refers to a monovalent group (for example, having 1 to 60 carbon atoms) having two or more rings condensed with each other, a heteroatom selected from B, **N,** O, P, Si, S, Se, or Ge, other than carbon atoms, as a ring-forming atom, and no aromaticity in its entire molecular structure. Non-limiting examples of the monovalent non-aromatic condensed heteropolycyclic group include a carbazolyl group or the like. The term "divalent non-aromatic condensed heteropolycyclic group" as used herein refers to a divalent group having the same structure as the monovalent non-aromatic condensed heteropolycyclic group described above.

The term "C₅-C₃₀ carbocyclic group" as used herein refers to a saturated or unsaturated ring group having, as a ring-forming atom, 5 to 30 carbon atoms only. The C₅-C₃₀ carbocyclic group may be a monocyclic group or a polycyclic group.

The term "C₁-C₃₀ heterocyclic group" as used herein refers to a saturated or unsaturated ring group having, as a ring-forming atom, at least one heteroatom selected from B, **N,** O, Si, P, S, Se, or Ge, other than 1 to 30 carbon atoms as ring-forming atom(s). The C₁-C₃₀ heterocyclic group may be a monocyclic group or a polycyclic group.

In the specification, TMS represents * -Si(CH₃)₃, and TMG represents * -Ge(CH₃)₃.

At least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group may be:
deuterium, -F, -Cl, -Br, -I, -SFs, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₁₁)(Q₁₂)(Q₁₃), -Ge(Q₁₁)(Q₁₂)(Q₁₃), -N(Q₁₄)(Q₁₅), -B(Q₁₆)(Q₁₇), -P(Q₁₈)(Q₁₉), -P(=O)(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each substituted with at least one of deuterium, -F, -Cl, -Br, -I, -SF₅, -CD₃, -CD₂H, - CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₂₁)(Q₂₂)(Q₂₃), - Ge(Q₂₁)(Q₂₂)(Q₂₃), -N(Q₂₄)(Q₂₅), -B(Q₂₆)(Q₂₇), -P(Q₂₈)(Q₂₉), -P(=O)(Q₂₈)(Q₂₉), or a combination thereof; or
-Si(Q₃₁)(Q₃₂)(Q₃₃), -Ge(Q₃₁)(Q₃₂)(Q₃₃), -N(Q₃₄)(Q₃₅), -B(Q₃₆)(Q₃₇), - P(Q₃₈)(Q₃₉), or -P(=O)(Q₃₈)(Q₃₉), and
Q₁ to Q₉, Q₁₁ to Q₁₉, Q₂₁ to Q₂₉, and Q₃₁ to Q₃₉ may each independently be hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a C₁-C₆₀ heteroaryloxy group, a C₁-C₆₀ heteroarylthio group, a substituted or unsubstituted monovalent non-aromatic condensed polycyclic group, or a substituted or unsubstituted monovalent non-aromatic condensed heteropolycyclic group.

Hereinafter, a compound and an organic light-emitting device according to exemplary embodiments are described in further detail with reference to Synthesis Examples and Examples. However, the organic light-emitting devices are not limited thereto. The wording ‴B' was used instead of 'A‴ used in describing Synthesis Examples means that an amount of 'A' used was identical to an amount of 'B' used, in terms of a molar equivalent.

### EXAMPLES

### Synthesis Example 1: Synthesis of Compound 1

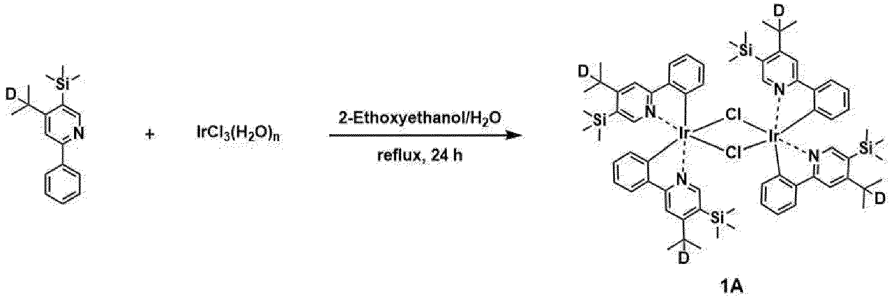

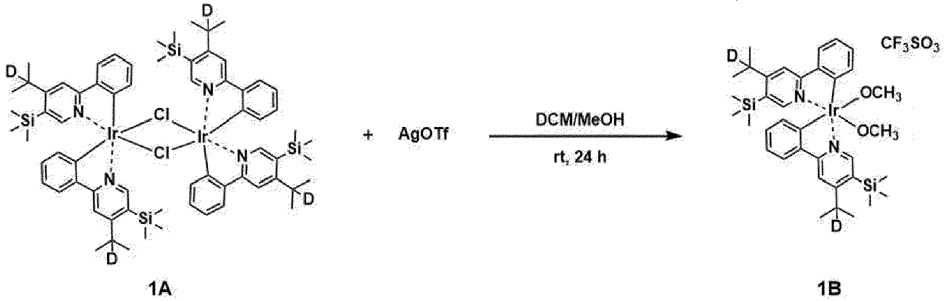

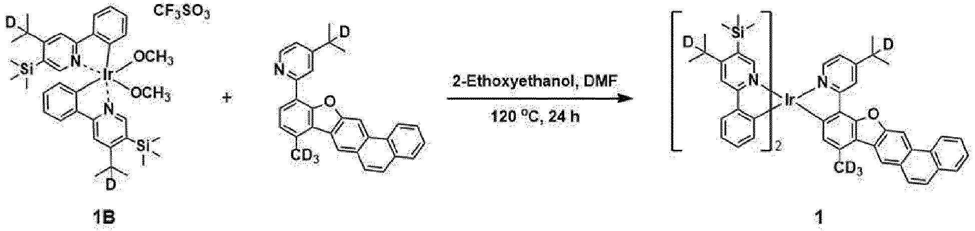

### (1) Synthesis of Compound 1A

2-phenyl-4-(propan-2-yl-2-d)-5-(trimethylsilyl)pyridine (3.00 grams (g), 11.09 millimoles (mmol)) and iridium chloride hydrate (1.88 g, 5.32 mmol) were mixed with 21 milliliters (mL) of 2-ethoxyethanol and 7 mL of deionized (DI) water. The mixture was stirred and heated under reflux for 24 hours, and then the temperature was lowered to room temperature. The resulting solid was separated by filtration, washed sufficiently with water, methanol, and hexane, in this stated order, and then dried in a vacuum oven to obtain 3.27 g (yield of 80%) of Compound 1A.

### (2) Synthesis of Compound 1B

Compound 1A (3.27 g, 2.13 mmol) was mixed with 75 mL of dichloromethane in a first flask. In a second flask, a mixture of silver trifluoromethanesulfonate (AgOTf) (1.15 g, 4.48 mmol) and 25 mL of methanol was prepared. The contents of the second flask were then added to the first flask. Thereafter, the resulting reaction mixture was stirred for 24 hours at room temperature while light was blocked with aluminum foil, and then filtered through Celite to remove the resulting solid. The solvent was removed from the filtrate under a reduced pressure to obtain a solid (Compound 1B). Compound 1B was used in the next reaction step without an additional purification process.

### (3) Synthesis of compound 1

Compound 1B (3.22 g, 3.41 mmol) and 2-(8-(methyl-d3)phenanthro[3,2-b]benzofuran-11-yl)-4-(propan-2-yl-2-d)pyridine (1.38 g, 3.41 mmol) were mixed with 35 mL of 2-ethoxyethanol and 35 mL of dimethylformamide. The mixture was stirred at 120°C for 24 hours, and then the temperature was lowered to room temperature. The solvent was removed under a reduced pressure to obtain a solid, and then the product was purified by column chromatography (eluents: hexane and ethyl acetate) to obtain Compound 1 (0.97 g, yield: 25%). The obtained compound was identified by high resolution mass spectrometry using matrix assisted laser desorption ionization (HRMS (MALDI)) and high-performance liquid chromatography (HPLC) analysis.

HRMS (MALDI) calculated for C₆₃H₆₀D₆IrN₃OSi₂: m/z 1135.4750; found: 1135.4749.

### Synthesis Example 2: Synthesis of Compound 42

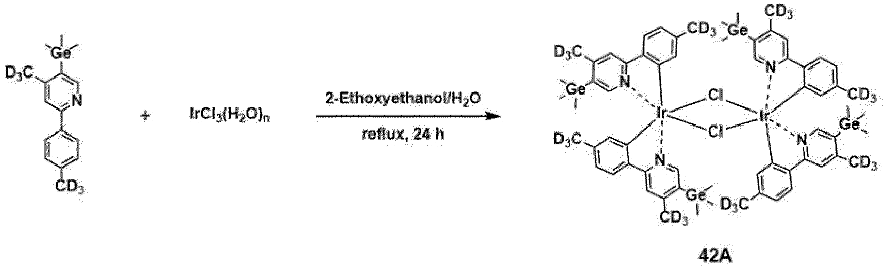

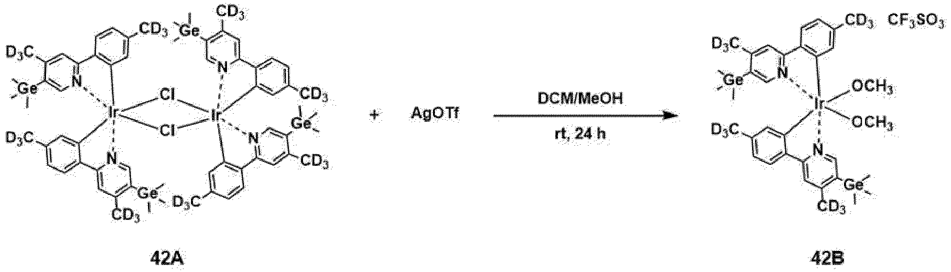

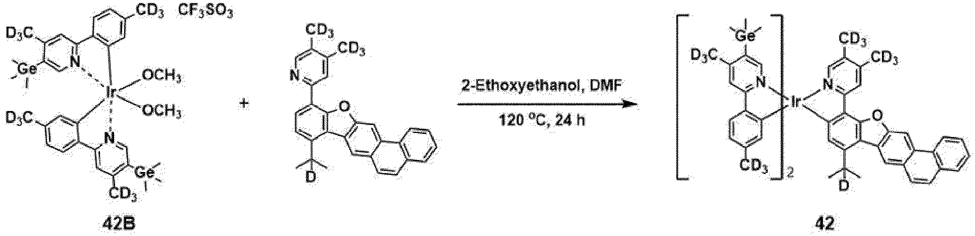

### (1) Synthesis of Compound 42A

4-(methyl-d3)-2-(4-(methyl-d3)phenyl)-5-(trimethylgermyl)pyridine (5.00 g, 16.34 mmol) and iridium chloride hydrate (2.77 g, 7.84 mmol) were mixed with 30 mL of 2-ethoxyethanol and 10 mL of DI water. The mixture was stirred and heated under reflux for 24 hours, and then the temperature was lowered to room temperature. The resulting solid was separated by filtration, washed sufficiently with water, methanol, and hexane, in this stated order, and then dried in a vacuum oven to obtain 4.90 g (yield of 75%) of Compound 42A.

### (2) Synthesis of Compound 42B

In a first flask, Compound 42A (4.90 g, 2.92 mmol) was mixed with 105 mL of dichloromethane. In a second flask, a mixture of AgOTf (1.58 g, 6.14 mmol) and 35 mL of methanol was prepared. The second flask was then added to the first flask. Thereafter, the resulting reaction mixture was stirred for 24 hours at room temperature while light was blocked with aluminum foil. The reaction mixture was filtered through Celite to remove the resulting solid, and the solvent was removed from the filtrate under a reduced pressure to obtain a solid (Compound 42B). Compound 42B was used in the next reaction step without an additional purification process.

### (3) Synthesis of Compound 42

Compound 42B (4.75 g, 4.69 mmol) and 4,5-bis(methyl-d3)-2-(9-(propan-2-yl-2-d)phenanthro[1,2-b]benzofuran-12-yl)pyridine (1.98 g, 4.69 mmol) were mixed with 47 mL of 2-ethoxyethanol and 47 mL of dimethylformamide. The mixture was stirred at 120°C for 24 hours, and then the temperature was lowered to room temperature. The solvent was removed under a reduced pressure to obtain a solid, and then the product was purified by column chromatography (eluents: hexane and ethyl acetate) to obtain Compound 42 (1.26 g, yield: 22%). The obtained compound was identified by HRMS (MALDI) and HPLC analysis.

HRMS (MALDI) calculated for C₆₂H₄₅D₁₉Ge₂IrN₃O: m/z 1226.4295; found: 1226.4297.

### Synthesis Example 3: Synthesis of Compound 53

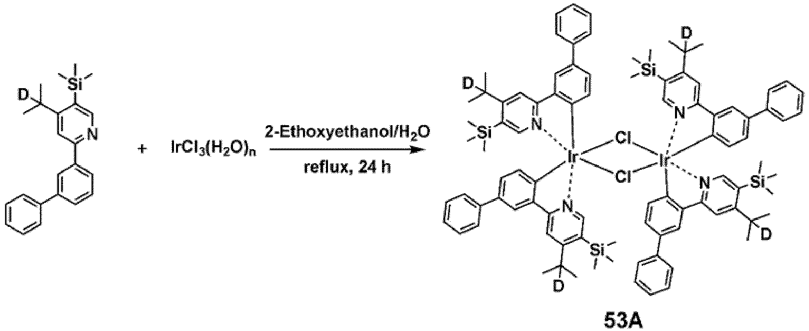

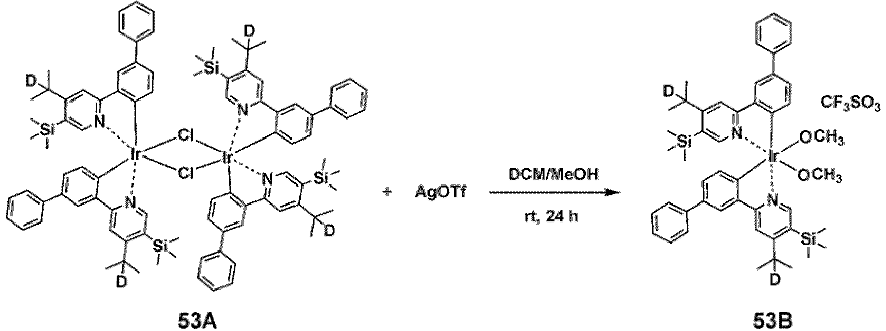

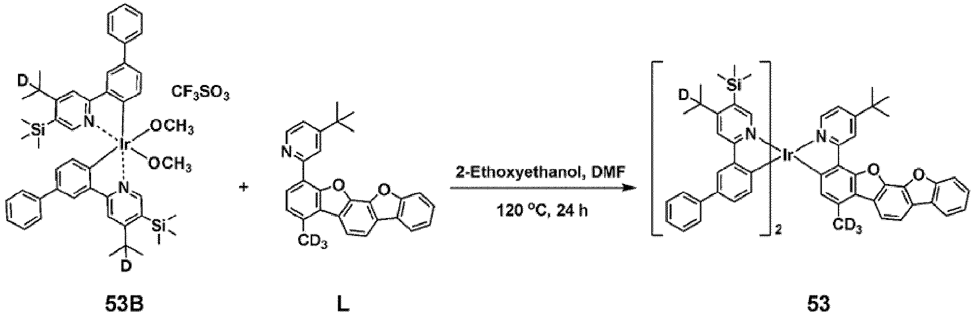

### (1) Synthesis of Compound 53A

2-([1,1'-biphenyl]-3-yl)-4-(propan-2-yl-2-d)-5-(trimethylsilyl)pyridine (5.00 g, 14.43 mmol) and iridium chloride hydrate (2.44 g, 6.93 mmol) were mixed with 27 mL of 2-ethoxyethanol and 9 mL of DI water. The mixture was stirred under reflux for 24 hours, and then the temperature was lowered to room temperature. The resulting solid was separated by filtration, washed sufficiently with water, methanol, and hexane, in this stated order, and then dried in a vacuum oven to obtain 5.41 g (yield of 86%) of Compound 53A.

### (2) Synthesis of Compound 53B

In a first flask, Compound 53A (5.41 g, 2.94 mmol) was mixed with 120 mL of dichloromethane. In a second flask, a mixture of AgOTf (1.59 g, 6.18 mmol) and 40 mL of methanol was prepared. Then, the second flask was added to the first flask. Thereafter, the resulting reaction mixture was stirred for 24 hours at room temperature while light was blocked with aluminum foil. The product was then filtered through Celite to remove the resulting solid, and the solvent was removed from the filtrate under a reduced pressure to obtain a solid (Compound 53B). Compound 53B was used in the next reaction without an additional purification process.

### (3) Synthesis of Compound 53

Compound 53B (5.48 g, 5.00 mmol) and Compound L (2.04 g, 5.00 mmol) were mixed with 50 mL of 2-ethoxyethanol and 50 mL of dimethylformamide. The mixture was stirred at 120°C for 24 hours, and then the temperature was lowered to room temperature. The solvent was removed under a reduced pressure to obtain a solid, and then the product was purified by column chromatography (eluents: hexane and ethyl acetate) to obtain Compound 53 (1.10 g, yield: 17%). The obtained compound was identified by HRMS (MALDI) and HPLC analysis.

HRMS (MALDI) calculated for C₇₄H₆₉D₅IrN₃O₂Si₂: m/z 1290.5263; found: 1290.5262.

### Synthesis Example 4: Synthesis of Compound 64

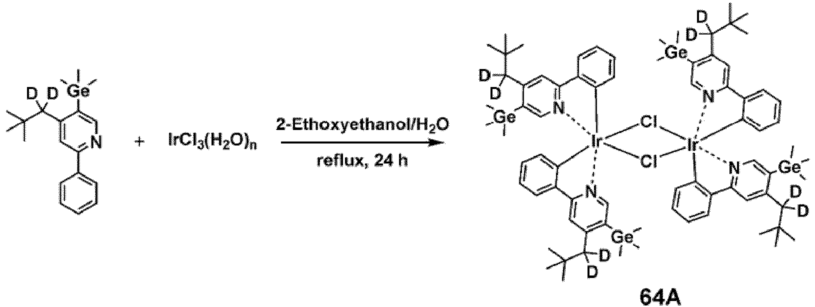

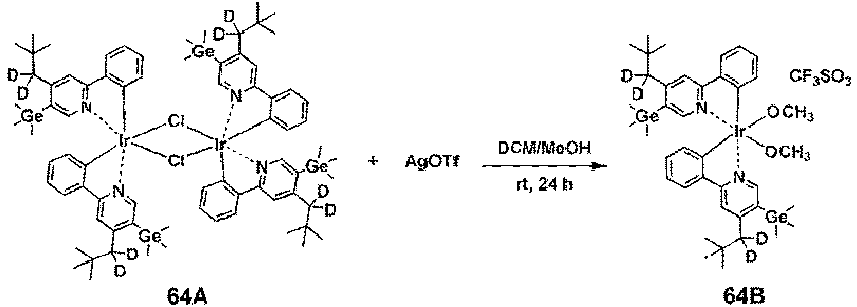

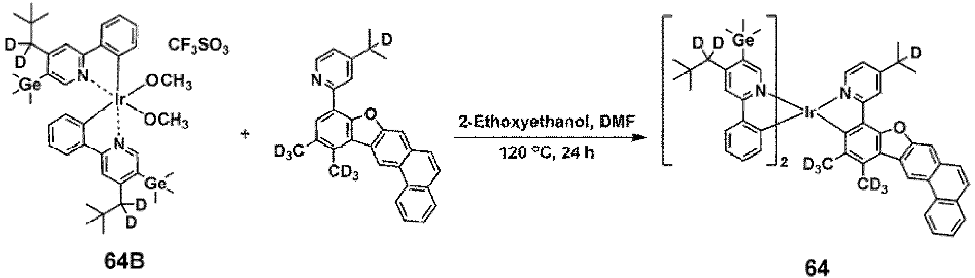

### (1) Synthesis of Compound 64A

4-(2,2-dimethylpropyl-1,1-d2)-2-phenyl-5-(trimethylgermyl)pyridine (5.00 g, 14.53 mmol) and iridium chloride hydrate (2.46 g, 6.98 mmol) were mixed with 27 mL of 2-ethoxyethanol and 9 mL of DI water. The mixture was stirred under reflux for 24 hours, and then the temperature was lowered to room temperature. The resulting solid was separated by filtration, washed sufficiently with water, methanol, and hexane, in this stated order, and then dried in a vacuum oven to obtain 5.23 g (yield of 82%) of Compound 64A.

### (2) Synthesis of Compound 64B

In a first flask, Compound 64A (5.23 g, 2.86 mmol) was mixed with 105 mL of dichloromethane. In a second flask, a mixture of AgOTf (1.54 g, 6.01 mmol) and 35 mL of methanol was prepared. The second flask was then combined with the first flask. Thereafter, the resulting mixture was stirred for 24 hours at room temperature while light was blocked with aluminum foil. The reaction mixture was then filtered through Celite to remove the resulting solid, and the solvent was removed from the filtrate under a reduced pressure to obtain a solid (Compound 64B). Compound 64B was used in the next reaction without an additional purification process.

### (3) Synthesis of Compound 64

Compound 64B (4.88 g, 4.47 mmol) and 2-(11,12-bis(methyl-d3)phenanthro[2,3-b]benzofuran-9-yl)-4-(propan-2-yl-2-d)pyridine (1.89 g, 4.47 mmol) were mixed with 45 mL of 2-ethoxyethanol and 45 mL of dimethylformamide. The mixture was stirred at 120°C for 24 hours, and then the temperature was lowered to room temperature. The solvent was then removed under a reduced pressure to obtain a solid, and then the product was prufied by column chromatography (eluents: hexane and ethyl acetate) to obtain Compound 64 (1.69 g, yield: 29%). The obtained compound was identified by HRMS (MALDI) and HPLC analysis.

HRMS (MALDI) calcd for C₆₈H₆₅D₁₁Ge₂IrN₃O: m/z 1299.9201; found: 1299.9200.

### Synthesis Example 5: Synthesis of Compound 14

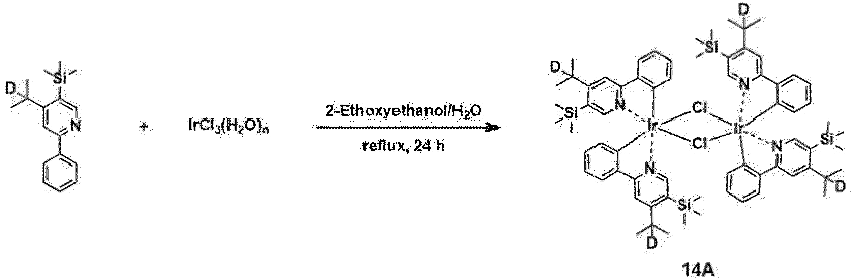

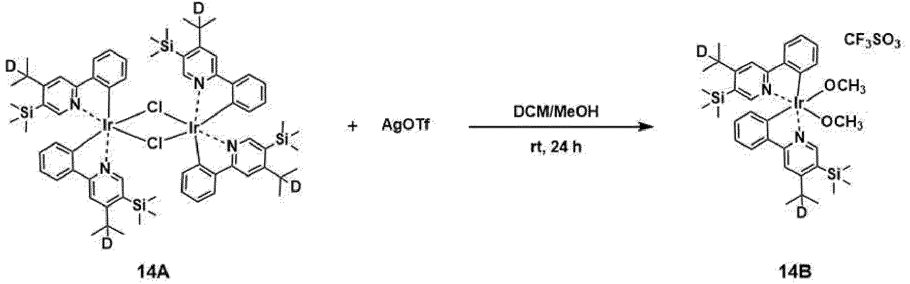

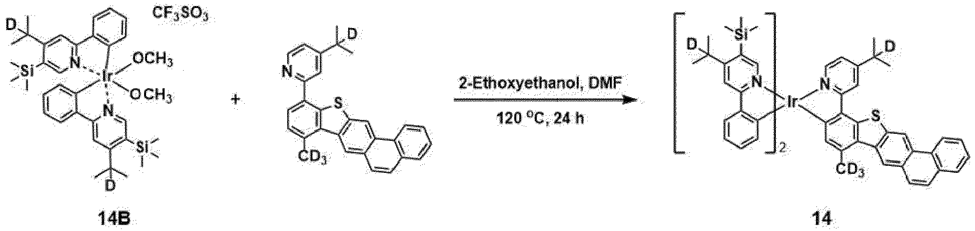

### (1) Synthesis of Compound 14A

2-phenyl-4-(propan-2-yl-2-d)-5-(trimethylsilyl)pyridine (3.00 g, 11.09 mmol) and iridium chloride hydrate (1.88 g, 5.32 mmol) were mixed with 21 mL of 2-ethoxyethanol and 7 mL of DI water. The mixture was stirred under reflux for 24 hours, and then the temperature was lowered to room temperature. The resulting solid was separated by filtration, washed sufficiently with water, methanol, and hexane, in this stated order, and then dried in a vacuum oven to obtain 3.27 g (yield of 80%) of Compound 14A.

### (2) Synthesis of Compound 14B

In a first flask, Compound 14A (3.27 g, 2.13 mmol) was mixed with 75 mL of dichloromethane. In a second flask, a mixture of AgOTf (1.15 g, 4.48 mmol) and 25 mL of methanol was prepared. The second flask was then combined with the first flask. Thereafter, the resulting reaction mixture was stirred for 24 hours at room temperature while light was blocked with aluminum foil. The reaction contents were then filtered through Celite to remove the resulting solid, and the solvent was removed from the filtrate under a reduced pressure to obtain a solid (Compound 14B). Compound 14B was used in the next reaction without an additional purification process.

### (3) Synthesis of Compound 14

Compound 14B (3.22 g, 3.41 mmol) and 2-(8-(methyl-d3)benzo[b]phenanthro[2,3-d]thiophen-11-yl)-4-(propan-2-yl-2-d)pyridine (1.44 g, 3.41 mmol) were mixed with 35 mL of 2-ethoxyethanol and 35 mL of dimethylformamide. The mixture was stirred at 120°C for 24 hours, and then the temperature was lowered to room temperature. The solvent was removed under a reduced pressure to obtain a solid, and then the product was purified by column chromatography (eluents: hexane and ethyl acetate) to obtain Compound 14 (1.30 g, yield: 33%). The obtained compound was identified by HRMS (MALDI) and HPLC analysis.

HRMS (MALDI) calculated for C₆₃H₆₀D₆IrN₃SSi₂: m/z 1151.4522; found: 1151.4524.

### Synthesis Example 6: Synthesis of Compound 18

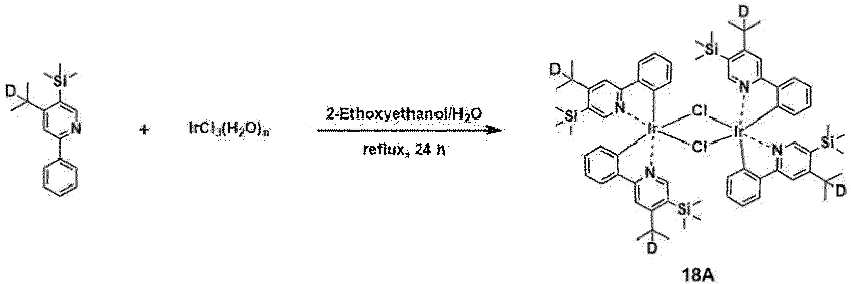

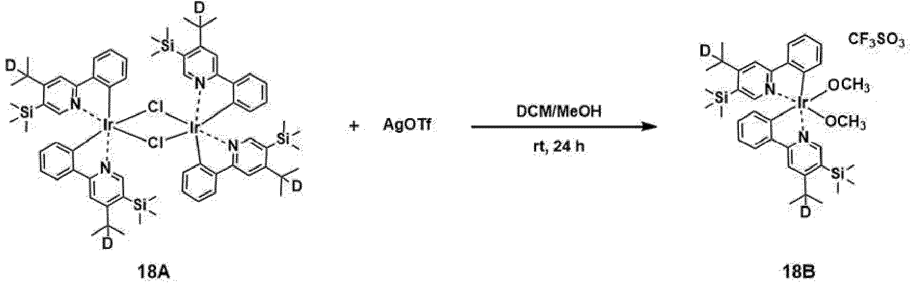

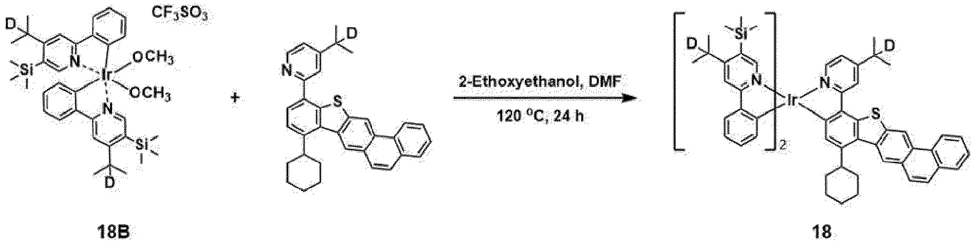

### (1) Synthesis of Compound 18A

2-phenyl-4-(propan-2-yl-2-d)-5-(trimethylsilyl)pyridine (3.00 g, 11.09 mmol) and iridium chloride hydrate (1.88 g, 5.32 mmol) were mixed with 21 mL of 2-ethoxyethanol and 7 mL of DI water. The mixture was stirred under reflux for 24 hours, and then the temperature was lowered to room temperature. The resulting solid was separated by filtration, washed sufficiently with water, methanol, and hexane, in this stated order, and then dried in a vacuum oven to obtain 3.27 g (yield of 80%) of Compound 18A.

### (2) Synthesis of Compound 18B

In a first flask, Compound 18A (3.27 g, 2.13 mmol) was mixed with 75 mL of dichloromethane. In a second flask, a mixture of AgOTf (1.15 g, 4.48 mmol) and 25 mL of methanol was prepared. The second flask was then added to the first flask. Thereafter, the resulting reaction mixture was stirred for 24 hours at room temperature while light was blocked with aluminum foil. The mixture was then filtered through Celite to remove the resulting solid, and the solvent was removed from the filtrate under a reduced pressure to obtain a solid (Compound 18B). Compound 18B was used in the next reaction without an additional purification process.

### (3) Synthesis of Compound 18

Compound 18B (3.22 g, 3.41 mmol) and 2-(8-cyclohexylbenzo[b]phenanthro[2,3-d]thiophen-11-yl)-4-(propan-2-yl-2-d)pyridine (1.66 g, 3.41 mmol) were mixed with 35 mL of 2-ethoxyethanol and 35 mL of dimethylformamide. The mixture was stirred at 120°C for 24 hours, and then the temperature was lowered. The solvent was then removed under a reduced pressure to obtain a solid, and then the product was purified by column chromatography (eluents: hexane and ethyl acetate) to obtain Compound 18 (0.87 g, yield: 21%). The obtained compound was identified by HRMS (MALDI) and HPLC analysis.

HRMS (MALDI) calculated for C₆₈H₇₁D₃IrN₃SSi₂: m/z 1216.4959; found: 1216.4959.

### Synthesis Example 7: Synthesis of Compound 19

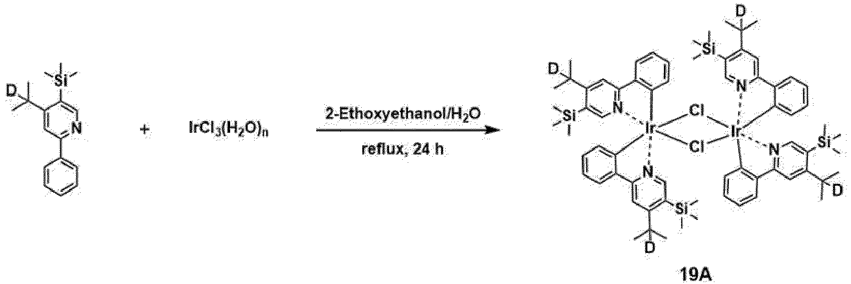

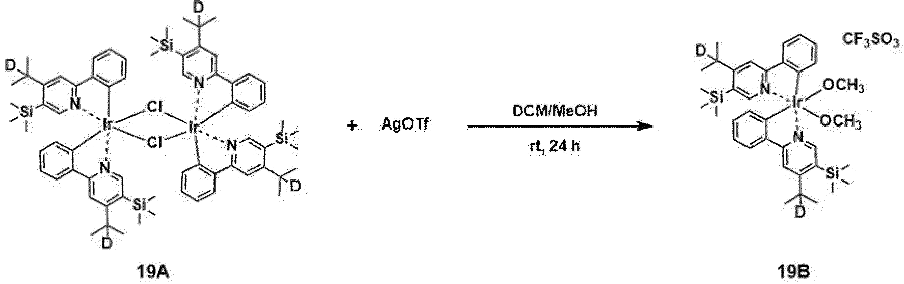

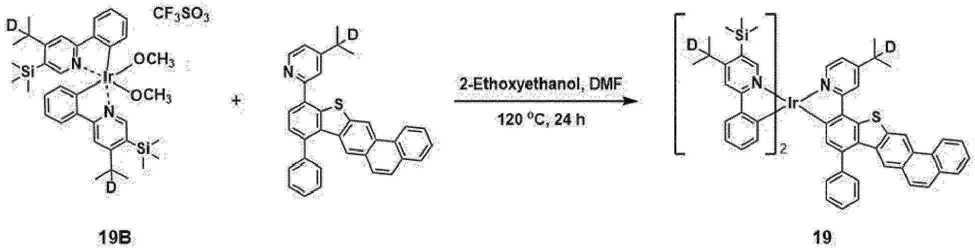

### (1) Synthesis of Compound 19A

2-phenyl-4-(propan-2-yl-2-d)-5-(trimethylsilyl)pyridine (3.00 g, 11.09 mmol) and iridium chloride hydrate (1.88 g, 5.32 mmol) were mixed with 21 mL of 2-ethoxyethanol and 7 mL of DI water. The mixture was stirred under reflux for 24 hours, and then the temperature was lowered to room temperature. The resulting solid was separated by filtration, washed sufficiently with water, methanol, and hexane, in this stated order, and then dried in a vacuum oven to obtain 3.27 g (yield of 80 %) of Compound 19A.

### (2) Synthesis of Compound 19B

In a first flask, Compound 19A (3.27 g, 2.13 mmol) was mixed with 75 mL of dichloromethane. In a second flask, a mixture of AgOTf (1.15 g, 4.48 mmol) and 25 mL of methanol was prepared. Then, the second flask was combined with the first flask. Thereafter, the resulting reaction mixture was stirred for 24 hours at room temperature while light was blocked with aluminum foil. The mixture was then filtered through Celite to remove the resulting solid, and the solvent was removed from the filtrate under a reduced pressure to obtain a solid (Compound 19B). Compound 19B was used in the next reaction step without an additional purification process.

### (3) Synthesis of Compound 19

Compound 19B (3.22 g, 3.41 mmol) and 2-(8-phenylbenzo[b]phenanthro[2,3-d]thiophen-11-yl)-4-(propan-2-yl-2-d)pyridine (1.64 g, 3.41 mmol) were mixed with 35 mL of 2-ethoxyethanol and 35 mL of dimethylformamide. The mixture was stirred at 120°C for 24 hours, and then the temperature was lowered to room temperature. The solvent was then removed under a reduced pressure to obtain a solid, and then the product was purified by column chromatography (eluents: hexane and ethyl acetate) to obtain Compound 19 (1.16 g, yield: 28%). The obtained compound was identified by HRMS (MALDI) and HPLC analysis.

HRMS (MALDI) calculated for C₆₈H₆₅D₃IrN₃SSi₂: m/z 1210.4490; found: 1210.4491.

### Example 1

As an anode, an ITO-patterned glass substrate was cut to a size of 50 millimeters (mm) x 50 mm x 0.5 mm, sonicated in isopropyl alcohol and DI water for 5 minutes each, cleaned by irradiation of ultraviolet rays and exposure to ozone for 30 minutes, and then mounted on a vacuum deposition apparatus.

Compounds HT3 and Compound F12 (p-dopant) were co-deposited by vacuum on the anode at a weight ratio of 98:2 to form a hole injection layer having a thickness of 100 Å, and Compound HT3 was vacuum-deposited on the hole injection layer to form a hole transport layer having a thickness of 1,650 Å.

Then, Compound GH3 (host) and Compound 1 (dopant) were co-deposited on the hole transport layer at a weight ratio of 92:8 to form an emission layer having a thickness of 400 Å.

Afterwards, Compound ET3 and LiQ (n-dopant) were co-deposited on the emission layer at a volume ratio of 50:50 to form an electron transport layer having a thickness of 350 Å, LiQ was vacuum-deposited on the electron transport layer to form an electron injection layer having a thickness of 10 Å, and Al was vacuum-deposited on the electron injection layer to form a cathode having a thickness of 1,000 Å, thereby completing the manufacture of an organic light-emitting device.

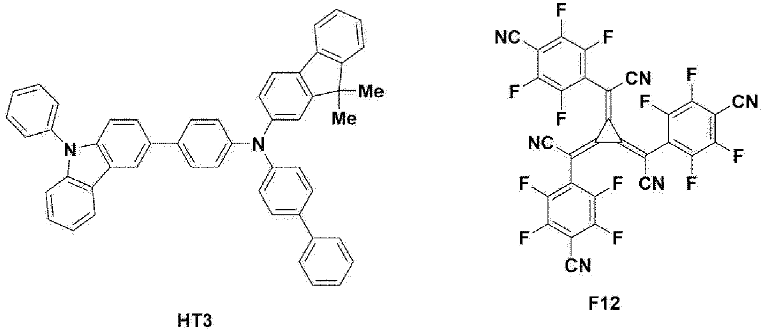

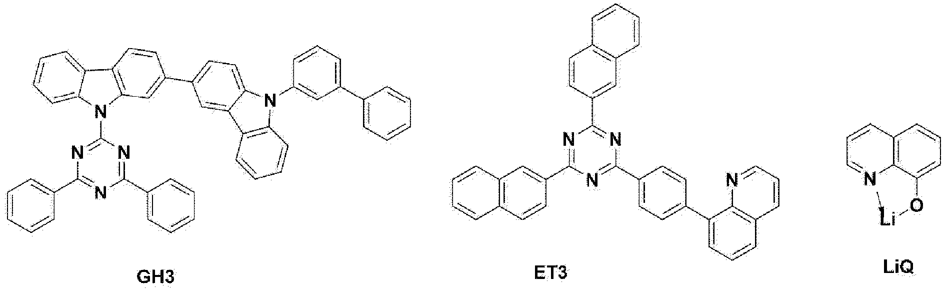

### Examples 2 to 7 and Comparative Examples 1 to 4

Organic light-emitting devices were manufactured in a similar manner as in Example 1, except that Compounds shown in Table 2 were each used instead of Compound 1 as a dopant in forming an emission layer.

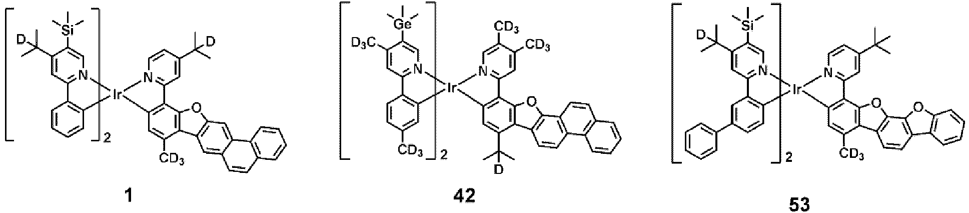

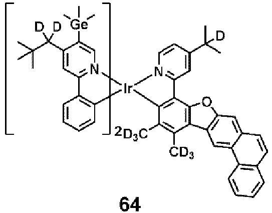

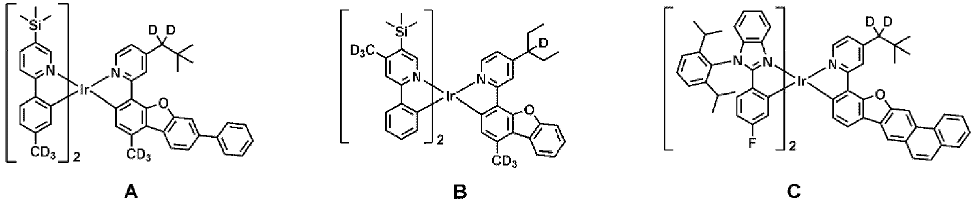

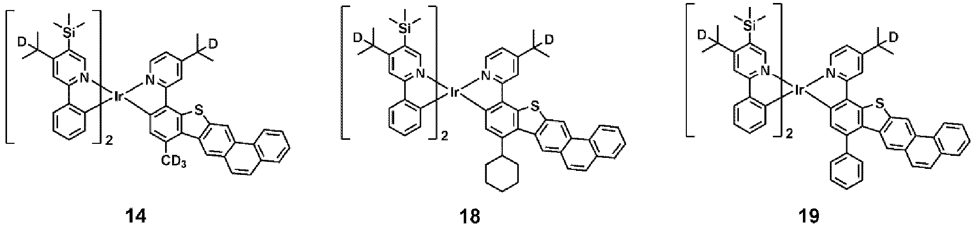

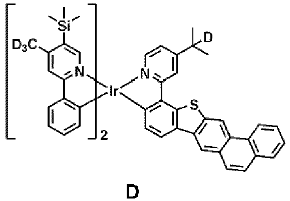

For each of the organic light-emitting devices manufactured in Examples 1 to 7 and Comparative Examples 1 to 4, maximum external quantum efficiency (Max EQE, %), maximum emission wavelength (λₘₐₓ, nm) of an emission spectrum, side luminance ratio (relative %), and lifespan (LT97, relative %) (at 6,000 nit) were evaluated, and the results are shown in Table 2. As evaluation apparatuses, a current-voltage meter (Keithley 2400) and a luminance meter (Minolta Cs-1000A) were used.

As for the side luminance ratio, the luminescence of the organic light-emitting devices was measured per angle, and a ratio of the luminance in the vertical direction to the luminance in the 45° direction is shown in Table 1 as a relative value based on Comparative Example 1.

The lifespan characteristics (LT97) were evaluated by measuring the amount of time that elapsed until the luminance was reduced to 97% of the initial luminance of 100%, and the results thereof are shown in Table 1 as relative values based on Comparative Example 1.

**Table 1**

| No. | Dopant in emission layer | Max EQE (%) | λₘₐₓ (nm) | Side luminance ratio (relative %) | LT97 (relative %) |
|---|---|---|---|---|---|
| Example 1 | Compound 1 | 113 | 516 | 155 | 125 |
| Example 2 | Compound 42 | 109 | 517 | 151 | 115 |
| Example 3 | Compound 53 | 106 | 518 | 147 | 120 |
| Example 4 | Compound 64 | 110 | 519 | 151 | 105 |
| Comparative Example 1 | Compound A | 100 | 525 | 100 | 100 |
| Comparative Example 2 | Compound B | 95 | 515 | 145 | 65 |
| Comparative Example 3 | Compound C | 70 | 509 | 140 | 50 |
| Example 5 | Compound 14 | 113 | 522 | 130 | 120 |
| Example 6 | Compound 18 | 110 | 523 | 125 | 105 |
| Example 7 | Compound 19 | 104 | 534 | 75 | 180 |
| Comparative Example 4 | Compound D | 114 | 532 | 68 | 125 |

From Table 2, it was found that as the organic light-emitting devices of Examples 1 to 7 have high external quantum efficiency and side luminance ratio, and long lifespan, and due to improvement of side luminance ratio, the viewing angle thereof may be improved. For example, the organic light-emitting devices of Examples 1 to 4 had a higher EQE, and significantly higher side luminance ratio and longer lifespan than the organic light-emitting devices of Comparative Examples 1 to 3. In addition, the organic light-emitting devices of Examples 5 to 7 had a higher or equivalent EQE and significantly higher side luminance ratio, and longer lifespan than the organic light-emitting device of Comparative Example 4.

The organometallic compounds represented by Formula 1 have excellent electrical characteristics and thermal stability. Accordingly, an electronic device using at least one of the organometallic compounds represented by Formula 1, for example, an organic light-emitting device using at least one of the organometallic compounds represented by Formula 1, has a low driving voltage, a high efficiency, a long lifespan, a reduced roll-off ratio, and a relatively narrow EL spectrum emission peak FWHM.

Thus, due to the use of the organometallic compounds, a high-quality organic light-emitting device may be embodied. In addition, an electronic apparatus including the organic light-emitting device may be provided.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. An organometallic compound represented by Formula 1:
Formula 1 M₁(Ln₁)ₙ₁(Ln₂)ₙ₂
wherein, in Formula 1,
M₁ is a transition metal,
Ln₁ is a ligand represented by Formula 1A,
Ln₂ is a ligand represented by Formula 1B,
n1 is 1 or 2, and
n2 is 1 or 2: 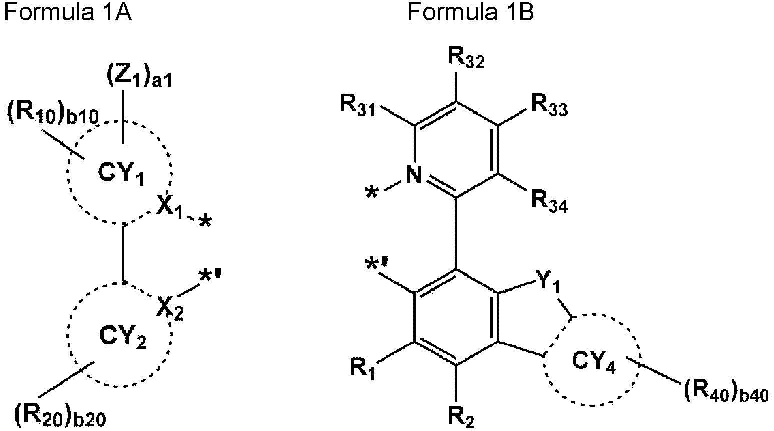 wherein, in Formulae 1A and 1B,
ring CY₁ and ring CY₂ are each independently a C₅-C₃₀ carbocyclic group or a C₁-C₃₀ heterocyclic group,
ring CY₄ is a polycyclic C₅-C₃₀ carbocyclic group or a polycyclic C₁-C₃₀ heterocyclic group,
X₁ is C or N, and X₂ is C or N,
Y₁ is O, S, or Se,
Z₁ is -Si(Q₁)(Q₂)(Q₃) or -Ge(Q₁)(Q₂)(Q₃),
a1 is 1, 2, 3, or 4,
R₁, R₂, R₁₀, R₂₀, R₃₁ to R₃₄, and R₄₀ are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -Si(Q₁)(Q₂)(Q₃), -Ge(Q₁)(Q₂)(Q₃), -N(Q₄)(Q₅), - B(Q₆)(Q₇), -P(Q₈)(Q₉), or -P(=O)(Q₈)(Q₉),
at least one of R₁ and R₂ is a substituted or unsubstituted C₁-C₆₀ alkyl group, a substituted or unsubstituted C₃-C₁₀ cycloalkyl group, or a substituted or unsubstituted C₆-C₆₀ aryl group,
two or more of a plurality of R₁₀ are optionally bonded to each other to form a substituted or unsubstituted C₅-C₃₀ carbocyclic group or a substituted or unsubstituted C₁-C₃₀ heterocyclic group,
two or more of a plurality of R₂₀ are optionally bonded to each other to form a substituted or unsubstituted C₅-C₃₀ carbocyclic group or a substituted or unsubstituted C₁-C₃₀ heterocyclic group,
two or more of a plurality of R₄₀ are optionally bonded to each other to form a substituted or unsubstituted C₅-C₃₀ carbocyclic group or a substituted or unsubstituted C₁-C₃₀ heterocyclic group,
neighboring two or more of R₁, R₂, R₁₀, R₂₀, R₃₁ to R₃₄, or R₄₀ are optionally bonded to each other to form a substituted or unsubstituted C₅-C₃₀ carbocyclic group or a substituted or unsubstituted C₁-C₃₀ heterocyclic group,
b10, b20, and b40 are each independently 1, 2, 3, 4, 5, 6, 7, 8, 9, or 10, * and *" each indicates a binding site to M₁,
at least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group is:
deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₁₁)(Q₁₂)(Q₁₃), -Ge(Q₁₁)(Q₁₂)(Q₁₃), -N(Q₁₄)(Q₁₅), -B(Q₁₆)(Q₁₇), -P(Q₁₈)(Q₁₉), -P(=O)(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each substituted with at least one of deuterium, -F, - Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₂₁)(Q₂₂)(Q₂₃), -Ge(Q₂₁)(Q₂₂)(Q₂₃), -N(Q₂₄)(Q₂₅), -B(Q₂₆)(Q₂₇), -P(Q₂₈)(Q₂₉), -P(=O)(Q₂₈)(Q₂₉), or a combination thereof; or
-Si(Q₃₁)(Q₃₂)(Q₃₃), -Ge(Q₃₁)(Q₃₂)(Q₃₃), -N(Q₃₄)(Q₃₅), -B(Q₃₆)(Q₃₇), -P(Q₃₈)(Q₃₉), or -P(=O)(Q₃₈)(Q₃₉), and
Q₁ to Q₉, Q₁₁ to Q₁₉, Q₂₁ to Q₂₉, and Q₃₁ to Q₃₉ are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group.

2. The organometallic compound of claim 1, wherein M₁ is iridium, platinum, osmium, titanium, zirconium, hafnium, europium, terbium, thulium, or rhodium;
preferably wherein M₁ is iridium and a sum of n1 and n2 is 3.

3. The organometallic compound of claims 1 or 2, wherein ring CY₁ and ring CY₂ are each independently a benzene group, a naphthalene group, a 1,2,3,4-tetrahydronaphthalene group, a phenanthrene group, a pyridine group, a pyrimidine group, a pyrazine group, a pyridazine group, a triazine group, a quinoline group, an isoquinoline group, a quinoxaline group, a quinazoline group, a phenanthroline group, a benzofuran group, a benzothiophene group, a fluorene group, a carbazole group, a dibenzofuran group, a dibenzothiophene group, a dibenzosilole group, an azafluorene group, an azacarbazole group, an azadibenzofuran group, an azadibenzothiophene group, or an azadibenzosilole group.

4. The organometallic compound of any of claims 1-3, wherein a moiety represented by 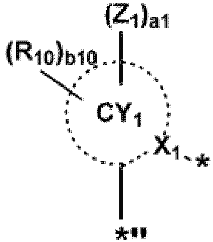 is a group represented by any one of Formulae 1-1 to 1-32: 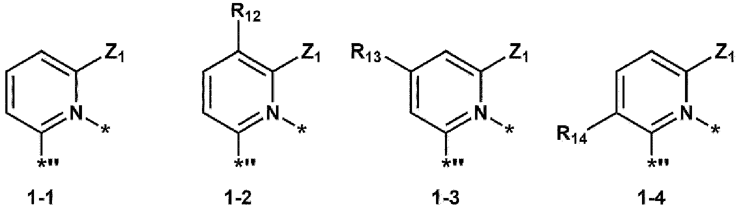 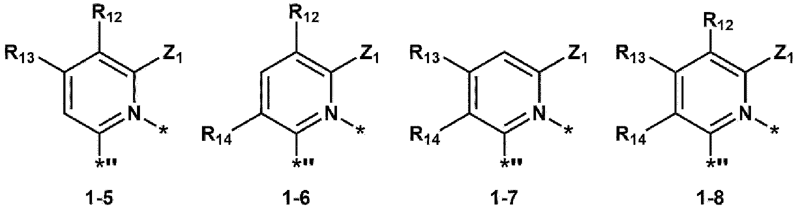 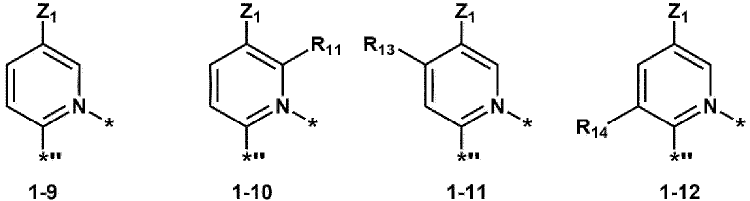 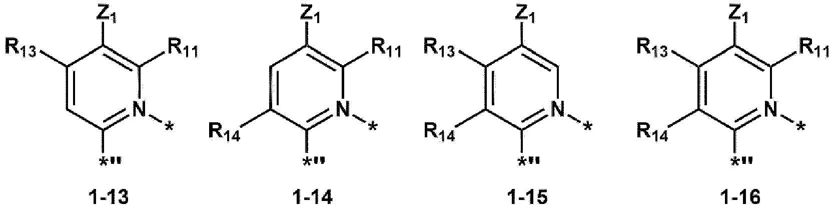 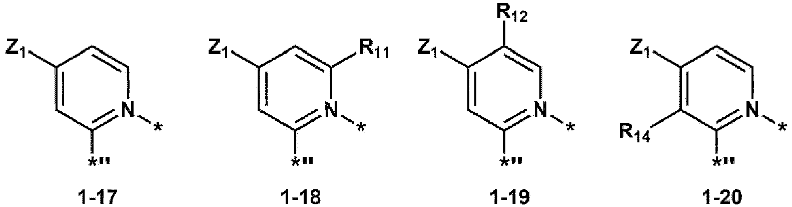 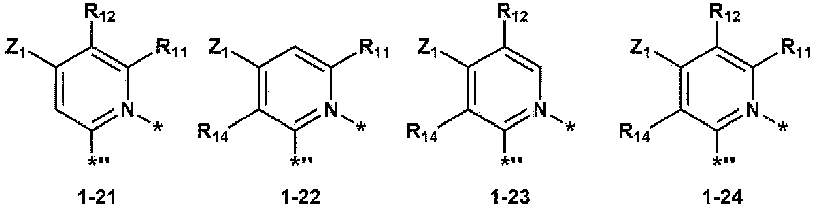 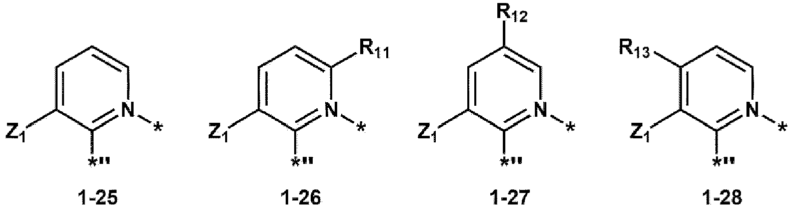 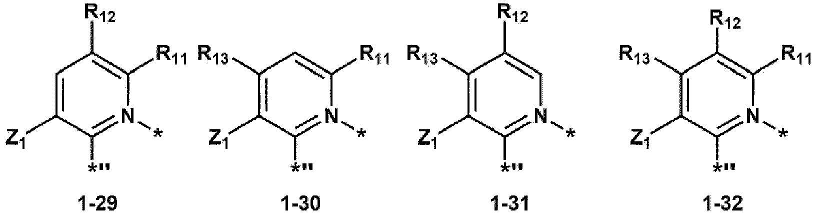 wherein, in Formulae 1-1 to 1-32,
R₁₁ to R₁₄ are each independently as described in connection with R₁₀ in claim 1, provided that R₁₁ to R₁₄ are not hydrogen,
Z₁ is as described in claim 1,
* indicates a binding site to M₁, and
*" indicates a binding site to a neighboring atom; and/or
wherein a moiety represented by 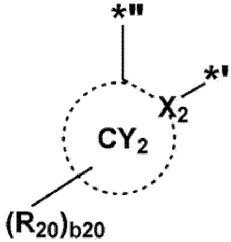 is a group represented by one of Formulae 2-1 to 2-16: 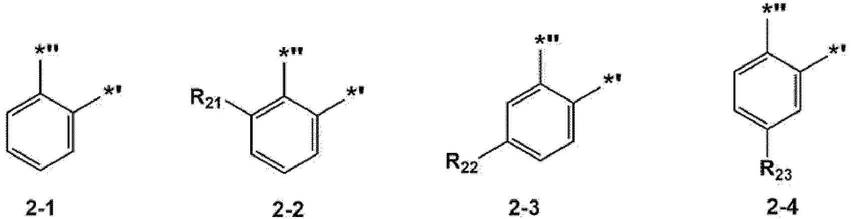 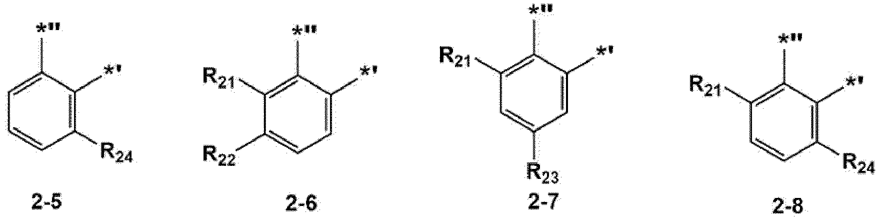 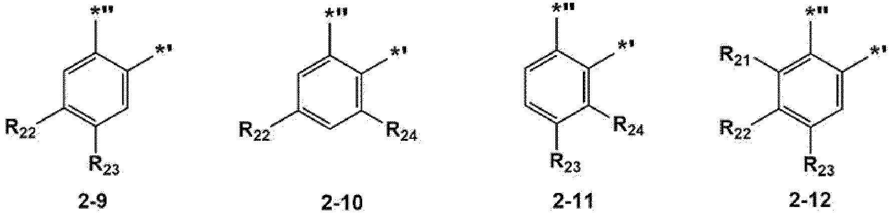 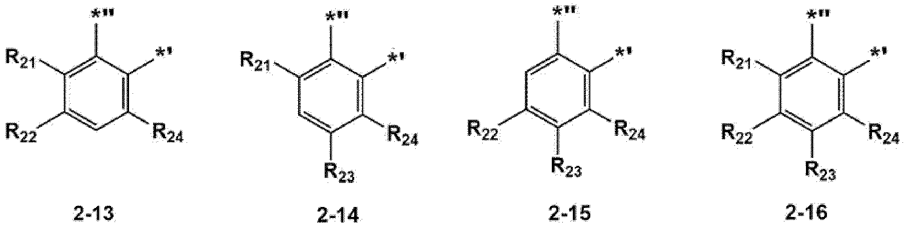
wherein, in Formulae 2-1 to 2-16,
R₂₁ to R₂₄ are each independently as described in connection with R₂₀ in claim 1, provided that R₂₁ to R₂₄ are not hydrogen,
* indicates a binding site to M₁, and
*" indicates a binding site to a neighboring atom.

5. The organometallic compound of any of claims 1-4, wherein ring CY₄ is a group represented by Formula 4: 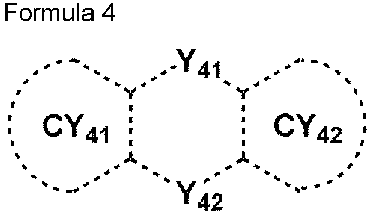 wherein, in Formula 4,
Y₄₁ and Y₄₂ are each independently a single bond, *-O-*', *-S-*', *-Se-*', *-N(R₅₁)-*', *-C(R₅₁)(R₅₂)-*', *-Si(R₅₁)(R₅₂)-*', *-B(R₅₁)-*', *-P(R₅₁)-*', *-C(=O)-*', *-S(=O)₂-*', *-P(=O)(R₅₁)-*', *-C(R₅₁)=*', *-N=*', *-C(R₅₁)=C(R₅₂)-*', *-C(R₅₁)=N-*', or *-N=N-*',
ring CY₄₁ and ring CY₄₂ are each independently a C₅-C₁₅ carbocyclic group or a C₁-C₁₅ heterocyclic group, and
R₅₁ and R₅₂ are each independently as described in connection with R₄₀ in claim 1.

6. The organometallic compound of any of claims 1-5, wherein a moiety represented by 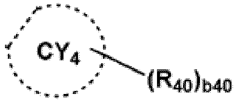 is a group represented by any one of Formulae 4-1 to 4-15: 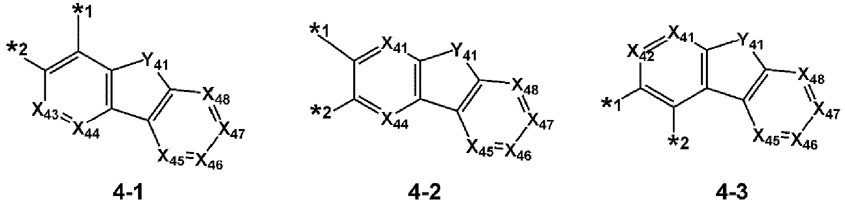 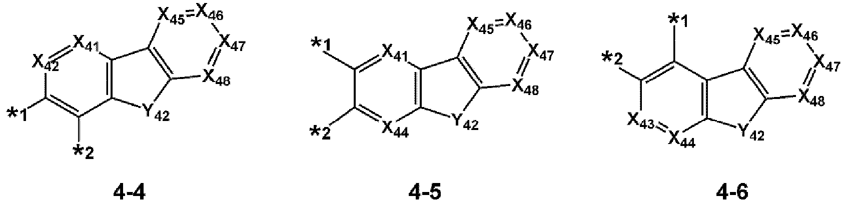 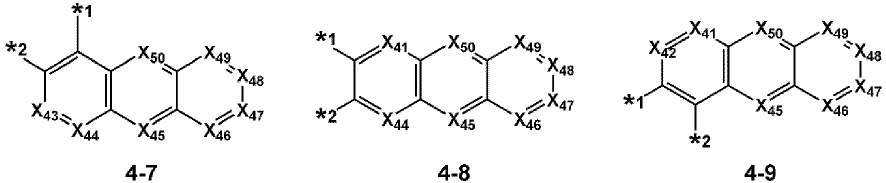 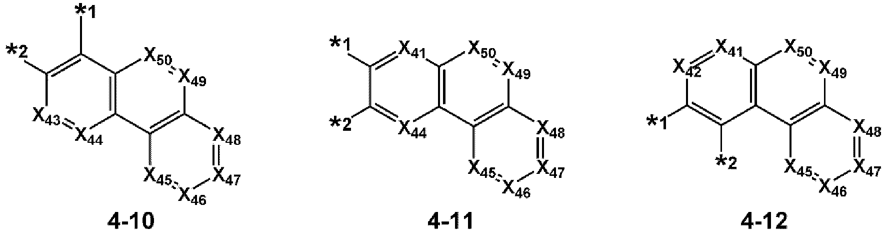 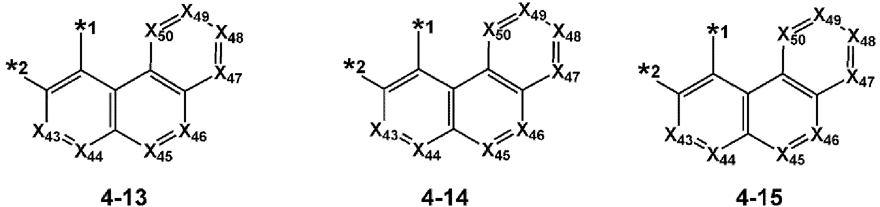 wherein, in Formulae 4-1 to 4-15,
Y₄₁ and Y₄₂ are each independently O, S, Se, N(R₅₁), C(R₅₁)(R₅₂), Si(R₅₁)(R₅₂), B(R₅₁), P(R₅₂), C(=O), S(=O)₂, or P(=O)(R₅₁),
X₄₁ is C(R₄₁) or N, X₄₂ is C(R₄₂) or N, X₄₃ is C(R₄₃) or N, X₄₄ is C(R₄₄) or N, X₄₅ is C(R₄₅) or N, X₄₆ is C(R₄₆) or N, X₄₇ is C(R₄₇) or N, X₄₈ is C(R₄₈) or N, X₄₉ is C(R₄₉) or N, and X₅₀ is C(R₅₀) or N,
R₄₁ to R₅₂ are each independently as described in connection with R₄₀ in claim 1, and
*¹ and *² each indicate a binding site to a neighboring atom.

7. The organometallic compound of any of claims 1-6, wherein R₁, R₂, R₁₀, R₂₀, R₃₁ to R₃₄, and R₄₀ are each independently:
hydrogen, deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, or a C₁-C₂₀ alkylthio group;
a C₁-C₂₀ alkyl group, a C₁-C₂₀ alkoxy group, or a C₁-C₂₀ alkylthio group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, or a combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₆₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, or a combination thereof; or
**-Si(Q₁)(Q₂)(Q₃),** -Ge(Q₁)(Q₂)(Q₃), **-N(Q₄)(Q₅), -B(Q₆)(Q₇), -P(Q₈)(Q₉), or** - P(=O)(Q₈)(Q₉), and
Q₁ to Q₉ are each independently:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group; or
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group, each substituted with at least one of deuterium, a C₁-C₁₀ alkyl group, a phenyl group, or a combination thereof.

8. The organometallic compound of any of claims 1-7, wherein at least one of R₁ and R₂ is a C₁-C₆₀ alkyl group substituted with at least one deuterium; and/or
wherein at least one of R₃₁ to R₃₄ is not hydrogen.

9. The organometallic compound of any of claims 1-8, wherein the organometallic compound is a compound represented by Formula 11: 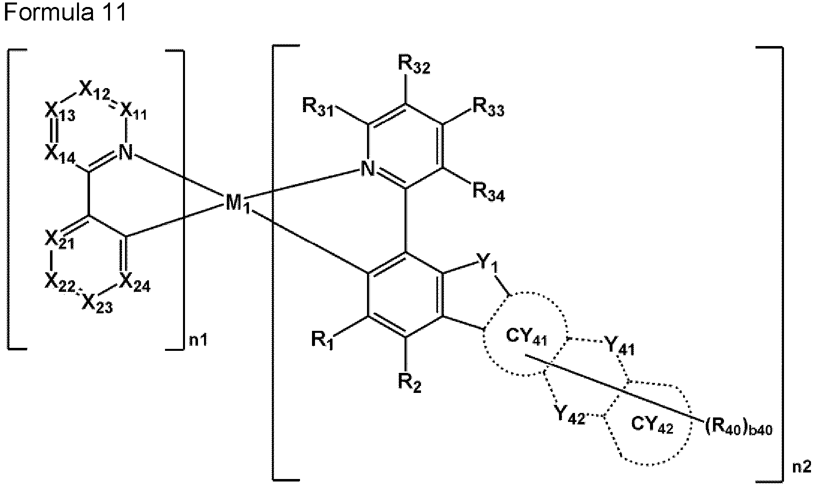 wherein, in Formula 11,
M₁, n1, n2, b40, R₁, R₂, R₃₁ to R₃₄, R₄₀, and Y₁ are each as described in claim 1,
Y₄₁ and Y₄₂ are each independently a single bond, *-O-*', *-S-*', *-Se-*', *-N(R₅₁)-*', *-C(R₅₁)(R₅₂)-*', *-Si(R₅₁)(R₅₂)-*', *-B(R₅₁)-*', *-P(R₅₂)-*', *-C(=O)-*', *-S(=O)₂-*', *-P(=O)(R₅₁)-*', *-C(R₅₁)=*', *-N=*', *-C(R₅₁)=C(R₅₂)-*', *-C(R₅₁)=N-*', or *-N=N-*',
ring CY₄₁ and ring CY₄₂ are each independently a C₅-C₁₅ carbocyclic group or a C₁-C₁₅ heterocyclic group,
X₁₁ is C(Z₁), C(R₁₁), or N, X₁₂ is C(Z₁), C(R₁₂), or N, X₁₃ is C(Z₁), C(R₁₃), or N, and X₁₄ is C(Z₁), C(R₁₄), or N,
X₂₁ is C(R₂₁) or N, X₂₂ is C(R₂₂) or N, X₂₃ is C(R₂₃) or N, and X₂₄ is C(R₂₄) or N, at least one of X₁₁ to X₁₄ is C(Z₁),
two or more of R₁₁ to R₁₄ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of R₂₁ to R₂₄ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of a plurality of R₄₀ are optionally bonded to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
R₁₀ₐ is as described in connection with R₁₀,
R₁₁ to R₁₄ are independently as described in connection with R₁₀,
R₂₁ to R₂₄ are independently as described in connection with R₂₀, and
R₄₉ and R₅₀ are each independently as described in connection with R₄₀ in claim 1; or
wherein the organometallic compound is a compound represented by one of Formulae 21-1 to 21-15: 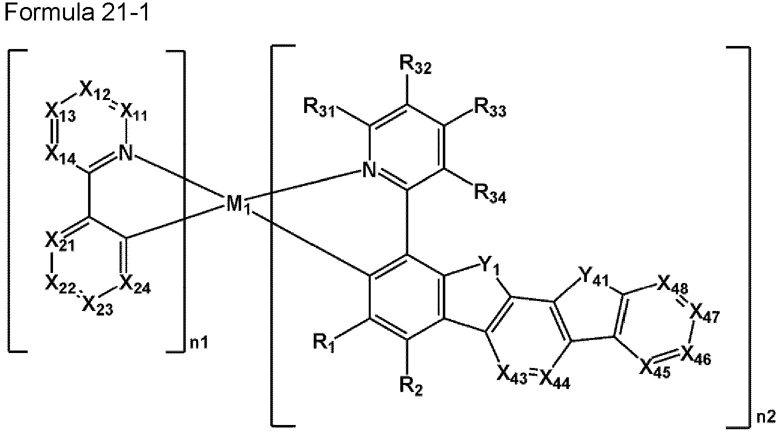 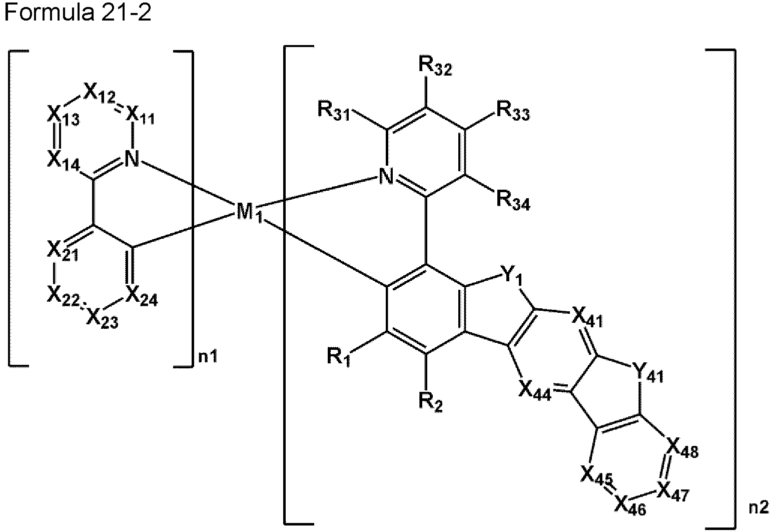 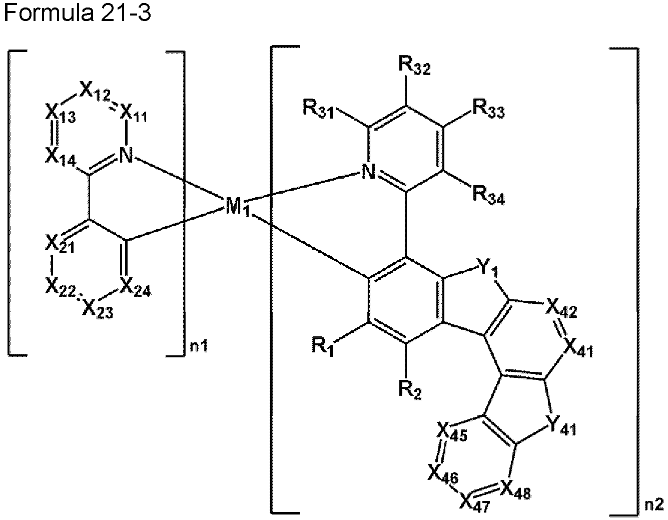 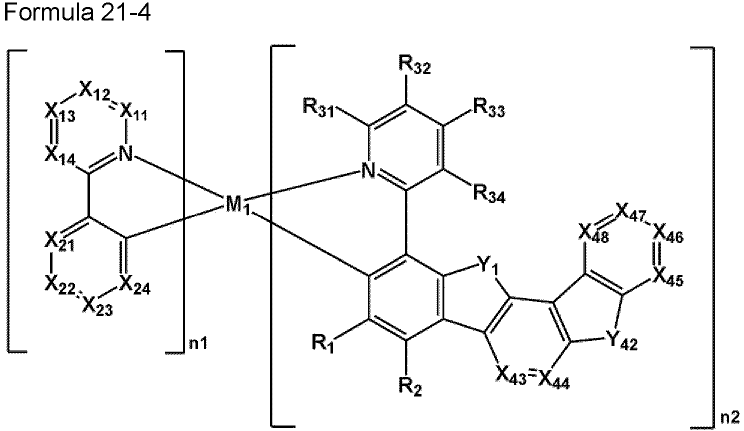 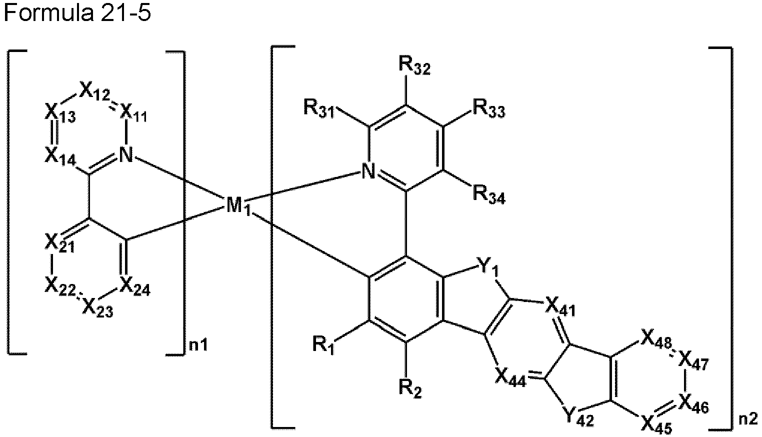 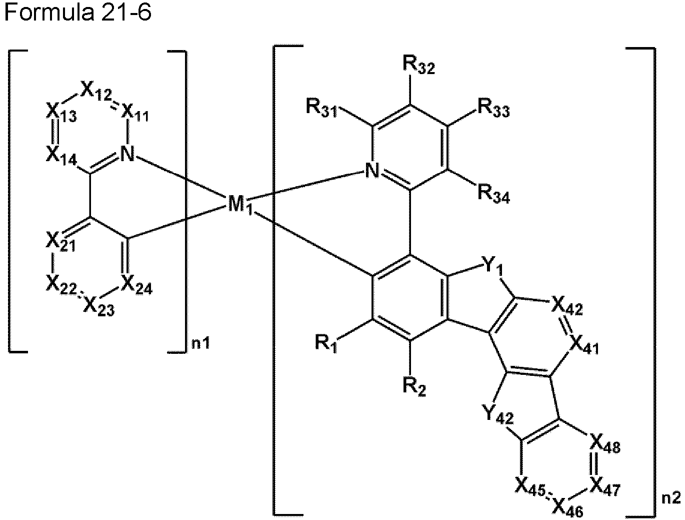 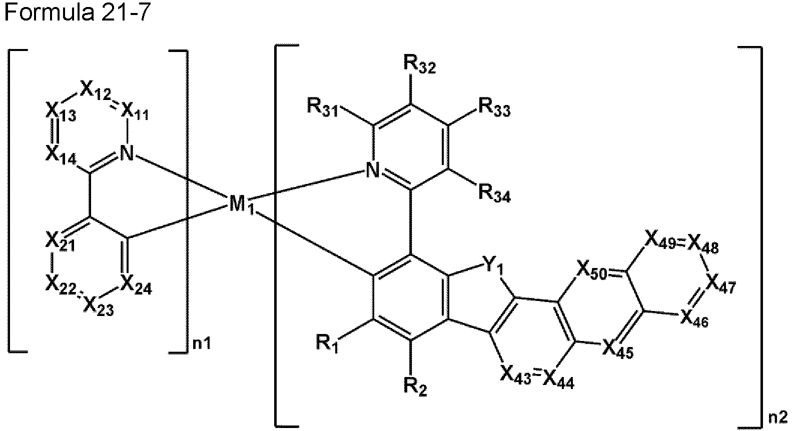 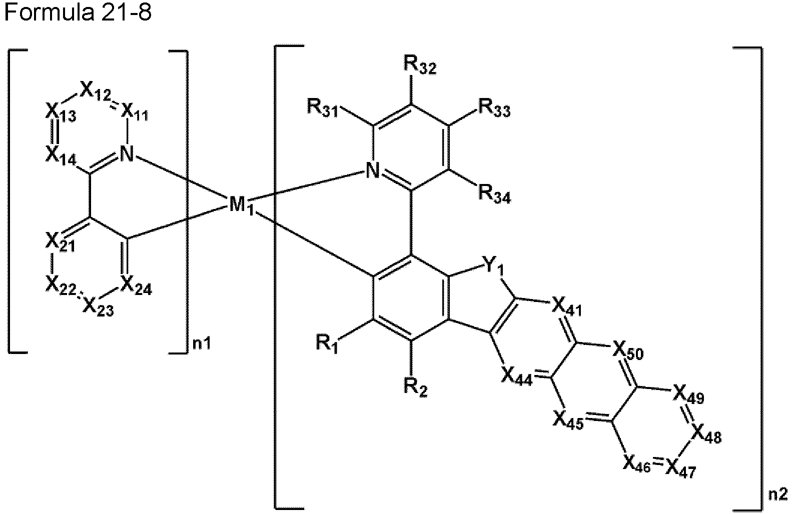 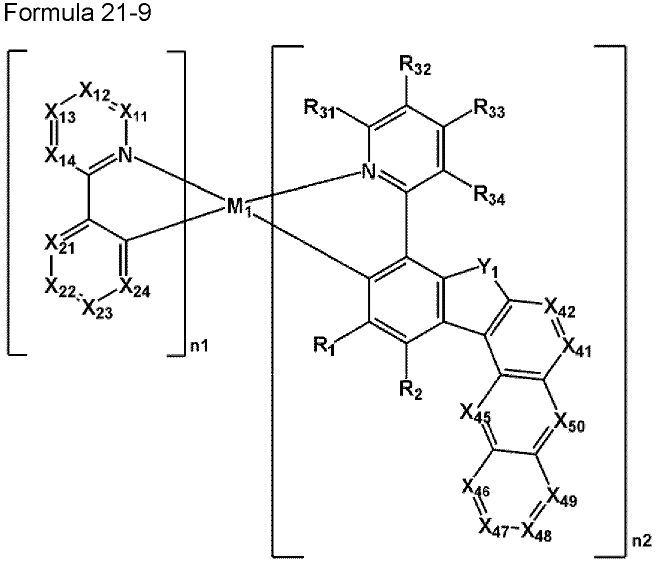 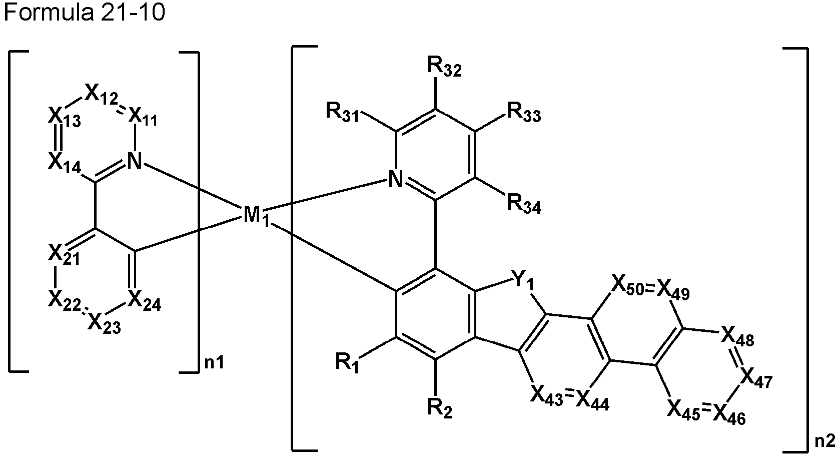 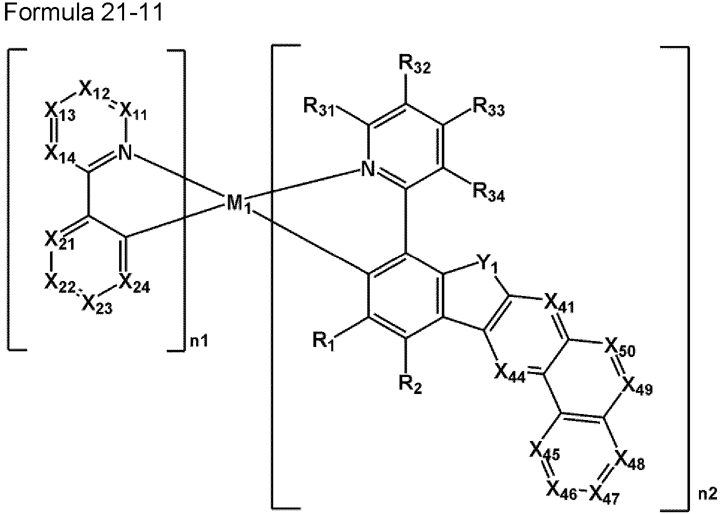 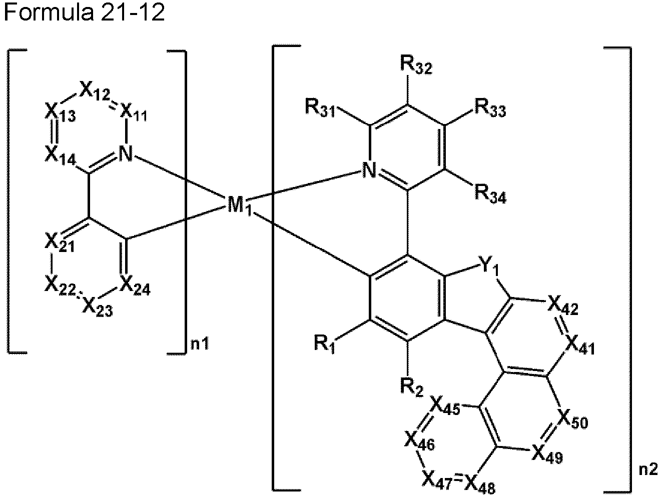 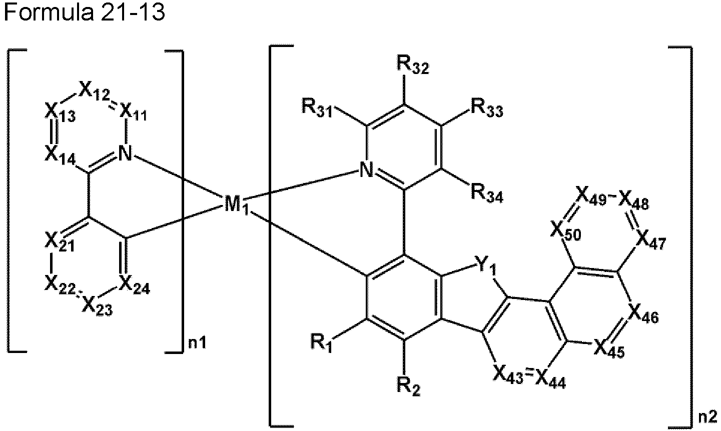 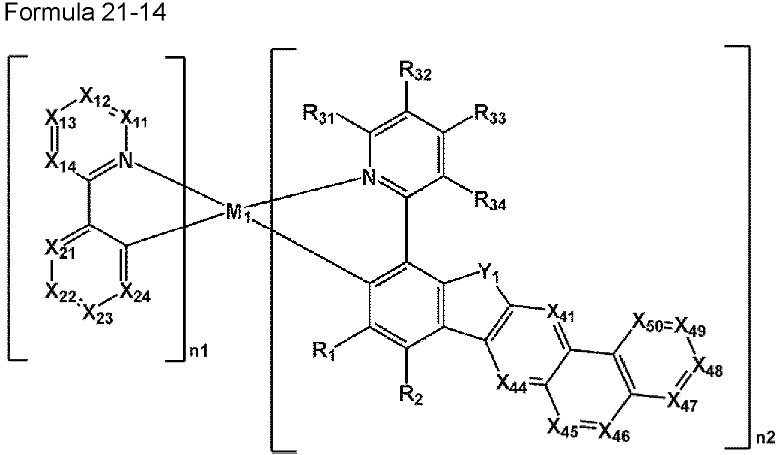 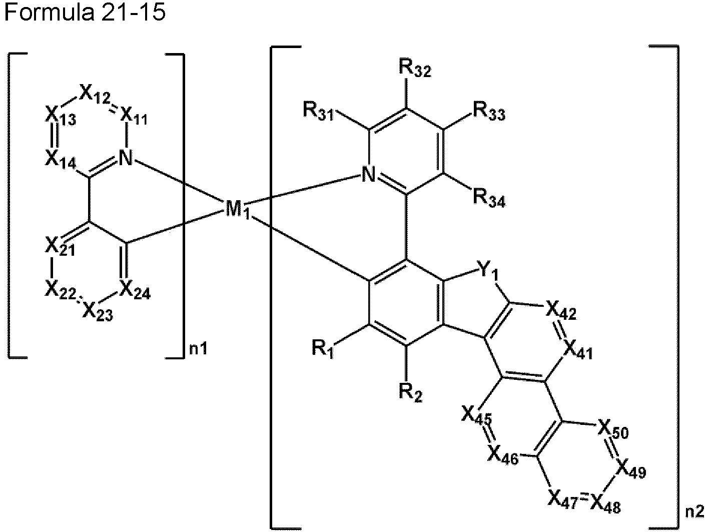 wherein, in Formulae 21-1 to 21-15,
Y₄₁ and Y₄₂ are each independently a single bond, *-O-*', *-S-*', *-Se-*', *-N(R₅₁)-*', *-C(R₅₁)(R₅₂)-*', *-Si(R₅₁)(R₅₂)-*', *-B(R₅₁)-*', *-P(R₅₁)-*', *-C(=O)-*', *-S(=O)₂-*', *-P(=O)(R₅₁)-*', *-C(R₅₁)=*', or *-N=*',
X₁₁ is C(Z₁), C(R₁₁), or N, X₁₂ is C(Z₁), C(R₁₂), or N, X₁₃ is C(Z₁), C(R₁₃), or N, and X₁₄ is C(Z₁), C(R₁₄), or N,
at least one of X₁₁ to X₁₄ is C(Z₁), Z₁ is as described in claim 1,
X₂₁ is C(R₂₁) or N, X₂₂ is C(R₂₂) or N, X₂₃ is C(R₂₃) or N, and X₂₄ is C(R₂₄) or N,
X₄₁ is C(R₄₁) or N, X₄₂ is C(R₄₂) or N, X₄₃ is C(R₄₃) or N, X₄₄ is C(R₄₄) or N, X₄₅ is C(R₄₅) or N, X₄₆ is C(R₄₆) or N, X₄₇ is C(R₄₇) or N, X₄₈ is C(R₄₈) or N, X₄₉ is C(R₄₉) or N, and X₅₀ is C(R₅₀) or N,
R₁₁ to R₁₄ are each independently as described in connection with R₁₀,
R₂₁ to R₂₄ are each independently as described in connection with R₂₀,
R₄₁ to R₅₀ are each independently as described in connection with R₄₀,
two or more of R₁₁ to R₁₄ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of R₂₁ to R₂₄ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ, and
R₁₀ₐ is as described in connection with R₁₀.

10. The organometallic compound of claim 1, wherein the organometallic compound is represented by at least one of Compounds 1 to 78:

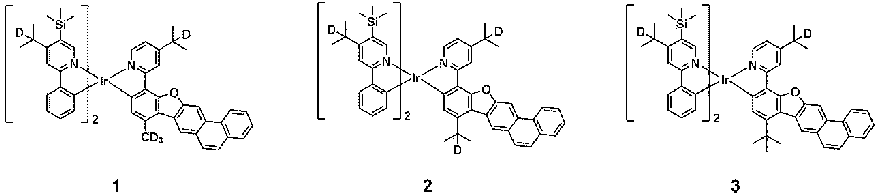

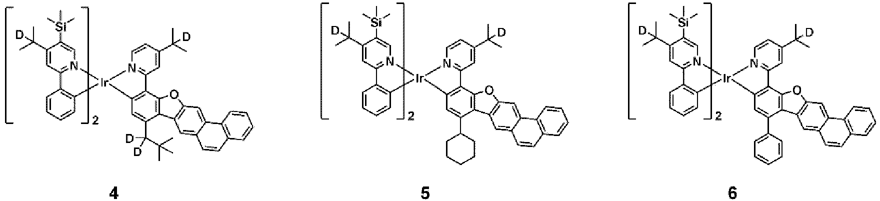

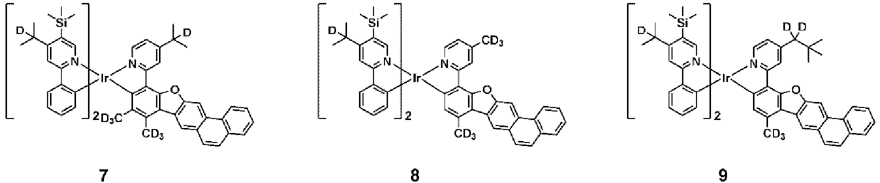

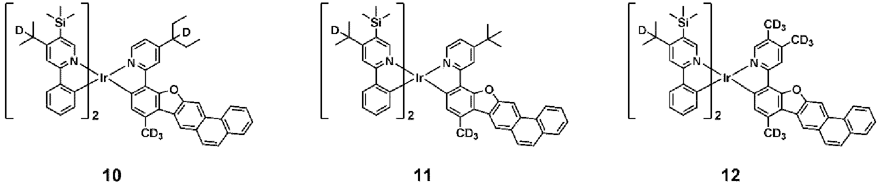

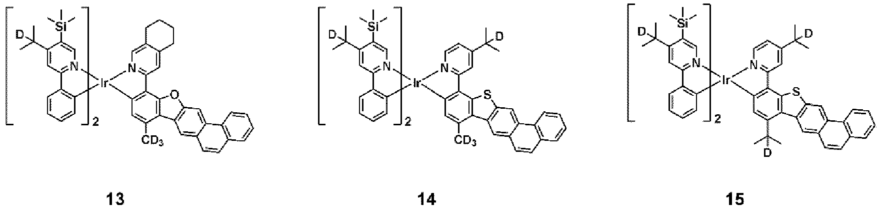

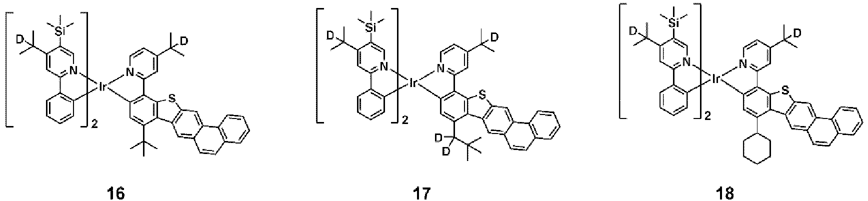

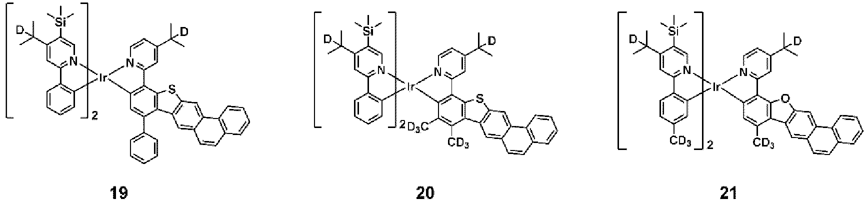

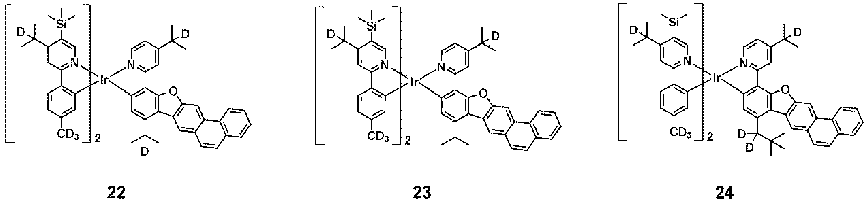

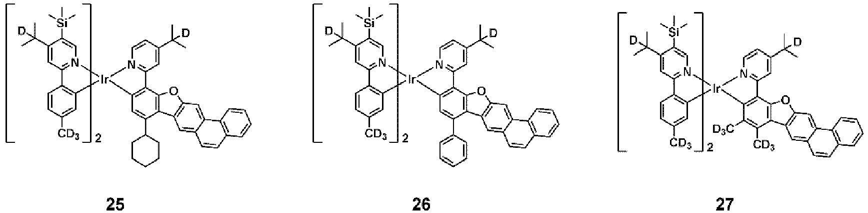

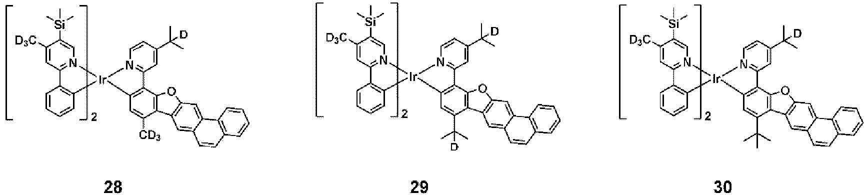

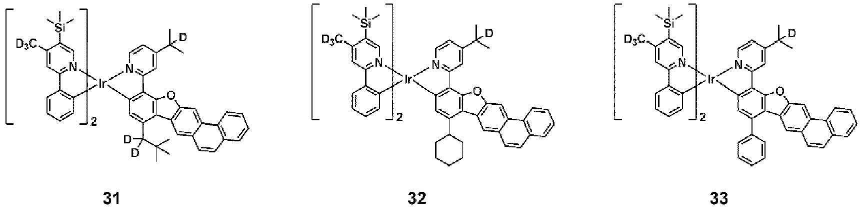

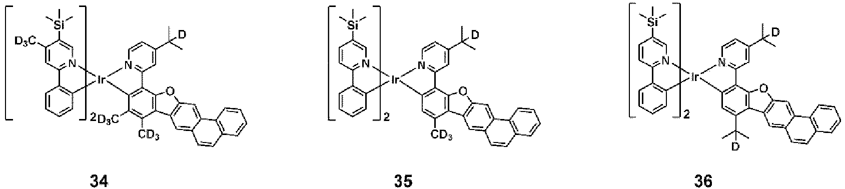

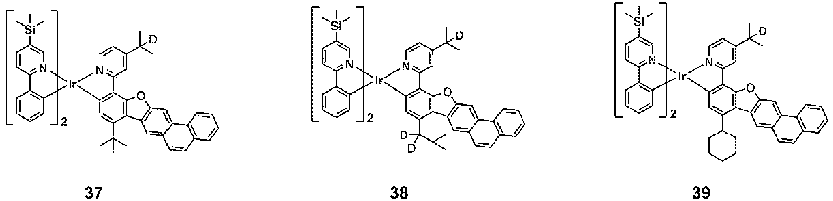

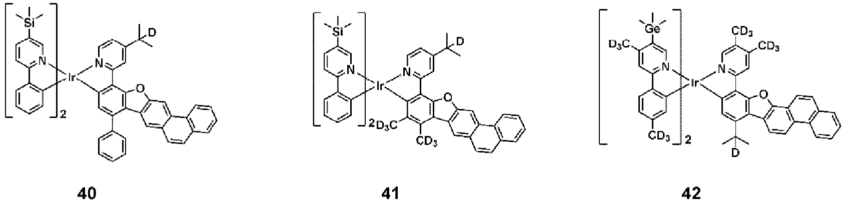

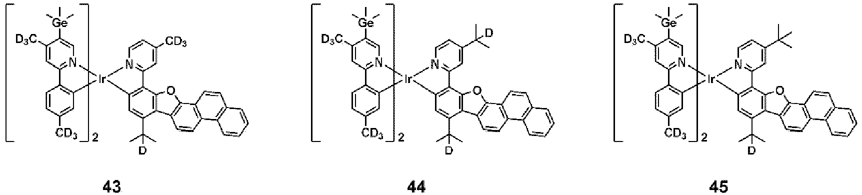

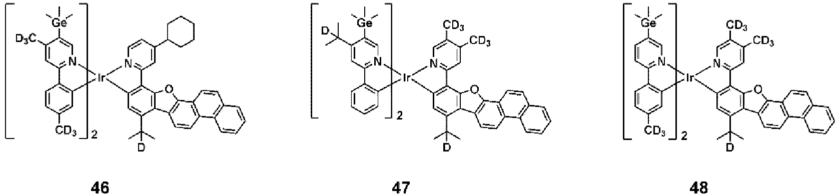

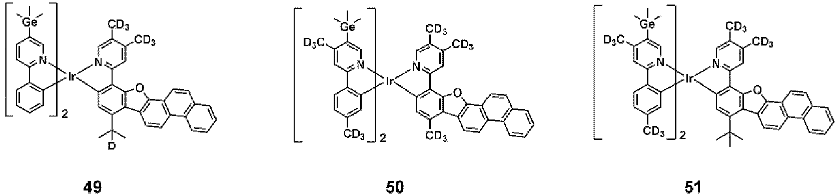

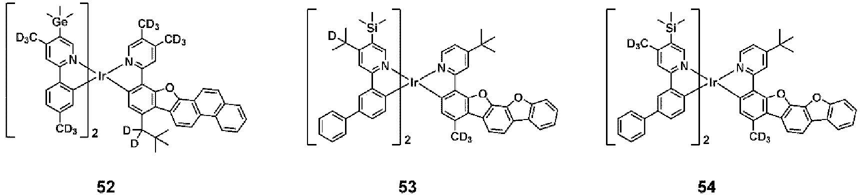

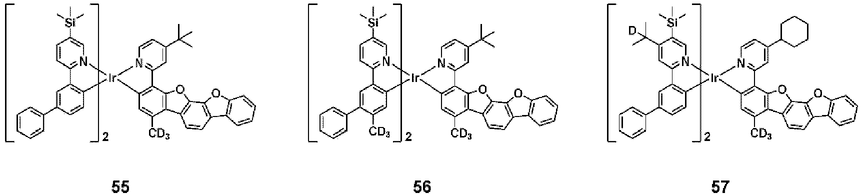

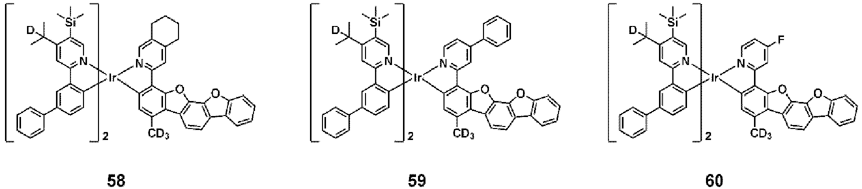

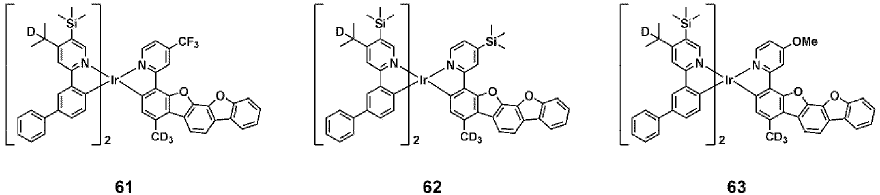

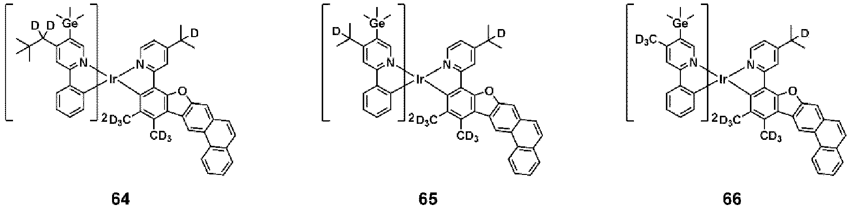

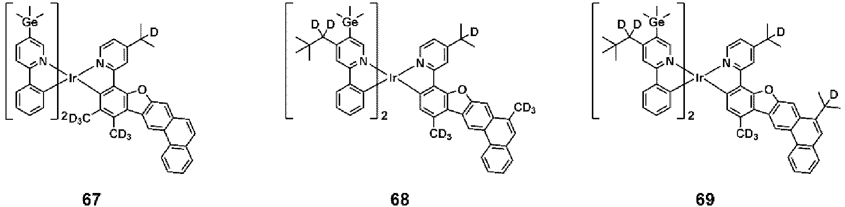

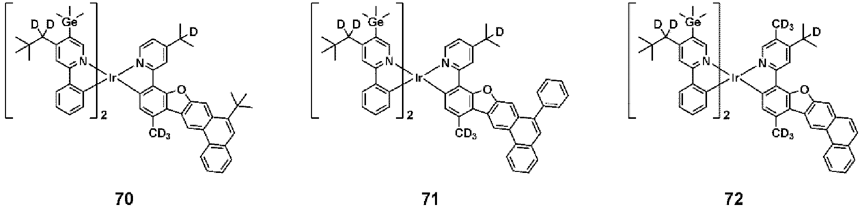

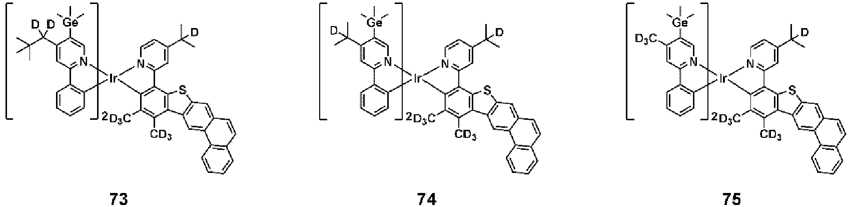

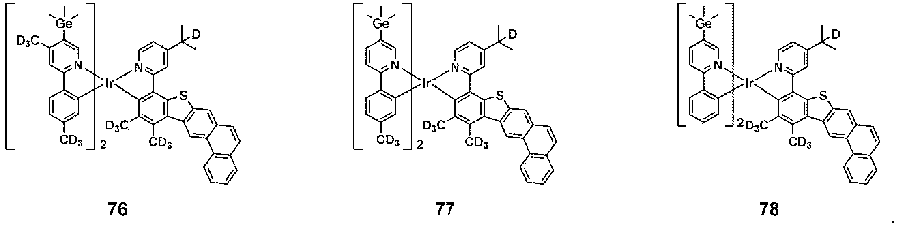

11. An organic light-emitting device, comprising:
a first electrode;
a second electrode; and
an organic layer arranged between the first electrode and the second electrode,
wherein the organic layer comprises an emission layer, and
wherein the organic layer further comprises at least one of the organometallic compound of any of claims 1-10.

12. The organic light-emitting device of claim 11, wherein the emission layer comprises the at least one organometallic compound.

13. The organic light-emitting device of claim 12, wherein the emission layer further comprises a host, and an amount of the host in the emission layer is greater than an amount of the at least one organometallic compound in the emission layer, based on weight; and/or
wherein the emission layer emits a green light having a maximum emission wavelength of 490 nanometers to 600 nanometers.

14. The organic light-emitting device of claims 12 or 13, wherein
the first electrode is an anode,
the second electrode is a cathode,
the organic layer further comprises a hole transport region arranged between the first electrode and the emission layer, and an electron transport region arranged between the emission layer and the second electrode,
the hole transport region comprises a hole injection layer, a hole transport layer, an electron blocking layer, a buffer layer, or a combination thereof, and
the electron transport region comprises a hole blocking layer, an electron transport layer, an electron injection layer, or a combination thereof.

15. An electronic apparatus, comprising the organic light-emitting device of any of claims 11-14.
